# EUROPEAN PATENT SPECIFICATION

(11) **EP 2 169 463 B1**
(45) Date of publication and mention of the grant of the patent: **28.03.2012**
(21) Application number: 09011863.9
(22) Date of filing: 17.09.2009
(51) Int. Cl.: G03F 7/00, G03F 7/032, G03F 7/033, G03F 7/105

(54) **Colored curable composition, color filter and method for producing the same**
Gefärbte härtbare Zusammensetzung, Farbfilter und Verfahren zu deren Herstellung
Composition durcissable colorée, filtre de couleur, et son procédé de production

(30) Priority: 29.09.2008 JP 2008251321
(43) Date of publication of application: 31.03.2010
(73) Proprietor: FUJIFILM Corporation, Minato-ku Tokyo (JP)
(72) Inventor: Kaneko, Yushi, Haibara-gun Shizuoka-ken (JP); Makino, Masaomi, Haibara-gun Shizuoka-ken (JP)
(74) Representative: HOFFMANN EITLE

(56) References cited:
- EP-A1- 2 048 539
- WO-A1-2008/035671
- JP-A- 2004 287 298
- JP-A- 2008 020 566

## Description

### BACKGROUND OF THE INVENTION

### Field of the Invention

The present invention relates to a colored curable composition that is suitable for forming color filters for liquid crystal displays (LCDs), solid-state image sensors (CCD, CMOS, etc.) or the like, a color filter having a colored region obtainable by using the colored curable composition, and a method for producing the color filter.

### Description of the Related Art

A color filter is an essential component in a liquid crystal display or solid-state image sensor. In recent years, liquid crystal displays in TV and monitors have been required to have a higher image quality than before, and to have improved contrast and color purity. A colored curable composition for producing color filters has attempted to improve contrast by using pigment particles having a smaller particle size (for example, Japanese Patent Application Laid-Open (JP-A) No. 2006-30541).
In color filters for solid-state image sensors, a reduction in color unevenness has been required in order to increase resolution. Therefore, it is important to disperse pigments having a small particle size, while suppressing the generation of secondary aggregates.

In recent years, increases in color purity have been demanded for color filters for liquid crystal displays. To achieve this end, the content of pigments must be increased. Color filters for solid-state image sensors have also been required to reduce stray light due to scattering as a means of increasing resolution, and thus there is a strong desire to obtain a thin colored layer. For this reason as well, the content of pigments in a color filter must be increased. In order to increase the content of pigments, the pigment concentration in a colored curable composition needs to be increased. However, when pigment concentration is increased, the relative content of dispersion resins and curable components (monomers, polymerization initiators, etc.) in a colored curable composition is inevitably reduced, thereby reducing storage stability and developability of a colored curable composition, and pattern formability also becomes poor. In particular, when color filters for solid-state image sensor become very small in order to increase pixel numbers and reduce overall size, the developability of a colored curable composition (the inhibition of generation of residues at unexposed areas) is deteriorated. To address these issues, a comb resin containing a trunk polymer having a cationic group, or a graft polymer containing polyallylamine has been used (see, for example, JP-A Nos. 9-176511 and 2001-272524). However, these issues have not been overcome even when the comb resin or the graft polymer is used.

JP 2004-287298 describes a pigment dispersion liquid comprising a pigment, a pigment dispersant comprising a copolymer containing a molecular structure in which at least a structural unit having a specified quaternary ammonium salt group in the side chain is linked with a structural unit having a specified ester structure, and further containing an acidic functional group and a polyester chain. The dispersion liquid additionally comprises an imide group-containing copolymer having specified groups and an organic solvent.

EP 2 048 539 describes a pigment-dispersion composition wherein a pigment is colored with at least one of a specified polymer compound selected from a polymer compound having a heterocycle on a side chain, a graft polymer compound having a weight average molecular weight from 1,000 to 100,000 and a specified copolymer compound being defined by means of a specified formula.

WO 2008/035671 relates to a photosensitive coloring composition comprising a carrier for a coloring agent, which comprises a transparent resin and a precursor thereof, a coloring agent and a photopolymerization initiator represented by a specified formula.

### SUMMARY OF THE INVENTION

The present invention provides a colored curable composition that has, even when the concentration of a pigment is high, excellent fine-dispersibility and dispersion stability, high sensitivity, and excellent developability.
The invention also provides a color filter obtainable by using the colored curable composition, and which has excellent adhesion property to substrates, a favorable pattern shape, and favorable color properties such as improved contrast and reduced color unevenness, and a method for producing the color filter.

As a result of the extensive researches in view of the above issues, the present inventors have found that, by using a colored curable composition containing (A) a dispersion resin as defined below (B) a pigment, (C) a photopolymerization initiator, which is an oxime compound (D) a polymerizable compound, (E) a solvent, and (F) an alkali-soluble resin containing a repeating unit represented by the following Formula (2) or (3) below, storage stability and developability can be improved even when the concentration of the pigment is high. In addition, by using the colored curable composition of the invention, a color filter having excellent adhesion property to a surface of a substrate, a favorable pattern shape, and favorable color properties such as improved contrast and reduced color unevenness, can be obtained.

Aspects of the invention include the following.

<1> A colored curable composition, containing: (A) a dispersion resin as defined below (B) a pigment, (C) a photopolymerization initiator, (D) a polymerizable compound, (E) a solvent, and (F) an alkali-soluble resin containing a repeating unit represented by the following Formula (2) or (3) :

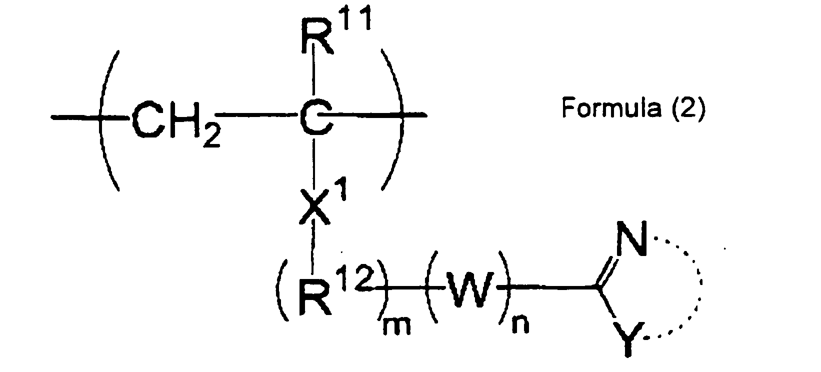

In Formula (2), R¹¹ represents a hydrogen atom or an alkyl group. R¹² represents an alkylene group. X¹ represents -CO-, -COO-, -OCO-, -CONH-, or a phenylene group. W represents -O-, -S-, -COO-, -CONH-, -COS-, -NHCONH-, -NHCOO-, -NHCOS-, -OCO-, -OCONH-, or-NHCO-. Y represents -NR¹³-, -O-, -S-, or -N=, and is linked to the N atom via an atomic group adjacent to Y to form a cyclic structure. R¹³ represents a hydrogen atom, an alkyl group, or an aryl group. *m* and *n* each independently represent 0 or 1.

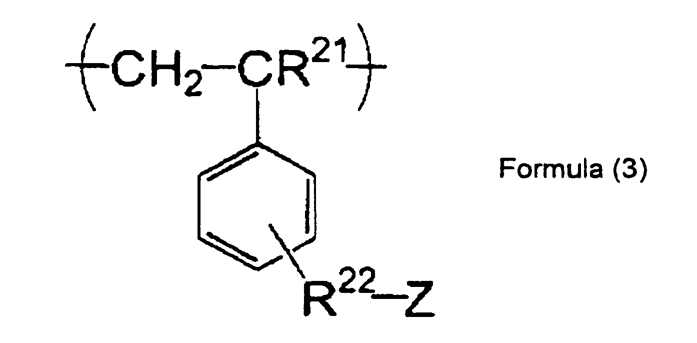

In Formula (3), R²¹ represents a hydrogen atom or a methyl group, R²² represents an alkylene group, and Z represents a nitrogen-containing heterocyclic group.

<2> The colored curable composition according to to <1>, in which (F) the alkali-soluble resin further contains a repeating unit having an ethylenic unsaturated double bond at a side chain thereof.
<3> The colored curable composition according to any one of <1> or <2>, in which the content of (F) the alkali-soluble resin is from 10% by mass to 100% by mass with respect to the mass of (B) the pigment.
<4> The colored curable composition according to any one of <1> to <3>, in which the weight average molecular weight of (A) the dispersion resin is from 3,000 to 100,000.
<5> The colored curable composition according to any one of <1> to <4>, in which the amine value of (A) the dispersion resin is from 10 mgKOH/g to 150 mgKOH/g.
<6> The colored curable composition according to any one of <1> to <5>, in which the content of (A) the dispersion resin is from 20% by mass to 50% by mass with respect to the content of (B) the pigment.

<7> The colored curable composition according to <1>, wherein W in formula (2) is -O-, -S-, -CONH-, -NHCONH- or -NHCOS-.
<8> A color filter, which has a colored pattern on a support obtainable by using the colored curable composition according to any one of <1> to <6>.

<9> A method for producing a color filter, including forming a colored layer by applying the colored curable composition according to any one of <1> to <6> to a support, pattern-wise exposing the colored layer through a mask, and developing the exposed colored layer to form a colored pattern.

According to the invention, a colored curable composition that has favorable fine-dispersibility and dispersion stability, high sensitivity, and favorable developability even under high pigment concentration conditions is provided.

The invention also provides a color filter that has excellent adhesion property to substrates, has a favorable pattern shape, and has favorable color characteristics, such as favorable contrast or reduced color unevenness, by using the colored curable composition and a method for producing the same.

### DETAILED DESCRIPTION OF THE INVENTION

The colored curable composition of the invention has excellent storage stability and developability even when the concentration of the pigment is high. The reason for this remains unknown, but is thought to be as follows. The storage stability increases due to strong adsorption of resin to the surface of a pigment. The colored curable composition of the invention contains (A) the dispersion resin and (F) the alkali-soluble resin containing the repeating unit represented by Formula (2) or (3). The colored curable composition of the invention can firmly adsorb to the pigment surface via two kinds of interactions: a hydrogen bond with the pigment surface by a specified amino group portion of (A) the dispersion resin and a π-π bond with the pigment surface by a heterocyclic portion of (F) the alkali-soluble resin. As a result, the colored curable composition of the invention exhibits excellent storage stability. In addition, relatively high developability can be achieved since the colored curable composition of the invention contains the amino group of (A) the dispersion resin and the heterocyclic group of (F) the alkali-soluble resin, both of which are hydrophilic.

Hereinafter, the present invention is described in detail. A "colored region" as used herein includes both a colored pixel (colored pattern) region and a light-shielding film region in a color filter. When a group (an atom group) is described herein without an indication of "substituted" or "unsubstituted", the description is intended to include both a group not having an additional substituent and a group having one or more additional substituents. For example, the scope of an expression, "alkyl group", includes not only an alkyl group not having a substituent (i.e., an unsubstituted alkyl group), but also an alkyl group having a substituent (i.e., a substituted alkyl group).

*(A) Dispersion resin* A colored curable composition of the invention contains (A) a dispersion resin being a condensate of polyethylene imine and a polyester or a condensate of polyalkylamine and a polyester. When the colored curable composition contains (A) this dispersion resin (hereinafter, also referred to as "(A) the dispersion resin"), dispersion stability of a pigment can be maintained.

The main chain of (A) the dispersion resin is formed from a known polymer or oligomer having an amino group. The main chain include polyethyleneimine and polyallylamine. Among the above, polyethyleneimine is preferable.

(A) The dispersion resin preferably has a graft chain. When (A) the dispersion resin has a graft chain, dispersion stability of a pigment can be improved. The graft chain includes polyester from the viewpoint of developability and storage stability. The number average molecular weight of the graft chain is preferably from 2,000 to 40,000 and more preferably from 3,000 to 20,000.

The weight average molecular weight (as a polystyrene-equivalent value measured according to a GPC (gel permeation chromatography) method) of (A) the dispersion resin is preferably from 3,000 to 100,000, more preferably from 5,000 to 50,000, and still more preferably from 6,000 to 20,000. When the weight average molecular weight is lower than the above range, the dispersion stability of the pigment may be deteriorated. When the weight average molecular weight exceeds the above range, the developability of the colored curable composition may be deteriorated. The amine value of (A) the dispersion resin is preferably from 10 mgKOH/g to 150 mgKOH/g, and more preferably from 30 mgKOH/g to 100 mgKOH/g. When the amine value is within the above range, excellent dispersion stability of the pigment may be obtained.

The number average molecular weight of the amino group-containing resin is not limited, and is preferably from 200 to 1,800, more preferably from 300 to 1,200, and still more preferably from 500 to 1,000. The weight average molecular weight (as a polystyrene-equivalent value measured according to a GPC method) of the polyester is preferably from 1,000 to 50,000, more preferably from 2,000 to 40,000, and still more preferably from 3,000 to 20,000.

(A) The dispersion resin preferably further contains an alkali-soluble group. When (A) the dispersion resin contains the alkali-soluble group, the developability of the colored curable composition at a high pigment concentration can further be improved.

The alkali-soluble group is preferably a carboxylic acid group, a sulfonic acid group, a phosphate group, or -COCH₂COCH₃, and more preferably a carboxylic acid group.

The acid value of the alkali-soluble group of (A) the dispersion resin is preferably from 5 mgKOH/g to 100 mgKOH/g, and more preferably from 5 mgKOH/g to 50 mgKOH/g. As a method for introducing the alkali-soluble group, a method including reacting (A) the dispersion resin with a precursor of the alkali-soluble group (for example, cyclic acid anhydride, diketene) is preferable.

The content of (A) the dispersion resin having an amino group in the main chain thereof is preferably from 10% by mass to 100% by mass, and more preferably from 20% by mass to 50% by mass, with respect to the content of a pigment.

### (B) Pigment

The colored curable composition of the invention contains (B) a pigment. As (B) the pigment, various known inorganic pigments or organic pigments can be used.

Considering that a high transmittance pigment is preferable, the size of the inorganic pigments or organic pigments is preferably as small as possible. In consideration of handling properties, the average primary particle diameter of (B) the pigment is preferably from 5 nm to 100 nm, more preferably from 5 nm to 70 nm, still more preferably from 5 nm to 50 nm, and even more preferably from 5 nm to 40 nm.

Examples of inorganic pigments that can be used in the colored curable composition of the invention include metal compounds such as metal oxides or metal complex salts. Specific examples thereof include metal oxides such as iron oxides, cobalt oxides, aluminum oxides, cadmium oxides, lead oxides, copper oxides, titanium oxides, magnesium oxides, chromium oxides, zinc oxides, or antimony oxides, and composite oxides of these metals.

Examples of organic pigments that can be used in the colored curable composition of the invention include:
C. I. Pigment Yellow 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75, 81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, and 208;

C. I. Pigment Orange 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, and 79;
C. I. Pigment Red 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52: 1, 52: 2, 53, 53:1, 53:2, 53:3, 57, 57:1, 57: 2, 58:4, 60, 63, 63:1, 63:2, 64, 64:1, 68, 69, 81, 81:1, 81:2 81:3 81:4, 83, 88, 90:1, 101, 101:1, 104, 108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, and 276;

C. I. Pigment Violet 1, 1:1, 2, 2:2, 3, 3:1, 3:3, 5, 5:1, 14, 15, 16, 19, 23, 25, 27, 29, 31, 32, 37, 39, 42, 44, 47, 49, and 50;
C. I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, 79, and C. I. Pigment Blue 79 in which the Cl substituent group has been substituted by OH;
C. I. Pigment Green 1, 2, 4, 7, 8, 10, 13, 14, 15, 17, 18, 19, 26, 36, 45, 48, 50, 51, 54, and 55;
C. I. Pigment Brown 23, 25, and 26;
C. I. Pigment Black 1 and 7; and
carbon black, acetylene black, lamp black, bone black, graphite, iron black, aniline black, cyanine black, and titanium black.

In particular, pigments having a basic N atom in the structure thereof may preferably be used in the invention. These pigments having a basic N atom exhibit good dispersibility in the colored curable composition of the invention. While the reason for this has not been sufficiently clarified, it is thought that good affinity of a pigment with a polymerizable component may influence dispersibility.

Examples of pigments that can preferably be used in the invention include the following. However, the invention is not limited to these examples.

C. I. Pigment Yellow 11, 24, 108, 109, 110, 138, 139, 150, 151, 154, 167, 180 and 185;
C. I. Pigment Orange 36 and 71;
C. I. Pigment Red 122, 150, 171, 175, 177, 209, 224, 242, 254, 255 and 264;
C. I. Pigment Violet 19, 23 and 32;
C. I. Pigment Blue 15:1, 15:3, 15:6, 16, 22, 60 and 66;
C. I. Pigment Green 7, 36, 37 and 55; and
C. I. Pigment Black 1.

These organic pigments may be used singly, or may be used in combination of two or more kinds thereof in order to improve the color purity. Examples of preferable organic pigments and specific examples of the combination of the pigments include the following.
For example, as a red pigment, an anthraquinone pigment, a perylene pigment or a diketopyrrolopyrrole pigment may be used singly; or a mixture of at least one of these red pigments with at least one of a disazo yellow pigment, an isoindoline yellow pigment, a quinophthalone yellow pigment or a perylene red pigment, may be used. Examples of the anthraquinone pigment include C. I. pigment Red 177. Examples of the perylene pigment include C. I. Pigment Red 155 and C. I. Pigment Red 224. Examples of the diketopyrrolopyrrole pigment include C. I. Pigment Red 254. In consideration of color reproducibility, mixtures of the red pigments with C. I. Pigment Yellow 139 are preferable.
The mass ratio of the yellow pigment to the red pigment (yellow pigment/ red pigment) is preferably from 5/100 to 50/100, and more preferably from 10/100 to 30/100. When a combination of red pigments is used, the mass ratio thereof can be adjusted according to the desired chromaticity.

As a green pigment, a halogenated phthalocyanine pigment may be used singly; or a mixture of this green pigment with at least one of a disazo yellow pigment, a quinophthalone yellow pigment, an azomethine yellow pigment or an isoindoline yellow pigment, may be used. Preferable examples of the mixture include mixtures of at least one of C. I. Pigment Green 7, C. I. Pigment Green 36 or C. I. Pigment Green 37 with at least one of C. I. Pigment Yellow 83, C. I. Pigment Yellow 138, C. I. Pigment Yellow 139, C. I. Pigment Yellow 150, C. I. Pigment Yellow 180 or C. I. Pigment Yellow 185.
The mass ratio of the yellow pigment to the green pigment (yellow pigment/ green pigment) is preferably from 5/100 to 150/100, and more preferably form 30/100 to 120/100.

As a blue pigment, a phthalocyanine pigment may be used singly; or a mixture of the phthalocyanine pigment with a dioxazine purple pigment may be used. For example, a mixture of C. I. Pigment Blue 15:6 with C. I. Pigment Violet 23 is preferable.
The mass ratio of the purple pigment to the blue pigment (purple pigment/blue pigment) is preferably from 0/100 to 100/100, and more preferably 10/100 or less.

As a pigment used for a black matrix include carbon, titanium black, iron oxide and titanium oxide. These pigments are used singly, or in combination of two or more thereof. Among the above, a combination of carbon and titanium black is preferable.
The mass ratio of titanium black to carbon (titanium black/ carbon) is preferably from 0/100 to 60/100.

In the invention, the pigment to be used is preferably subjected to a pulverization treatment beforehand.

As a method for pulverizing the primary particles of the pigment, a method (a salt milling method) is well known, in which i) an organic pigment, ii) a water-soluble inorganic salt, and iii) a water-soluble organic solvent that does not substantially dissolve the water-soluble inorganic salt, are mechanically kneaded with a kneader or the like. In this method, (A) the dispersion resin having an amino group in the main chain thereof, and/or a high-molecular compound for pigment coating described below may be used in combination if necessary.

### i) Organic pigment

Examples of i) the organic pigment are the same as those of the organic pigment described above.

### ii) Water-soluble inorganic salt

ii) The water-soluble inorganic salt is not limited as long as it is soluble in water. Examples of ii) the water-soluble inorganic salt include sodium chloride, barium chloride, potassium chloride, and sodium sulfate. It is preferable to use sodium chloride or sodium sulfate in terms of cost.

The amount of ii) the water-soluble inorganic salt used for salt milling is preferably from 100% by mass to 3,000% by mass, and more preferably from 500% by mass to 2,500% by mass, based on the mass of the organic pigment, in consideration of both treatment efficiency and production efficiency. As the quantitative ratio of the inorganic salt to the organic pigment is increased, the amount of pigment that can be processed at a time is decreased while the pulverizing efficiency is improved.

### iii) Water-soluble organic solvent that does not substantially dissolve water-soluble inorganic salt

iii) The water-soluble organic solvent has a function of wetting i) the organic pigment and ii) the water-soluble inorganic salt. iii) The water-soluble organic solvent is not limited as long as it is soluble (miscible) in water, and does not substantially dissolve ii) the water-soluble inorganic salt. However, since the temperature increases during the salt milling and thus the solvent easily evaporates, a solvent having a boiling point of 120°C or more is preferable in consideration of safety.

Examples of the water-soluble organic solvent include 2-methoxyethanol, 2-butoxyethanol, 2-(isopentyloxy)ethanol, 2-(hexyloxy)ethanol, ethylene glycol, diethylene glycol, diethylene glycol monoethyl ether, diethylene glycol monoethyl ether acetate, diethylene glycol monobutyl ether, triethylene glycol, triethylene glycol monomethyl ether, liquid polyethyleneglycol, 1-methoxy-2-propanol, 1-ethoxy-2-propanol, dipropyleneglycol, dipropyleneglycol monomethyl ether, dipropyleneglycol monoethyl ether, and liquid polypropyleneglycol.

These water-soluble organic solvents may be used singly or in combination of two or more kinds thereof.

In order to obtain uniformly-sized particles, homogeneous kneading, and to apply a favorable shear force to a composition to be kneaded to obtain a sufficient pulverizing effect, the addition amount of the water-soluble organic solvent is preferably from 5% by mass to 50% by mass with respect to the total mass of the ii) the water-soluble inorganic salt. The addition amount of the water-soluble organic solvent is more preferably from 10% by mass to 40% by mass, and still more preferably from 15% by mass to 35% by mass, with respect to the total mass of the ii) the water-soluble inorganic salt.
The water-soluble organic solvent may be added at one time at an early stage of the salt milling process, or may be added in batches.

### High-molecular compound for pigment-coating

The high-molecular compound for pigment-coating that may be added at the time of salt milling is preferably a solid at room temperature, water insoluble, and at least partially soluble in the water-soluble organic solvent used for wetting during the salt milling. As the high-molecular compound, a natural resin, a modified natural resin, a synthetic resin, or a synthetic resin modified with a natural resin can be used.

In order to obtain a dry pulverized pigment after salt milling, the high-molecular compound for pigment-coating is preferably a solid at room temperature.

Examples of the natural resin include rosin; and examples of the modified natural resin include rosin derivatives, cellulose derivatives, rubber derivatives, and protein derivatives and oligomers thereof.

Examples of the synthetic resin include an epoxy resin, an acrylic resin, a maleic acid resin, a butyral resin, a polyester resin, a melamine resin, a phenolic resin, and a polyurethane resin.

Examples of the synthetic resin modified with a natural resin include a rosin-modified maleic acid resin and a rosin-modified phenolic resin.

Examples of the synthetic resin include (A) the dispersion resin having an amino group in the main chain thereof, polyamidoamine and salts thereof, polycarboxylic acid and salts thereof, high-molecular-weight unsaturated acid ester, polyurethane, polyester, poly(meth)acrylate, a (meth)acrylic copolymer, and a naphthalenesulfonic acid formalin condensate.

The high-molecular compound may be added at one time at an early stage of the salt milling process, or may be added in batches.

When the colored curable composition of the invention is used to form a colored region of a color filter, the primary particle diameter of the pigment is preferably from 5 nm to 100 mm, more preferably from 5 nm to 70 nm, still more preferably from 5 nm to 50 nm, and even more preferably from 5 nm to 40 nm, in consideration of color unevenness or contrast of the color filter. (A) The dispersion resin of the invention exerts more conspicuous effects on a pigment having a primary particle diameter of from 5 nm to 40 nm.
The primary particle diameter of the pigment can be measured by a known method, for example, using an electron microscope.

The pigment is preferably at least one pigment selected from anthraquinone pigments, azomethine pigments, benzylidene pigments, cyanine pigment, diketopyrrolopyrrole pigments, and phthalocyanine pigments.

### Pigment dispersion composition

When the colored curable composition of the invention is prepared, the pigment is preferably dispersed beforehand to form a pigment dispersion composition. The pigment to be used is preferably the above-described pulverized pigment.

The pigment dispersion composition is prepared by dispersing (A) the dispersion resin having an amino group in the main chain thereof, (B) the pigment, and a solvent. If necessary, another dispersant and/or resin may be added. Furthermore, the pigment dispersion composition may further include other ingredients, such as a pigment derivative, as required.

### Preparation of pigment dispersion composition

The method for preparing the pigment dispersion composition of the invention is not particularly limited. For example, the pigment dispersion composition may be obtained by subjecting (A) the dispersion resin, (B) the pigment, and the solvent to a finely dispersing treatment with beads made of, for example, glass or zirconia and having a particle diameter of from 0.01 mm to 1 mm, using a vertical or horizontal sand grinder, a pin mill, a slit mill, a ultrasonic disperser or the like.

Before the dispersing with beads is performed, a kneading-dispersing may be performed while applying a strong shearing force using a two-roll mill, a three-roll mill, a ball mill, a Tron mill, a disper mill, a kneader, a cokneader, a homogenizer, a blender, or a uniaxial or biaxial extruder.

Details regarding the kneading and dispersing are described in, for example, "Paint Flow and Pigment Dispersion", by T. C. Patton (published by John Wiley and Sons Co. 1964).

### -Pigment concentration-

The content of the pigment in the pigment dispersion composition is preferably from 10% by mass to 60% by mass, and more preferably from 15% by mass to 50% by mass, with respect to the total solid content (mass) of the pigment dispersion composition. When the content of the pigment is within the above range, a sufficient color concentration and excellent color characteristics may be obtained.

### -Dispersant-

In addition to (A) the dispersion resin, the pigment dispersion composition may contain a dispersant such as those described below. When the pigment dispersion composition contains the dispersant in addition to the dispersion resin, the dispersibility of the pigment may be improved.

As the dispersant, for example, a known pigment dispersant or surfactant may be appropriately selected for use.

As the dispersant, various kinds of compounds can be used. Specific examples of the dispersant include cationic surfactants such as KP341 (olgano-siloxane polymer) (trade name, manufactured by Shin-Etsu Chemical Co., Ltd.), POLYFLOW Nos. 75, 90, and 95 ((meth)acrylic acid-based (co)polymer) (trade name, all manufactured by Kyoeisha Chemical Co., Ltd.) and W001 (trade name, available from Yusho Co., Ltd.); nonionic surfactants such as polyoxyethylene lauryl ether, polyoxyethylene stearyl ether, polyoxyethylene oleyl ether, polyoxyethylene octylphenyl ether, polyoxyethylene nonylphenyl ether, polyoxyethylene glycol dilaurate, polyoxyethylene glycol distearate and sorbitan fatty acid ester; anionic surfactants such as W004, W005 and W017 (trade name, all available from Yusho Co., Ltd.); high-molecular dispersants such as EFKA-46, EFKA-47, EFKA-47EA, EFKA Polymer 100, EFKA Polymer 400, EFKA Polymer 401 and EFKA Polymer 450 (trade name, all manufactured by Chiba Specialty Chemicals Inc.); various SOLSPERSE dispersants such as SOLSPERSE 3000, 5000, 9000, 12000, 13240, 13940, 17000, 24000, 26000 and 28000 (trade name, all available form Lubrizol Corporation); ADEKA PLURONIC L31, F38, L42, L44, L61, L64, F68, L72, P95, F77, P84, F87, P94, L101, P103, F108, L121 and P-123 (trade name, all manufactured by ADEKA CORPORATION); IONET S-20 (trade name, manufactured by Sanyo Chemical Industries, Ltd.); and DISPER BYK 101, 103, 106, 108, 109, 111, 112, 116, 130, 140, 142, 162, 163, 164, 166, 167, 170, 171, 174, 176, 180, 182, 2000,2001, 2050, and 2150 (trade name, all manufactured by BYK Chemie). Other examples include a oligomer or a polymer having a polar group at a molecular terminal thereof or at a side chain thereof such as an acrylic copolymer.

The total content of (A) the dispersion resin and above-described other dispersants in the pigment dispersion composition is preferably form 1% by mass to 100% by mass, and more preferably from 3% by mass to 70% by mass, with respect to the total mass of the pigment.

### Pigment derivative

The pigment dispersion liquid of the invention may further contain a pigment derivative.

The pigment derivative preferably has a structure in which a part of an organic pigment, an anthraquinone or an acridone is substituted by an acid group, a basic group, or a phthalimidomethyl group. Examples of the organic pigment for forming the pigment derivative include diketopyrrolopyrrole pigments; azo pigments such as azo compounds, disazo compounds and polyazo compounds; phthalocyanine pigments such as copper phthalocyanines, halogenated copper phthalocyanines and metal-free phthalocyanines; anthraquinone pigments such as aminoanthraquinone, diaminodianthraquinone, anthrapyrimidine, flavanthrone, anthanthrone, indanthrone, pyranethrone and violanthrone; quinacridone pigments, dioxazine pigments, perynone pigments, perylene pigments, thioindigo pigments, isoindoline pigments, isoindolinone pigments, quinophthalone pigments, threne pigments, and metal complex pigments.

The acid group that the pigment derivative may have is preferably a sulfonic acid group, a carboxylic acid group, or quaternary ammonium salt group thereof. The basic group that the pigment derivative may have is preferably an amino group, and more preferably a tertiary amino group.

The amount of the pigment derivative to be used is not specifically limited, and is preferably from 5% by mass to 50% by mass, and more preferably from 10% by mass to 30% by mass, with respect to the content of the pigment.

The pigment dispersion composition may further contain a high-molecular compound such as an alkali-soluble resin described below. The alkali-soluble resin has a polar group such as an acid group, and may be effective for dispersing the pigment and thus may be effective for improving the dispersion stability of a pigment dispersion liquid.

### -Solvent-

Examples of the solvent of the pigment dispersion composition include 1-methoxy-2-propyl acetate, 1-methoxy-2-propanol, ethyleneglycol monomethyl ether, diethyleneglycol monomethyl ether, ethyl acetate, butyl acetate, ethyl lactate, acetone, methyl ethyl ketone, methyl isobutyl ketone, cyclohexanone, n-propanol, 2-propanol, n-butanol, cyclohexanol, ethyleneglycol, diethyleneglycol, toluene and xylene.

The content of the solvent in the pigment dispersion composition is suitably determined according to, for example, the application of the pigment dispersion composition. When the pigment dispersion composition is used for the preparation of the colored curable composition of the invention, the content of the solvent may be adjusted such that the total solid content of the pigment dispersion composition, including the pigment and the dispersant, is from 5% by mass to 50% by mass with respect to the total mass of the pigment dispersion composition, in consideration of handling properties.

The content of the pigment in the pigment dispersion composition of the invention is preferably from 30% by mass or more, more preferably from 35% by mass to 80% by mass, and still more preferably from 40% by mass to 70% by mass, with respect to the total solid content of the pigment dispersion composition.
When (A) the dispersion resin having an amino group in the main chain thereof of the invention is used as the pigment dispersant, dispersing effects thereof are more conspicuous when the pigment content is as high as 40% by mass or more; in contrast, it is difficult to stably and uniformly disperse a pigment at such a high content by using a known dispersant.

### (C) Photopolymerization Initiator

The colored curable composition of the invention includes (C) a photopolymerization initiator which is an oxime compound.

The photopolymerization initiator of the invention is decomposed by light, thereby initiating and accelerating polymerization of a polymerizable component such as (D) the polymerizable compound described below. The photopolymerization initiator preferably has an absorption in the wavelength region of from 300 nm to 500 nm.

The photopolymerization initiator may be used singly, or in combination of two or more thereof.

Examples of the oxime compounds include compounds such as those described in J.C.S. Perkin II (1979) 1653-1660, J.C.S. Perkin II (1979) 156-162, Journal of Photopolymer Science and Technology (1995) 202-232, and JP-A No. 2000-66385; and compounds such as those described in JP-A No. 2000-80068 and Japanese Patent Application National Publication (Laid-Open) No. 2004-534797.

As the (C) photopolymerization initiator of the invention, the above initiators can be appropriately used. In consideration of exposure sensitivity, the oxime compounds are used.

When a colored curable composition is used for the formation of colored pixels in color filters for solid-state image sensors, the pigment concentration in the colored curable composition is high due to the requirements for color filters for solid-state image sensors. Therefore, the concentration of a photopolymerization initiator in the colored curable composition is decreased and thus exposure sensitivity is reduced. When a stepper exposure is conducted using an initiator that generates a halogen-containing compound during the exposure such as triazine compounds, corrosion of the device may be caused. In consideration of these issues, as a photopolymerization initiator that can satisfy both exposure sensitivity and various properties, oxime compounds are preferable, and oxime compounds having an absorption at a wavelength of 365 nm are more preferable.

In the invention, among the oxime compounds, a compound represented by the following Formula (a) is preferable in consideration of exposure sensitivity, stability over time, and coloring at the time of post-heating. In addition, IRGACURE OXE-01 and OXE-02 (trade name, all manufactured by Ciba Specialty Chemicals Inc) are also preferable.

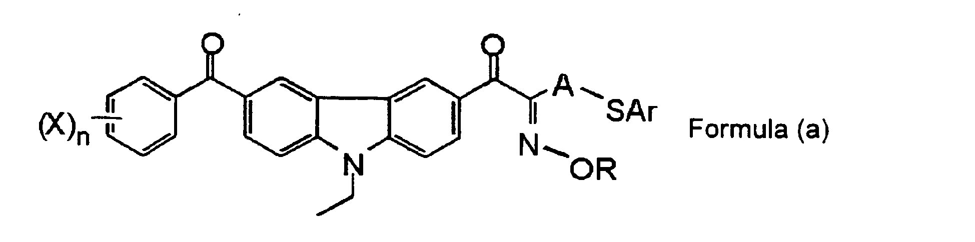

In Formula (a), R and X each independently represent a monovalent substituent, A represents a divalent organic group, Ar represents an aryl group, and n represents an integer of from 0 to 5.

In order to achieve high sensitivity, R preferably represents an acyl group, and, specifically, an acetyl group, a propionyl group, a benzoyl group, and a toluyl group are preferable.

In order to achieve high sensitivity and/or to suppress coloring caused by heating over time, A preferably represents an unsubstituted alkylene group, an alkylene group substituted by an alkyl group (such as a methyl group, an ethyl group, a tert-butyl group, or a dodecyl group), an alkylene group substituted by an alkenyl group (such as a vinyl group or an allyl group) or an alkylene group substituted by an aryl group (such as a phenyl group, a p-tolyl group, a xylyl group, a cumenyl group, a naphthyl group, an anthryl group, a phenanthryl group, or a styryl group).

In order to achieve high sensitivity and/or to suppress coloring caused by heating over time, Ar preferably represents a substituted or unsubstituted phenyl group. Preferable examples of the substituent in the substituted phenyl group include a halogen group such as a fluorine atom, a chlorine atom, a bromine atom, or an iodine atom.

In order to improve solubility in solvents and to improve absorption efficiency in a long wavelength region, X preferably represents a substituted or unsubstituted alkyl group, a substituted or unsubstituted aryl group, a substituted or unsubstituted alkenyl group, a substituted or unsubstituted alkynyl group, a substituted or unsubstituted alkoxy group, a substituted or unsubstituted aryloxy group, a substituted or unsubstituted alkylthioxy group, a substituted or unsubstituted arylthioxy group, and a substituted or unsubstituted amino group.

In Formula (a), n preferably represents 1 or 2.

Specific examples of oxime compounds suitable for the colored curable composition of the invention are shown below, but the invention is not limited to these examples.

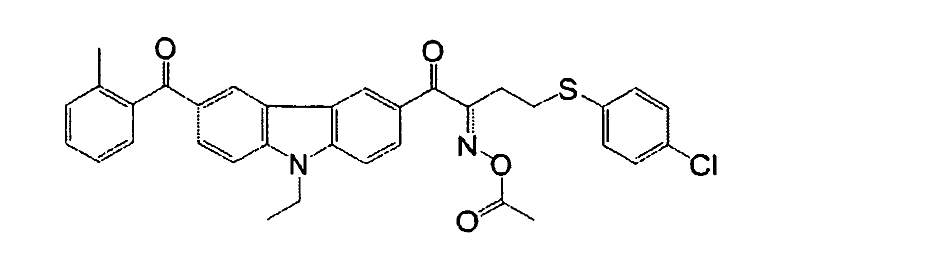

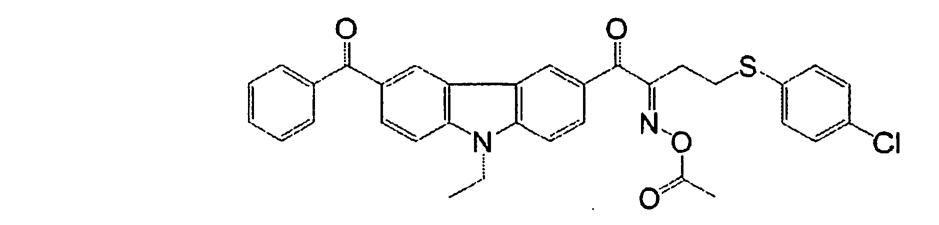

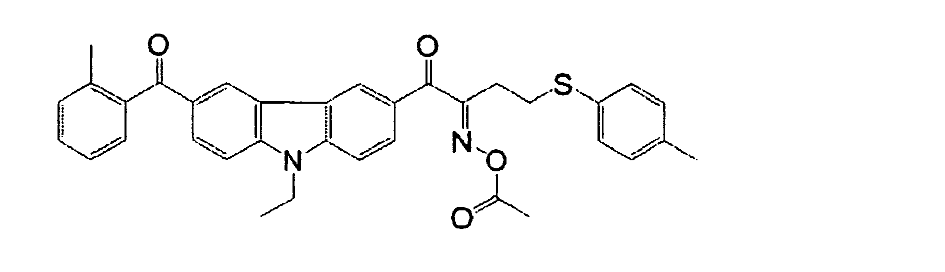

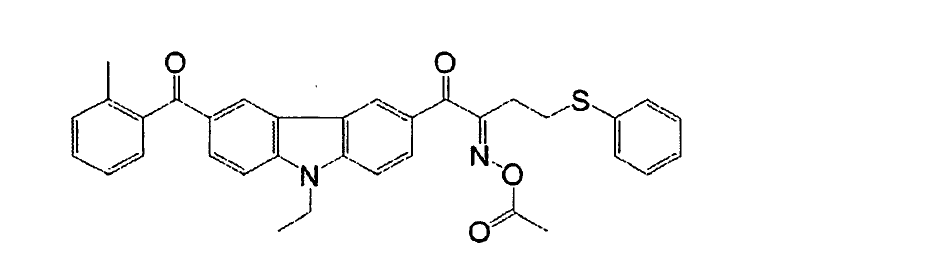

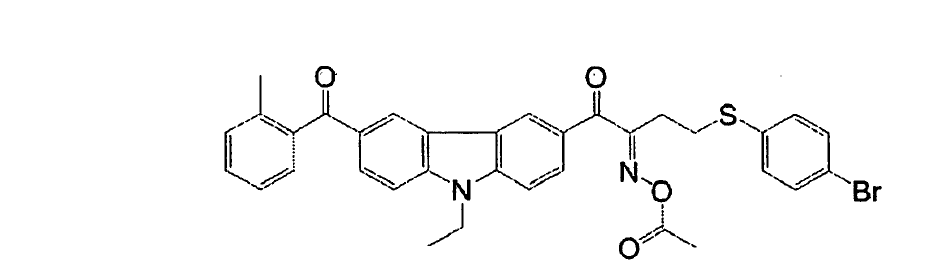

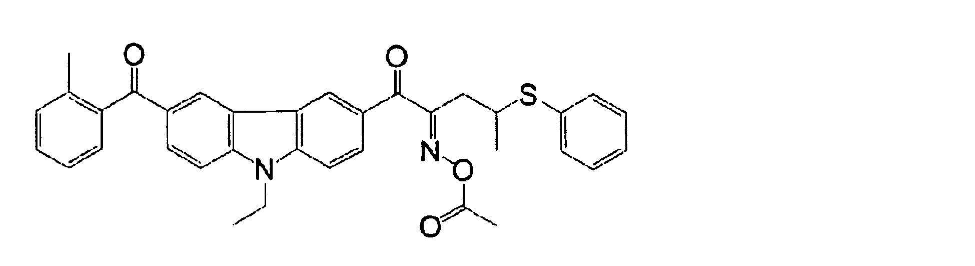

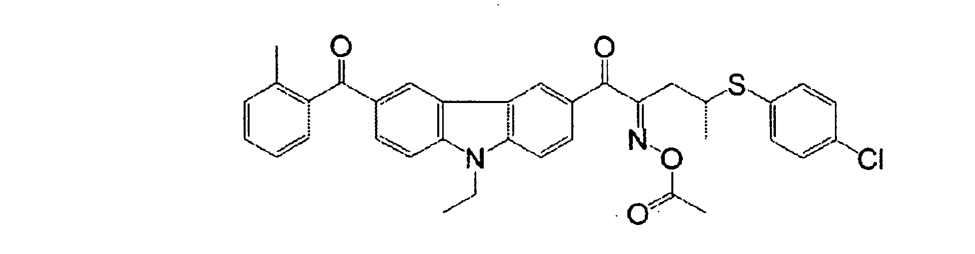

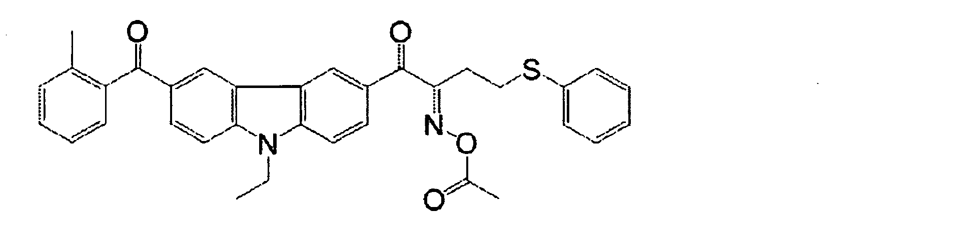

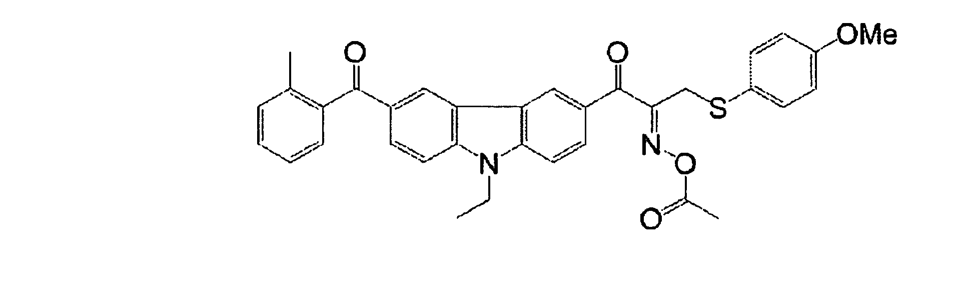

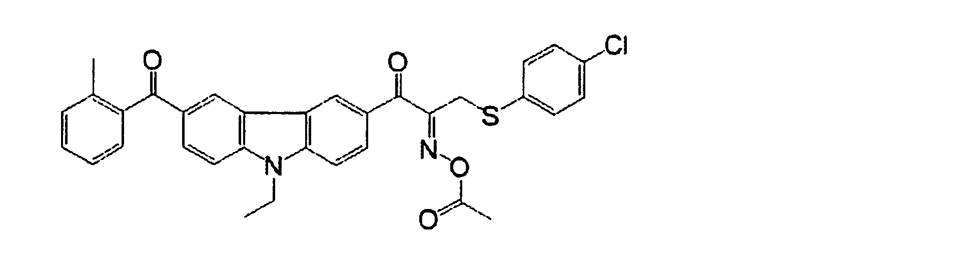

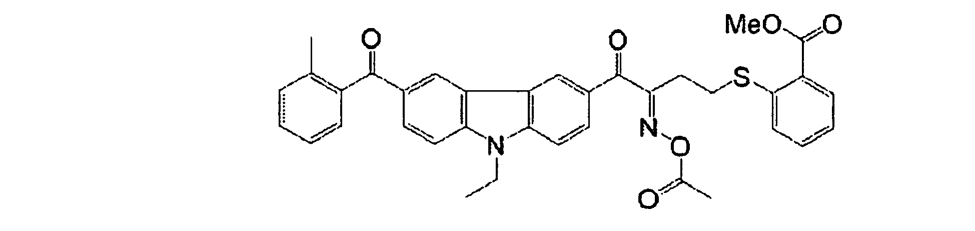

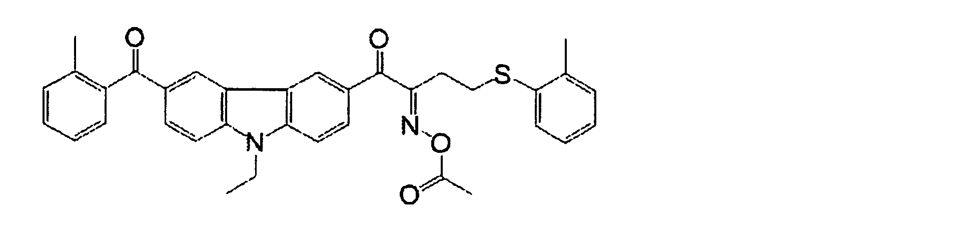

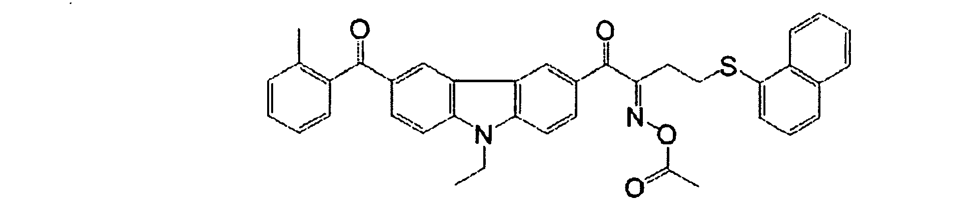

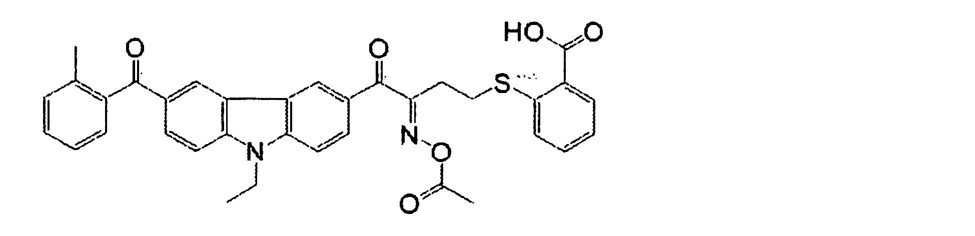

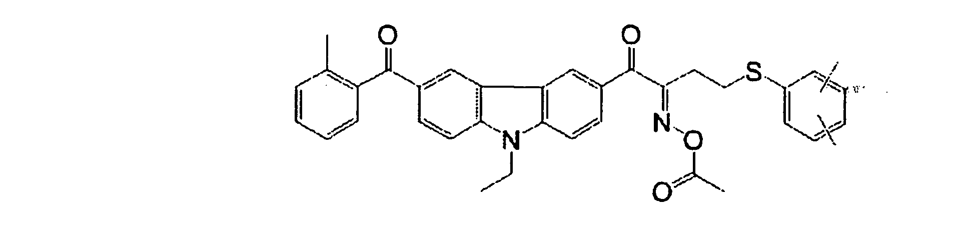

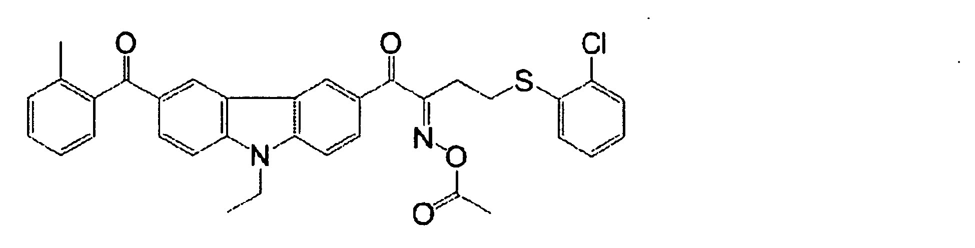

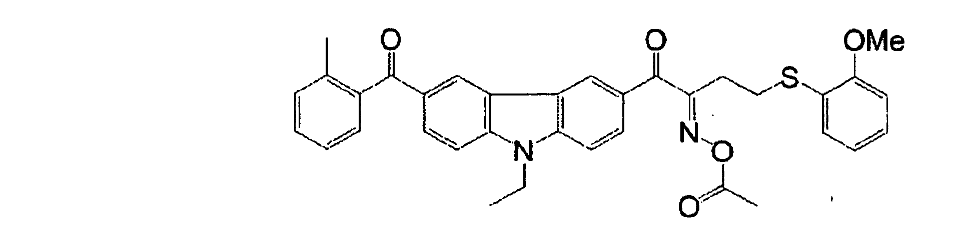

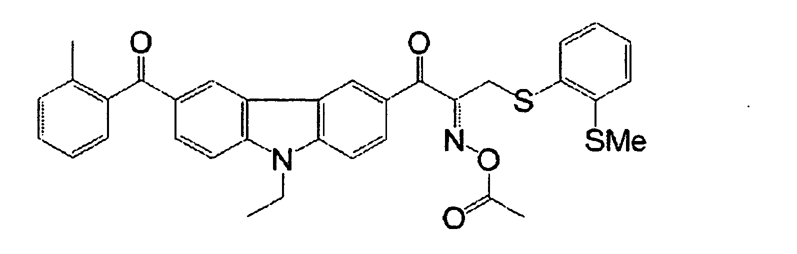

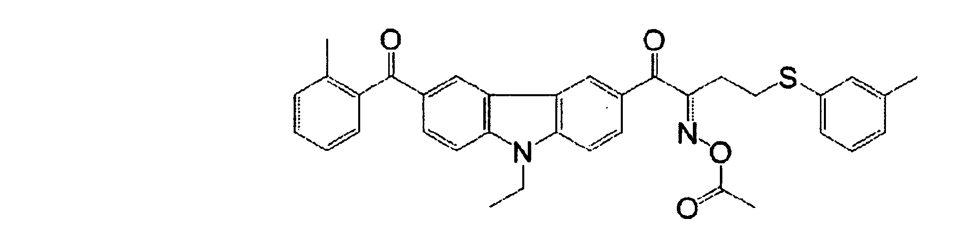

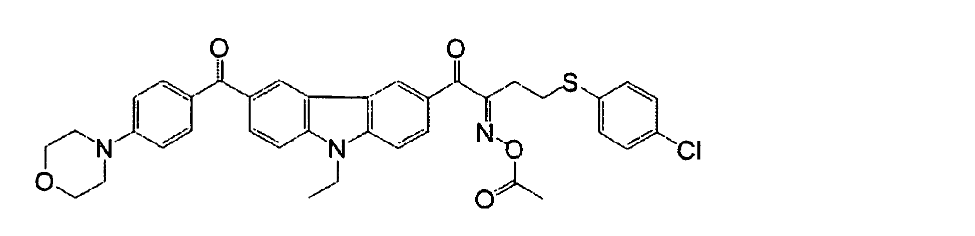

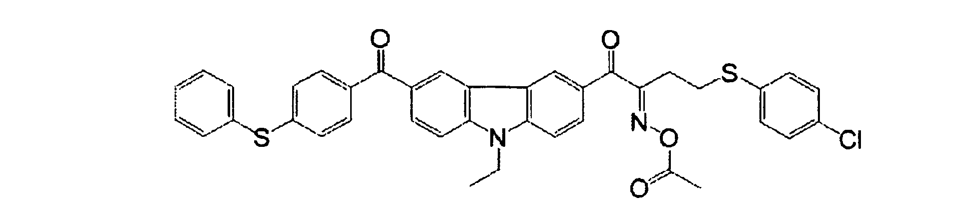

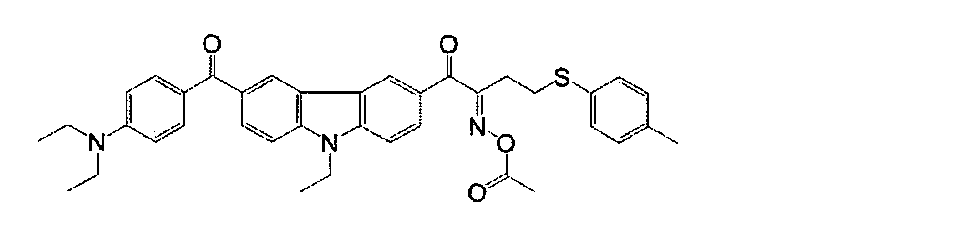

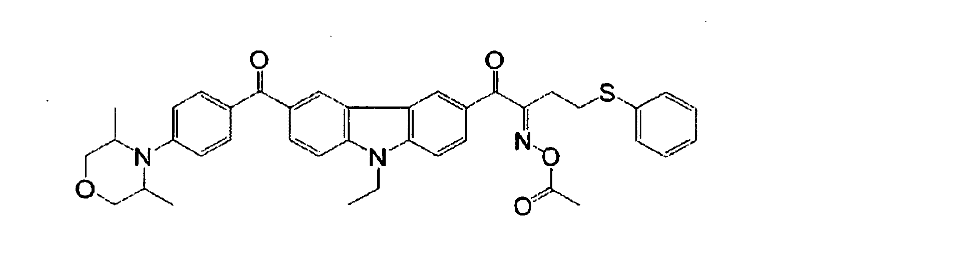

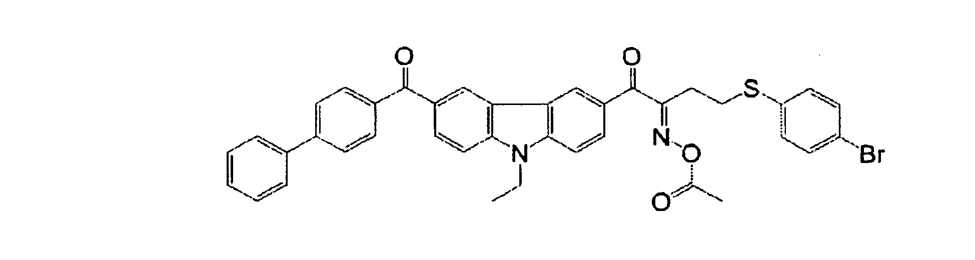

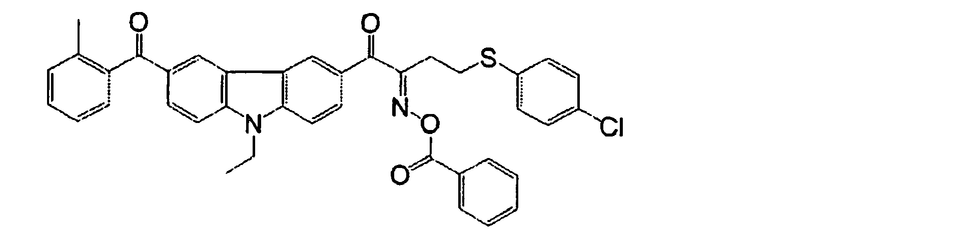

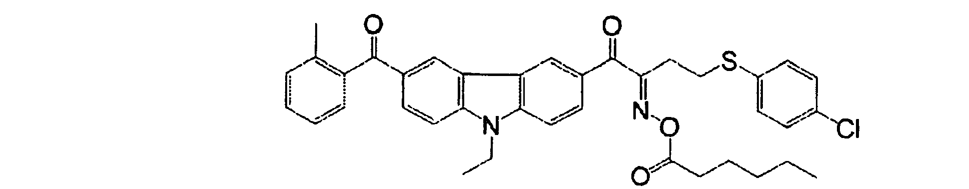

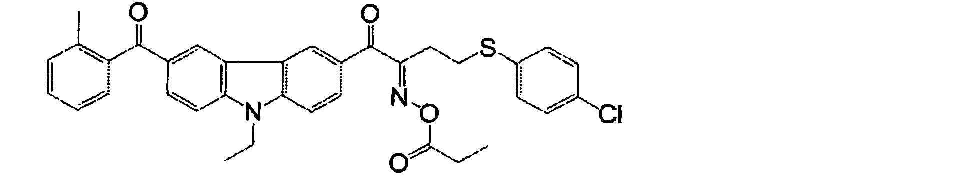

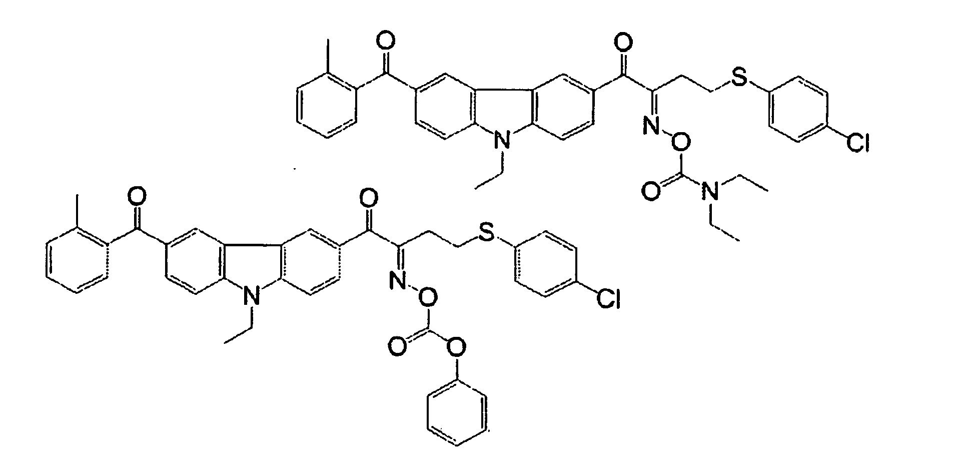

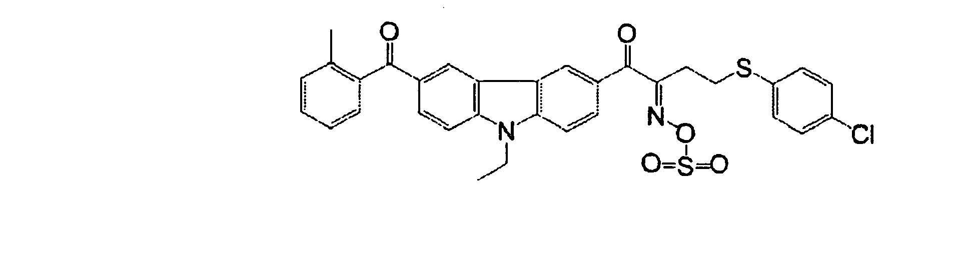

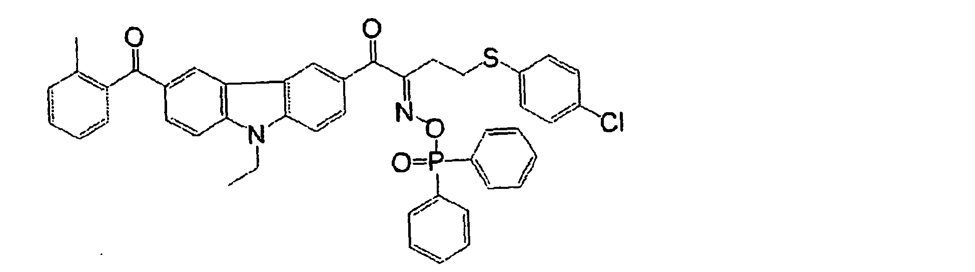

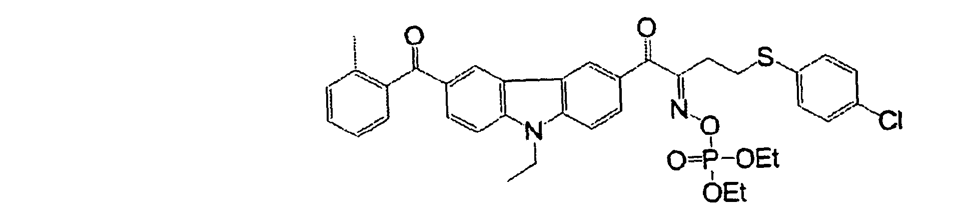

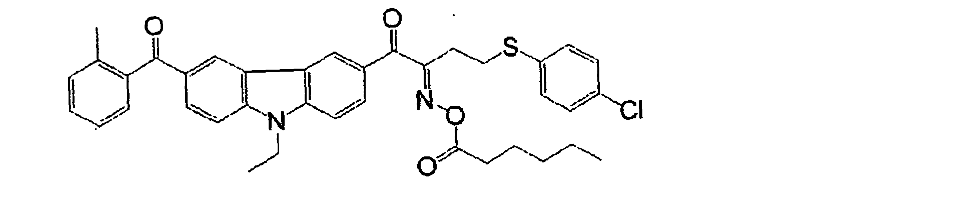

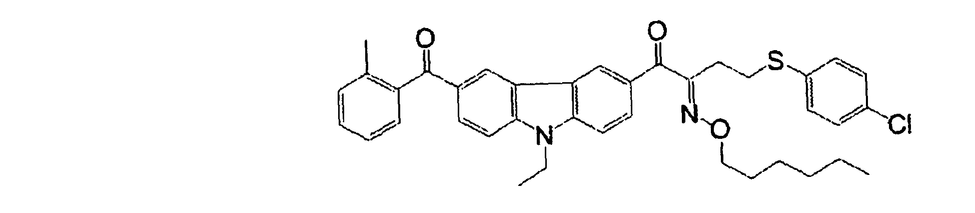

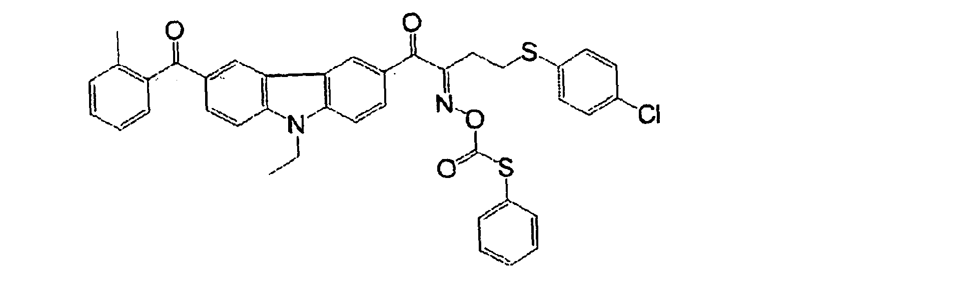

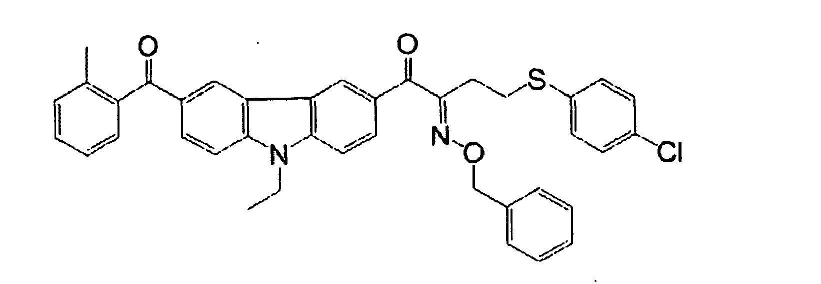

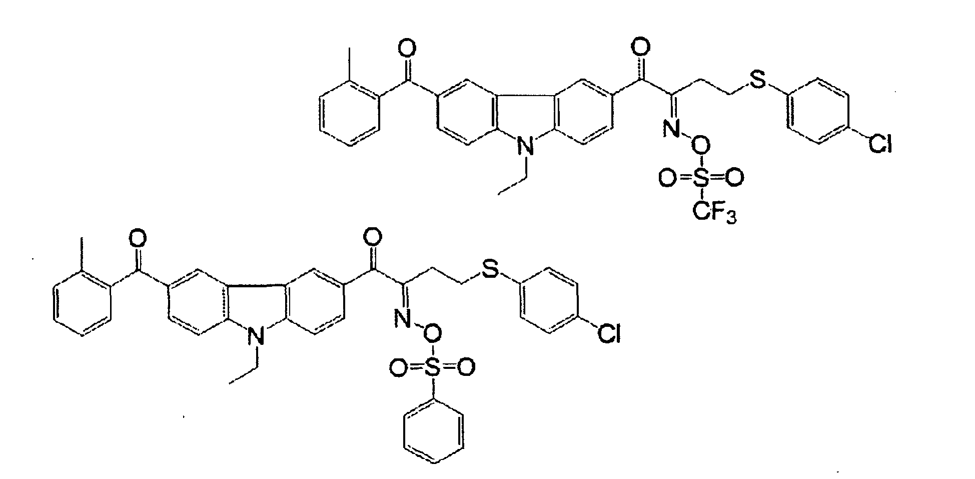

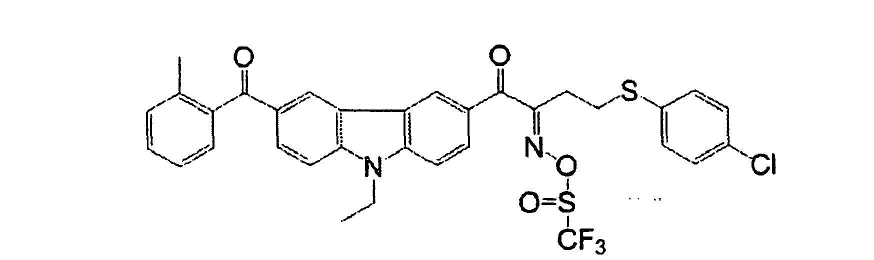

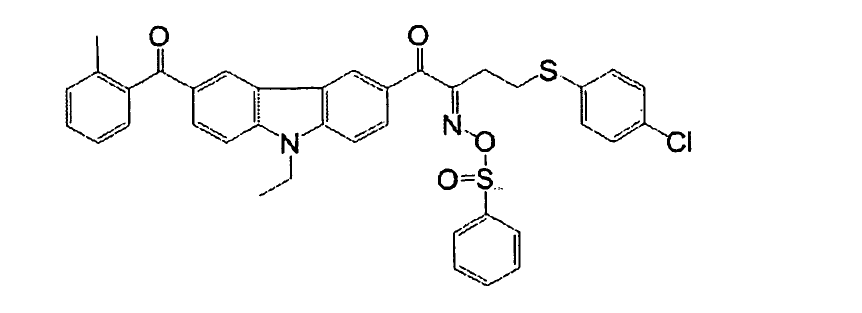

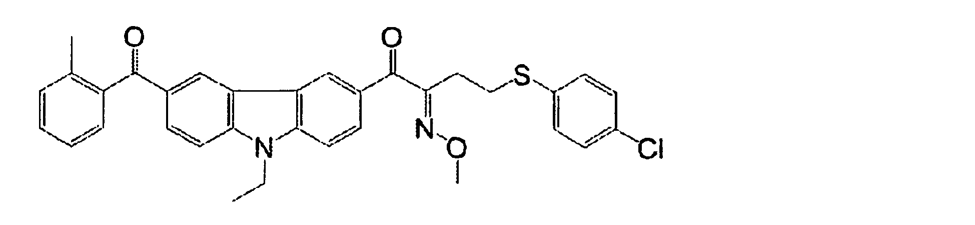

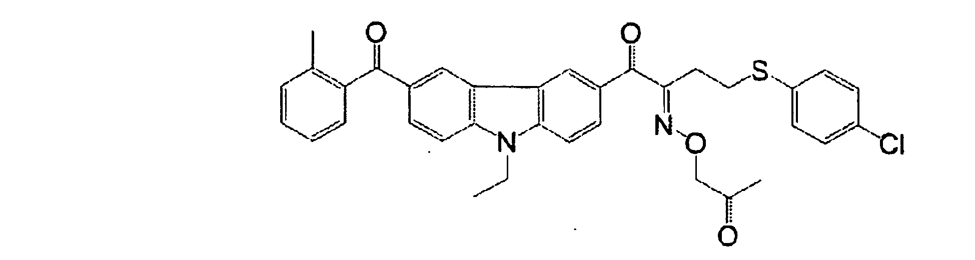

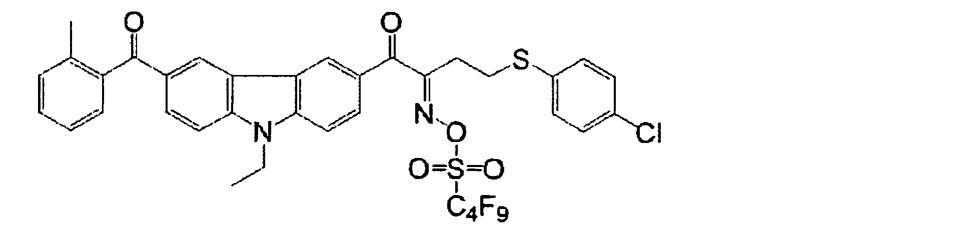

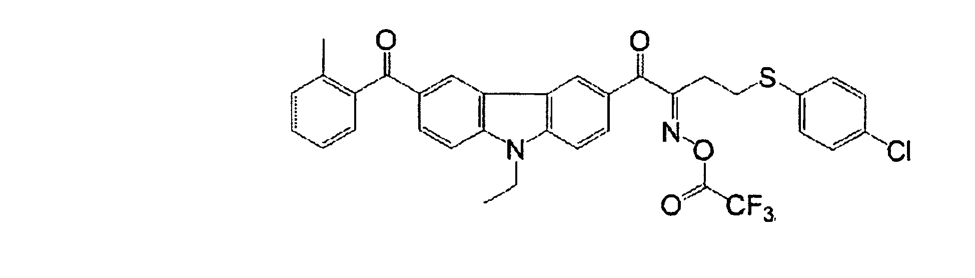

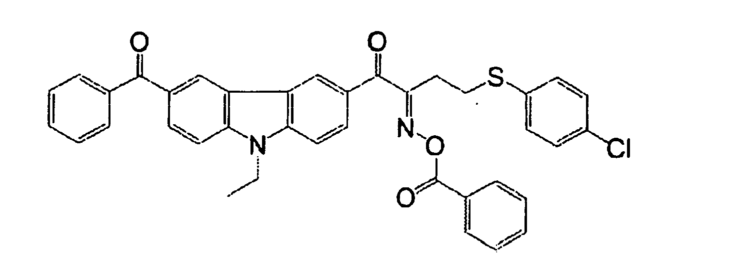

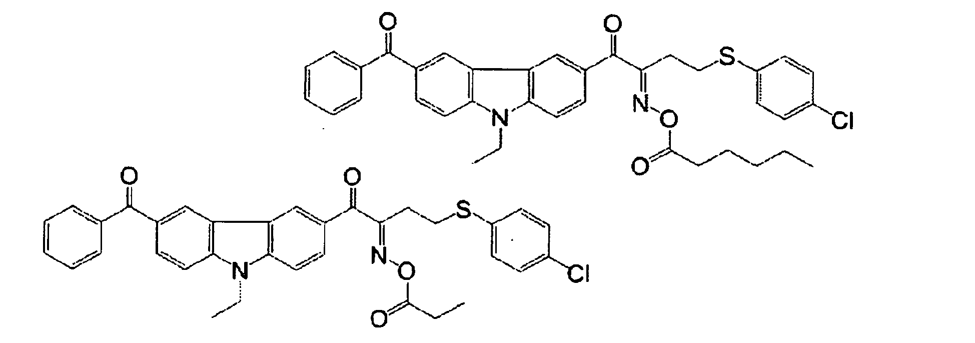

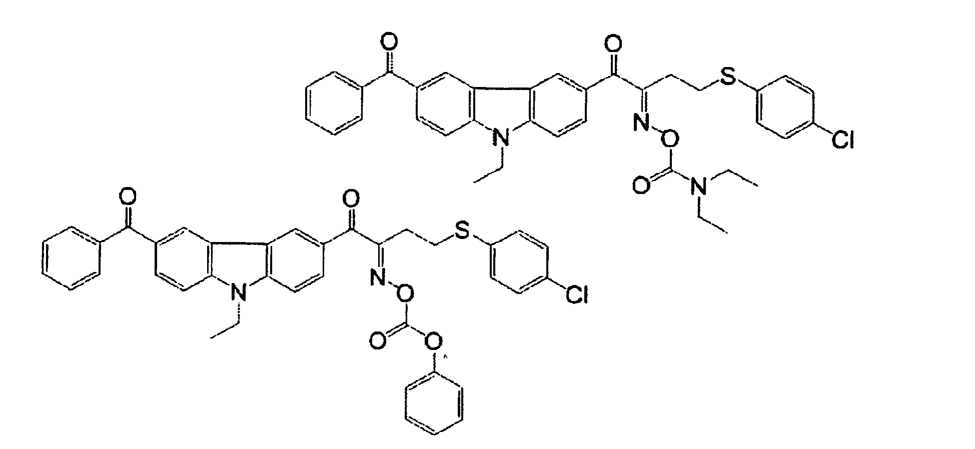

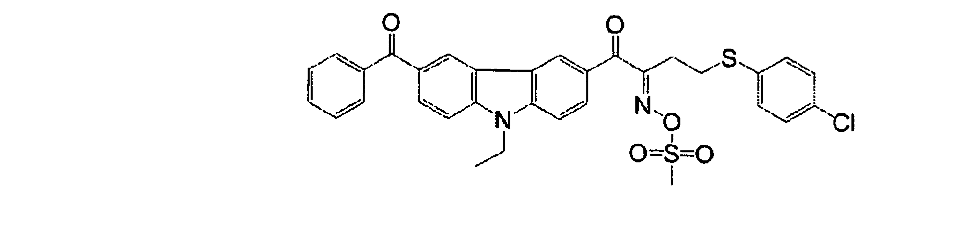

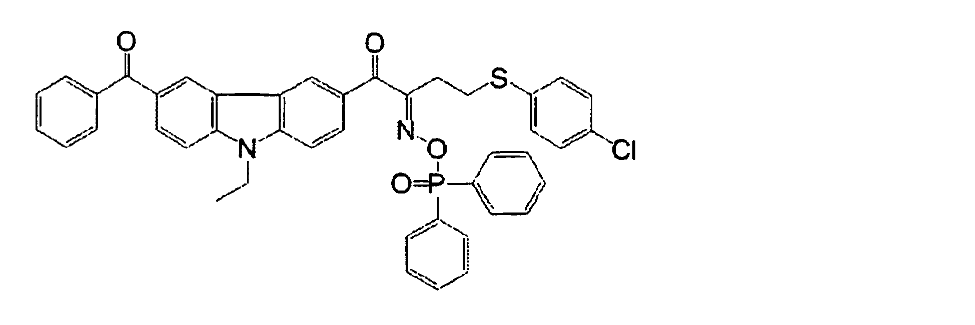

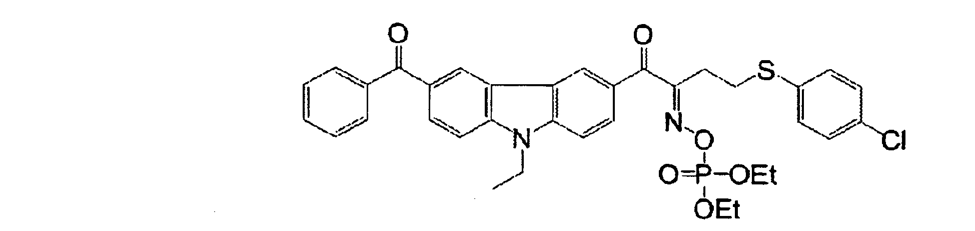

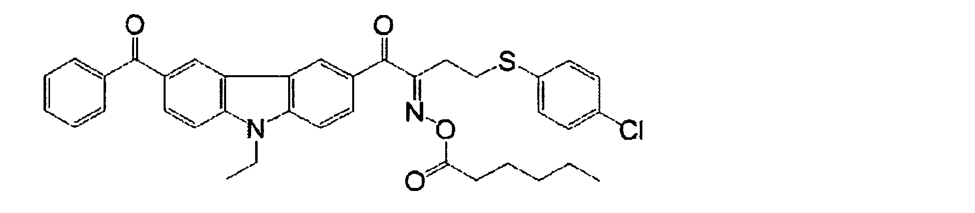

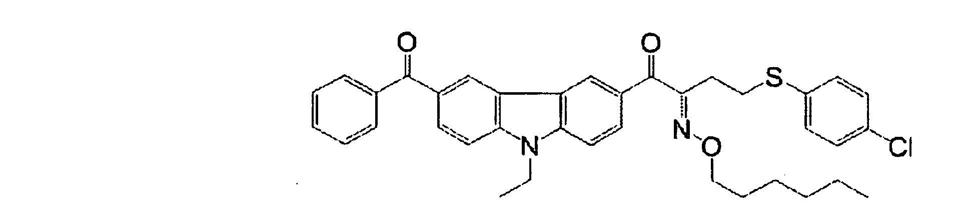

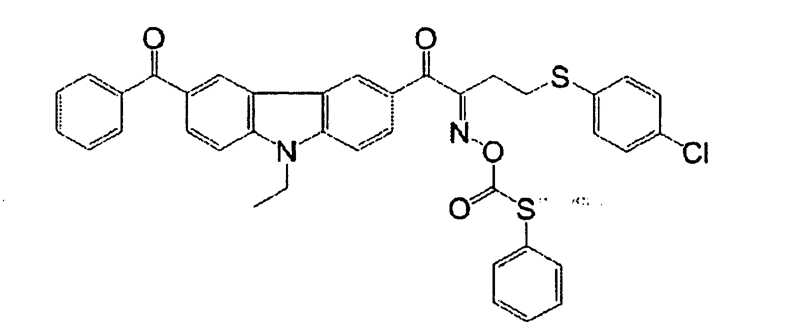

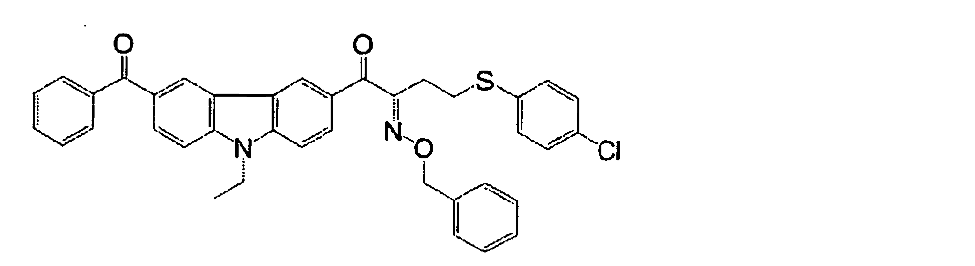

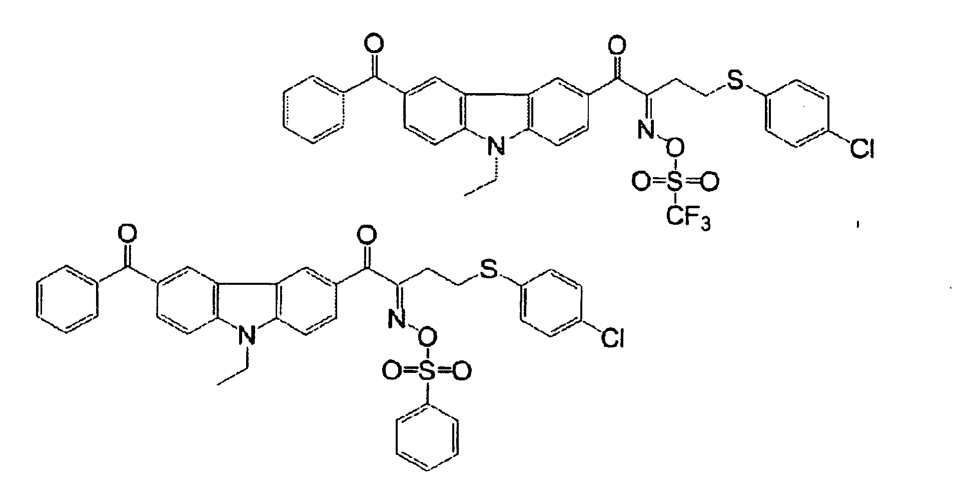

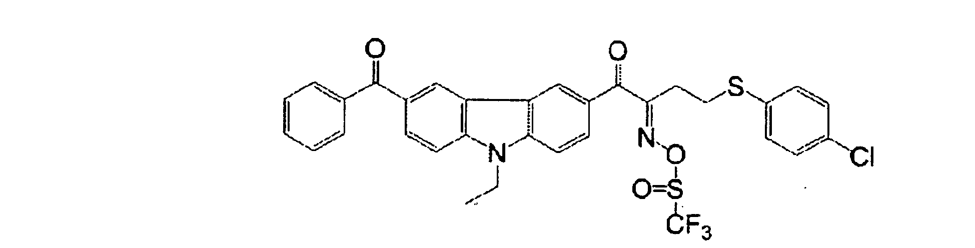

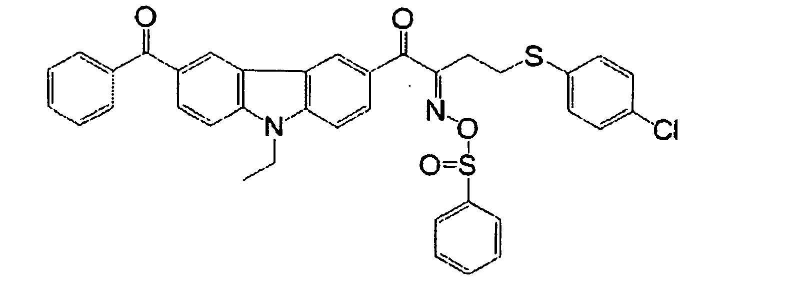

The content of (C) the photopolymerization initiator in the colored curable composition of the invention is preferably from 0.1% by mass to 50% by mass, more preferably from 0.5 to 30% by mass, and still more preferably from 1% by mass to 20% by mass, with respect to the total solid content of the colored curable composition. When the content of (C) the photopolymerization initiator is within the above range, excellent sensitivity and pattern forming property can be realized.

### (D) Polymerizable compound

The curable composition of the invention contains (D) the polymerizable compound. (D) The polymerizable compound that can be used in the invention is an addition-polymerizable compound having at least one ethylenic unsaturated double bond, which has a structure different from that of (F) an alkali-soluble resin described below. The addition-polymerizable compound having at least one ethylenic unsaturated double bond may be selected from compounds each having at least one terminal ethylenic unsaturated bond, preferably having two or more terminal ethylenic unsaturated bonds.

Such a class of compounds is widely known in the relevant industrial field, and such compounds may be used in the invention without particular limitations.

Such compounds may be in the chemical form of a monomer or a prepolymer (such as a dimer, a trimer, or an oligomer), or a mixture of a monomer and a prepolymer, or a copolymer of a monomer and a prepolymer. Examples of the monomer and copolymers thereof include an unsaturated carboxylic acid (such as acrylic acid, methacrylic acid, itaconic acid, crotonic acid, isocrotonic acid, or maleic acid), and an esters or amides of the unsaturated carboxylic acid.

It is preferable to use an ester of an unsaturated carboxylic acid and an aliphatic polyhydric alcohol compound, or an amide of an unsaturated carboxylic acid and an aliphatic polyamine. Specific examples thereof include an addition reaction product of an unsaturated carboxylic acid ester or amide having a nucleophilic substituent such as a hydroxyl group, an amino group or a mercapto group, with a monofunctional or polyfunctional, isocyanate or epoxy compound; and a dehydration condensation reaction product of such an unsaturated carboxylic acid ester or amide having a nucleophilic substituent with a monofunctional or polyfunctional carboxylic acid.

It is also preferable to use an addition reaction product of an unsaturated carboxylic acid ester or amide having an electrophilic substituent such as an isocyanate group or an epoxy group, with a monofunctional or polyfunctional alcohol, amine, or thiol, and a substitution reaction product of an unsaturated carboxylic acid ester or amide having a halogen group or having a leaving substituent such as a tosyloxy group, with a monofunctional or polyfunctional alcohol, amine, or thiol.

Other examples include a compound obtained by replacing the unsaturated carboxylic acid in any of the above examples with an unsaturated phosphonic acid, styrene, vinyl ether, or the like.

Examples of the ester monomer of an aliphatic polyhydric alcohol compound and an unsaturated carboxylic acid include acrylic esters such as ethyleneglycol diacrylate, triethyleneglycol diacrylate, 1,3-butanediol diacrylate, tetramethyleneglycol diacrylate, propyleneglycol diacrylate, neopentylglycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethyleneglycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, polyester acrylate oligomers, and isocyanuric acid EO-modified triacrylate.

Examples of the ester monomer also include methacrylic esters such as tetramethyleneglycol dimethacrylate, triethyleneglycol dimethacrylate, neopentylglycol dimethacrylate, trimethylolpropane trimethacrylate, trimethylolethane trimethacrylate, ethyleneglycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, and bis[p-(methacryloxyethoxy)phenyl]dimethylmethane.

Examples of the ester monomer also include itaconic esters such as ethyleneglycol diitaconate, propyleneglycol diitaconate, 1,3-butanediol diitaconate, 1,4-butanediol diitaconate, tetramethylene glycol diitaconate, pentaerythritol diitaconate, and sorbitol tetraitaconate; crotonic esters such as ethyleneglycol dicrotonate, tetramethylene glycol dicrotonate, pentaerythritol dicrotonate, and sorbitol tetradicrotonate; isocrotonic esters such as ethyleneglycol diisocrotonate, pentaerythritol diisocrotonate, and sorbitol tetraisocrotonate; and maleic esters such as ethyleneglycol dimaleate, triethyleneglycol dimaleate, pentaerythritol dimaleate, and sorbitol tetramaleate.

Examples of other esters include aliphatic alcohol esters such as those described in Japanese Patent Publication (JP-B) No. 51-47334 and JP-A No. 57-196231, aromatic skeleton-containing compounds such as those described in JP-A Nos. 59-5240, 59-5241 and 02-226149, and amino group-containing compounds such as those described in JP-A No. 01-165613. A mixture of monomers selected from the ester monomers described above may be used.

A monomer having an acid group may be used as the compound having an ethylenic unsaturated double bond. Examples thereof include (meth)acrylic acid, pentaerythritol triacrylate monosuccinate, dipentaerythritol pentaacrylate monosuccinate, pentaerythritol triacrylate monomaleate, dipentaerythritol pentaacrylate monomaleate, pentaerythritol triacrylate monophthalate, dipentaerythritol pentaacrylate monophthalate, pentaerythritol triacrylate mono-tetrahydrophthalate, and dipentaerythritol pentaacrylate mono-tetrahydrophthalate. Among these, pentaerythritol triacrylate monosuccinate is preferable in terms of developability and sensitivity.

Examples of the amide monomer of an aliphatic polyamine compound and an unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, and xylylene bismethacrylamide.
Examples of other preferred amide monomers include cyclohexylene structure-containing compounds such as those described in JP-B No. 54-21726.

Addition-polymerizable urethane compounds produced by an addition reaction of isocyanate with a hydroxyl group are also preferable. Examples thereof include vinyl urethane compounds such as those described in JP-B No. 48-41708, which have two or more polymerizable vinyl groups within a molecule thereof and which are produced by adding a compound represented by the following Formula (4) to a polyisocyanate compound having two or more isocyanate groups within a molecule thereof.

CH₂ = C (R¹⁰) COOCH₂CH (R¹¹) OH Formula (4)

In Formula (4), R¹⁰ and R¹¹ each independently represent H or CH₃.

In addition, urethane acrylates such as those disclosed in JP-A No. 51-37193 and JP-B Nos. 2-32293 and 2-16765 and urethane compounds having an ethylene oxide skeleton such as those disclosed in JP-B Nos. 58-49860, 56-17654, 62-39417, and 62-39418 are preferable. In order to obtain a photopolymerizable composition with remarkably excellent photo-reactive rate, addition-polymerizable compounds having an amino structure and/or a sulfide structure in a molecule thereof, such as those disclosed in JP-A Nos. 63-277653, 63-260909, and 1-105238, are preferable.

Other examples include polyfunctional (meth)acrylates, such as polyester (meth)acrylates and epoxy (meth)acrylates obtained by reacting an epoxy resin and (meth)acrylic acid, such as those disclosed in JP-A No. 48-64183 and JP-B Nos. 49-43191 and 52-30490; specific unsaturated compounds such as those described in JP-B Nos. 46-43946, 1-40337, and 1-40336; and vinyl phosphonic acid compounds such as those described in JP-A No. 2-25493. In a certain case, a structure containing a perfluoroalkyl group such as those described in JP-A No. 61-22048 can be suitably used. Furthermore, substances that are described, as photosetting monomers and photosetting oligomers, in Nihon Secchaku Kyoukai-Shi (journal of the Adhesion Society of Japan) Vol.20, No.7, pp. 300-308 (1984) can also be used.

Details of how to use (D) the polymerizable compound, such as what structure is used, whether they are used alone or in combination, or what amount is added, may be freely determined depending on the desired performance of the curable composition. For example, they may be selected from the following viewpoints.
In view of sensitivity, the polymerizable compound preferably has a structure having a higher content of unsaturated groups per molecule, and bifunctional or higher functional structures are preferable in many cases. In order to increase the strength of an image area (cured film in an image area), the polymerizable compound preferably has a tri- or higher-functional structure. A method of using a combination of compounds having different numbers of functional groups and/or different types of polymerizable groups (for example, compounds selected from an acrylic ester, a methacrylic ester, a styrene compound, a vinyl ether compound) is also effective for regulating both of sensitivity and strength. The polymerizable compound preferably contains an EO-modified product from the viewpoint of curing sensitivity and developability of an unexposed area.
In view of curing sensitivity, it is preferable to use a compound containing at least two (meth)acrylic acid ester structures, more preferably a compound containing at least three (meth)acrylic acid ester structures, and still more preferably a compound containing at least four (meth)acrylic acid ester structures. The polymerizable compound preferably contains a carboxylic acid group or an EO-modified structure from the viewpoint of curing sensitivity and developability of an unexposed area. The polymerizable compound is preferably a compound containing a urethane bond from the viewpoint of curing sensitivity and strength of an exposed area.

In addition, selection and usage mode of the polymerizable compound are very important factors affecting the compatibility with other components contained in the colored curable composition (for example, a resin, a photopolymerization initiator and a colorant) and dispersibility. For example, the compatibility may be improved by using a low-purity compound or by using two or more polymerizable compounds in combination. Furthermore, a specific structure may be selected in order to improve the adhesiveness to a surface of a substrate.

From the above-mentioned viewpoints, preferable examples of (D) the polymerizable compound include bisphenol A diacrylate, a bisphenol A diacrylate EO-modified product, trimethylolpropane triacrylate, trimethylolpropane tri(acryloyloxypropyl) ether, trimethylolethane triacrylate, tetraethylene glycol diacrylate, pentaerythritol diacrylate, pentaerythritol triacrylate, pentaerythritol tetraacrylate, dipentaerythritol tetraacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, a pentaerythritol tetraacrylate EO-modified product, a dipentaerythritol hexaacrylate EO-modified product, and pentaerythritol triacrylate monosuccinate; and commercially available products, for example, urethane oligomers such as UAS-10 and UAB-140 (trade name, manufactured by Sanyo-Kokusaku Pulp Co., Ltd.); DPHA-40H (trade name, manufactured by Nippon Kayaku Co., Ltd.); UA-306H, UA-306T, UA-306I, AH-600, T-600 and AI-600 (trade name, manufactured by Kyoeisha Chemical Co., Ltd.) and UA-7200 (trade name, manufactured by Shin-Nakamura Chemical Co., Ltd.).

Of these, a bisphenol A diacrylate EO-modified product, pentaerythritol triacrylate, pentaerythritol tetraacrylate, dipentaerythritol pentaacrylate, dipentaerythritol hexaacrylate, tri(acryloyloxyethyl) isocyanurate, a pentaerythritol tetraacrylate EO-modified product, a dipentaerythritol hexaacrylate EO-modified product, and pentaerythritol triacrylate monosuccinate are more preferable, and, as commercially available products, DPHA-40H (trade name, manufactured by Nippon Kayaku Co., Ltd.) and UA-306H, UA-306T, UA-306I, AH-600, T-600 and AI-600 (trade name, manufactured by Kyoeisha Chemical Co., Ltd.) are more preferable.

The content of (D) the polymerizable compound is preferably from 1% by mass to 90% by mass, more preferably from 5% by mass to 80% by mass, and still more preferably from 10% by mass to 70% by mass, with respect to the total solid content of the colored curable composition of the invention.

### (E) Solvent

The colored curable composition of the invention contains at least one solvent as (E) the solvent.

Examples of (E) the solvent include organic solvents as described in the following, and may be selected considering the solubility of the respective components contained in a pigment dispersion liquid, and the coating properties when used in the colored curable composition. The solvent is basically not particularly restricted as long as it satisfies desired properties, and is preferably selected in consideration of safety.

Specific examples of the solvent include esters, such as ethyl acetate, n-butyl acetate, isobutyl acetate, amyl formate, isoamyl acetate, butyl propionate, ethyl lactate, isopropyl butyrate, ethyl butyrate, butyl butyrate, methyl oxyacetate, ethyl oxyacetate, butyl oxyacetate, methyl methoxyacetate, ethyl methoxyacetate, butyl methoxyacetate, methyl ethoxyacetate, ethyl ethoxyacetate, methyl 3-oxypropionate, ethyl 3-oxypropionate, methyl 3-methoxypropionate, ethyl 3-methoxypropionate, methyl 3-ethoxypropionate, ethyl 3-ethoxypropionate, methyl 2-oxypropionate, ethyl 2-oxypropionate, propyl 2-oxypropionate, methyl 2-methoxypropionate, ethyl 2-methoxypropionate, propyl 2-methoxypropionate, methyl 2-ethoxypropionate, ethyl 2-ethoxypropionate, methyl 2-oxy-2-methylpropionate, ethyl 2-oxy-2-methylpropionate, methyl 2-methoxy-2-methylpropionate, ethyl 2-ethoxy-2-methylpropionate, methyl pyruvate, ethyl pyruvate, propyl pyruvate, methyl acetoacetate, ethyl acetoacetate, methyl 2-oxobutanoate, and ethyl 2-oxobutanoate;

ethers, such as diethyleneglycol dimethyl ether, tetrahydrofuran, ethyleneglycol monomethyl ether, ethyleneglycol monoethyl ether, methyl cellosolve acetate (ethyleneglycol monomethyl ether acetate), ethyl cellosolve acetate (ethyleneglycol monoethyl ether acetate), diethyleneglycol monomethyl ether, diethyleneglycol monoethyl ether, diethyleneglycol monobutyl ether, diethyleneglycol monoethyl ether acetate, diethyleneglycol monobutyl ether acetate, propyleneglycol methyl ether, propyleneglycol monomethyl ether acetate (PGMEA), propyleneglycol ethyl ether acetate, and propyleneglycol propyl ether acetate;
ketones, such as methyl ethyl ketone, cyclohexanone, 2-heptanone, and 3-heptanone; and
aromatic hydrocarbons, such as toluene and xylene.

Among these, methyl 3-ethoxypropionate, ethyl 3-ethoxypropionate, ethyl cellosolve acetate, ethyl lactate, diethyleneglycol dimethyl ether, n-butyl acetate, methyl 3-methoxypropionate, 2-heptanone, cyclohexanone, diethyleneglycol monoethyl ether acetate, diethyleneglycol monobutyl ether acetate, propyleneglycol methyl ether, and propyleneglycol monomethyl ether acetate (PGMEA) are more preferable.

The content of (E) the solvent in the colored curable composition of the invention is preferably from 50% by mass to 90% by mass, more preferably from 60% by mass to 90 % by mass, and still more preferably from 70% by mass to 90% by mass, with respect to the total mass of the colored curable composition. When the content of (E) the solvent is within the above range, generation of residual matter can be suppressed.

### (F) Alkali-soluble resin containing a repeating unit represented by Formula (1)

The colored curable composition of the invention contains (F) the alkali-soluble resin containing a repeating unit represented by the following Formula (2) or (3) (hereinafter sometimes referred to as a "specific alkali-soluble resin".).

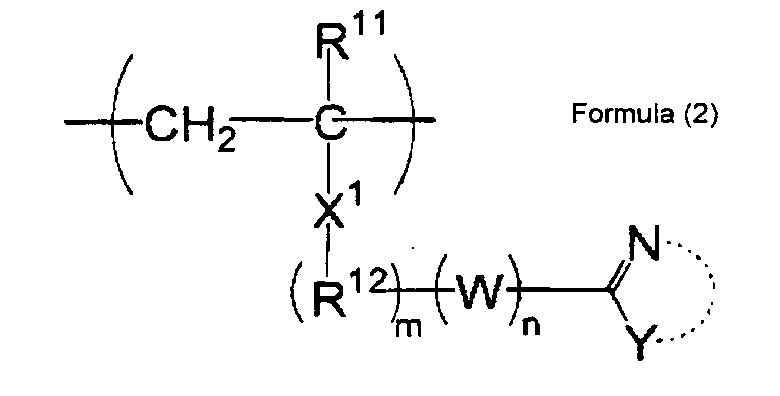

In Formula (2), R¹¹ represents a hydrogen atom, or a substituted or unsubstituted alkyl group; R¹² represents an alkylene group; X¹ represents -CO-, -COO-, OCO-, -CONH- or a phenylene group; W represents -O-, -S-, -COO-, -CONH-, -COS-, -NHCONH-, -NHCOO-, -NHCOS-, -OCO-, -OCONH- or -NHCO-; Y represents -NR¹³-, -O-, -S- or -N=. Y is linked to the N atom via an atomic group adjacent to Y to form a cyclic structure. R¹³ represents a hydrogen atom, an alkyl group, or aryl group. *m* and n each independently represents 0 or 1.

Hereinafter, the repeating unit represented by Formula (2) will be described in detail.

In Formula (2), R¹¹ represents a hydrogen atom, or a substituted or unsubstituted alkyl group. The alkyl group represented by R¹¹ is preferably an alkyl group having 1 to 12 carbon atoms, more preferably an alkyl group having 1 to 8 carbon atoms, and still more preferably an alkyl group having 1 to 4 carbon atoms. When the alkyl group represented by R¹¹ has a substituent, examples of the substituent that may be introduced include a hydroxyl group, an alkoxy group, an aryloxy group, an acyloxy group and a halogen group.
Preferable examples of the alkyl group represented by R¹¹ include a methyl group, an ethyl group, a propyl group, an n-butyl group, an i-butyl group, a t-butyl group, an n-hexyl group, a cyclohexyl group, a 2-hydroxyethyl group, a 3-hydroxypropyl group, a 2-hydroxypropyl group and a 2-methoxyethyl group.

R¹² represents an alkylene group.

The alkylene group represented by R¹² is preferably an alkylene group having 1 to 12 carbon atoms, more preferably an alkylene group having 1 to 8 carbon atoms, and particularly preferably an alkylene group having 1 to 4 carbon atoms.

The alkylene group represented by R¹² may have a substituent, and examples of the substituent include a hydroxyl group, an alkoxy group, an aryloxy group and an acyloxy group.

Preferable examples of the alkylene group represented by R¹² include a methylene group, an ethylene group, a propylene group, a trimethylene group and a tetramethylene group.

X¹ represents -CO-, -COO-, -OCO-, -CONH-, or a phenylene group, and preferably represents -COO- or -CONH-.

Y represents -NR¹³-, -O-, -S- or -N=, and Y is linked to the N atom via an atomic group adjacent to Y to form a cyclic structure. Here, R¹³ represents a hydrogen atom, an alkyl group or an aryl group, and preferably represents a hydrogen atom or a methyl group.

More preferably, Y represents -S-, -NH- or -N=.

Examples of the cyclic structure formed by Y being linked to the N atom via an adjacent atomic group include monocyclic structures such as an imidazole ring, a pyrimidine ring, a triazole ring, a tetrazole ring, a thiazole ring and an oxazole ring; and condensed-ring structures such as a benzimidazole ring, a benzothiazole ring, a benzoxazole ring, a purine ring, a quinazoline ring and a perimidine ring. In consideration of the affinity to pigments, the cyclic structure is preferably a fused-ring structure. Among fused-ring structures, a benzimidazole ring, a benzothiazole ring and a benzoxazole ring are more preferable.

W represents -O-, -S-, -COO-, -CONH-, -COS-, -NHCONH-, -NHCOO-, -NHCOS-, -OCO-, -OCONH- or -NHCO-. W represents preferably -O-, -S-, -CONH-, -NHCONH- or - NHCOS-.

*m* and n each independently represent 0 or 1. Preferably, both m and n represent 1.

Preferable examples of the repeating unit represented by Formula (2) include the following compounds (M-1) to (M-18), but the invention is not intended to be limited to these examples.

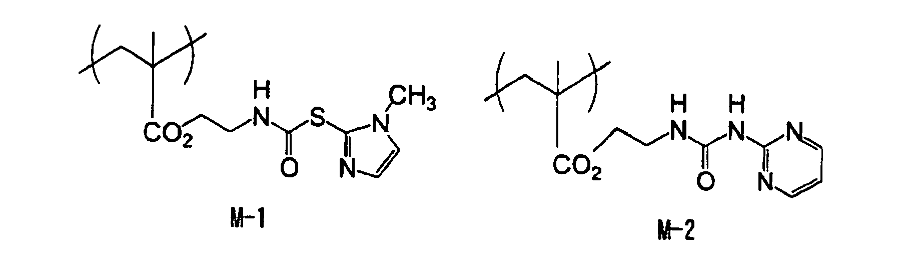

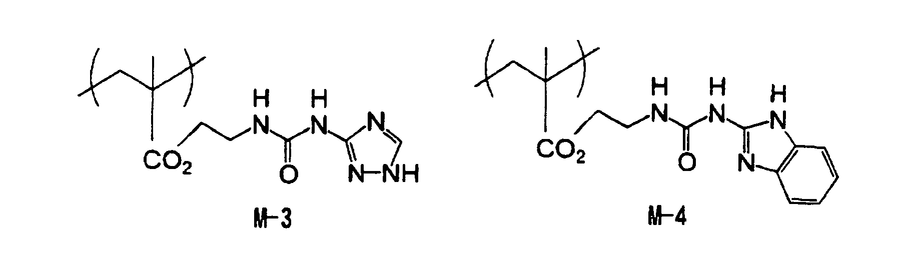

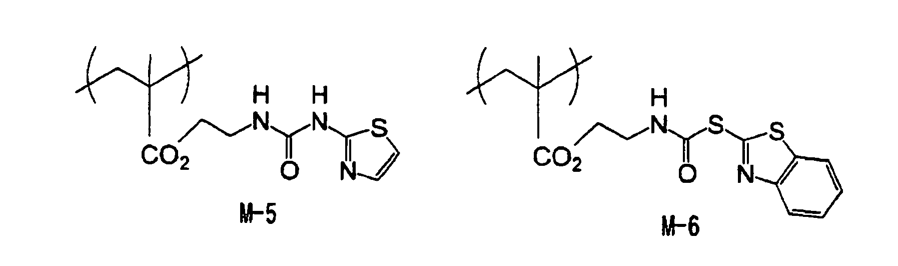

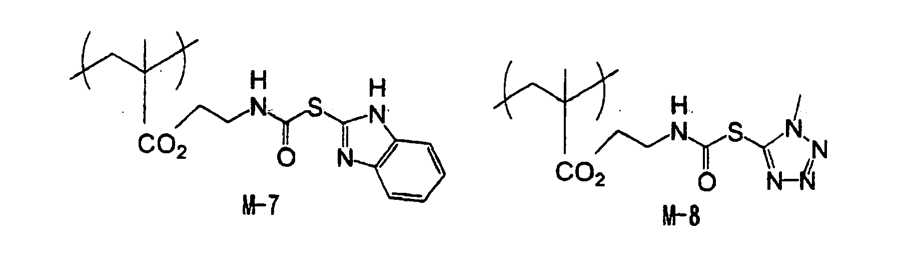

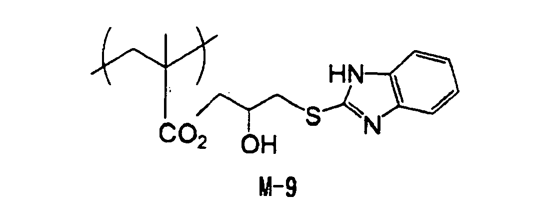

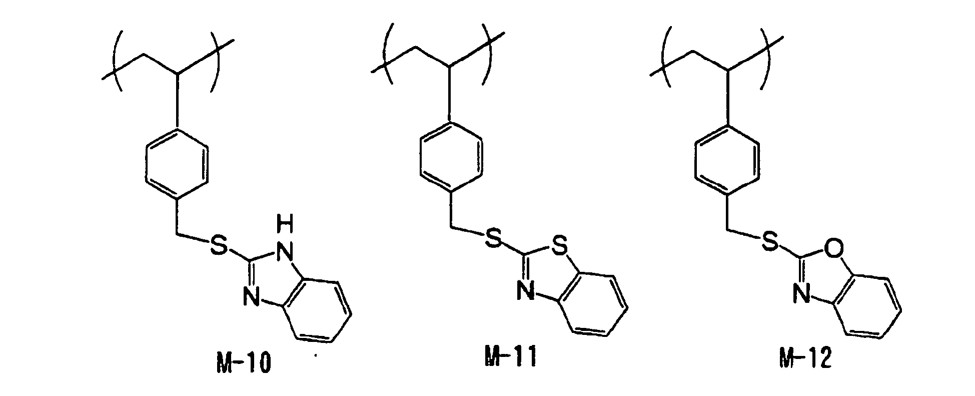

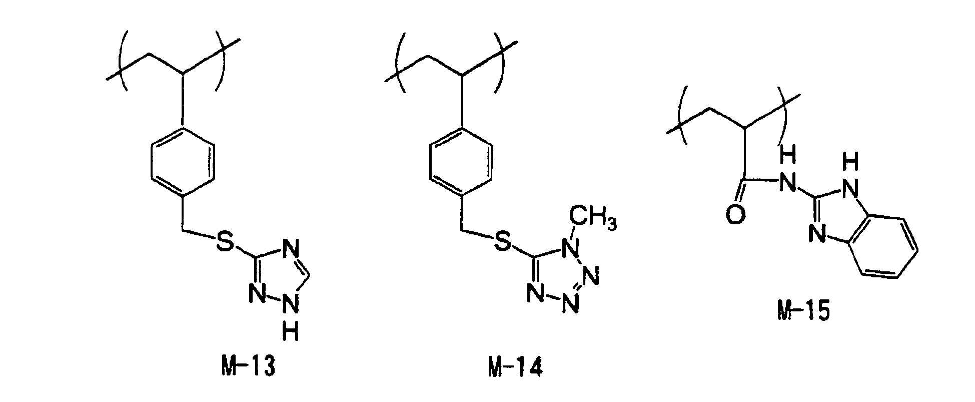

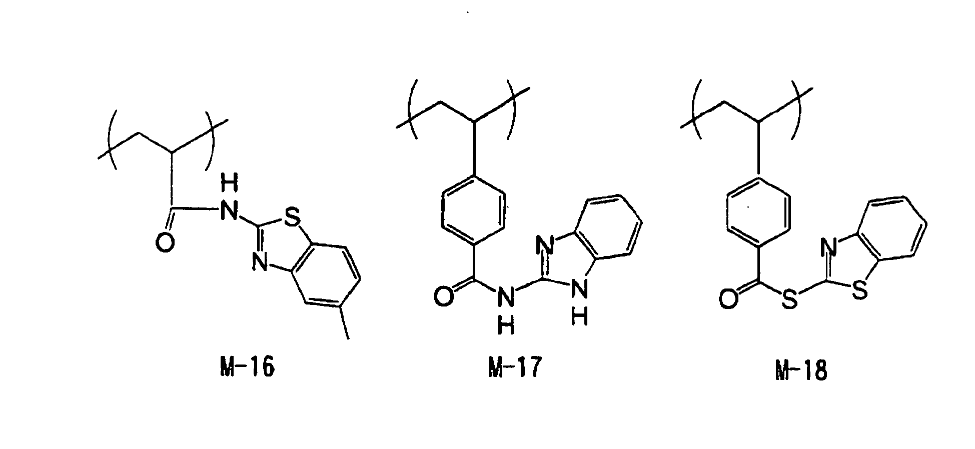

Hereinafter, the repeating unit represented by Formula (3) will be described in detail.

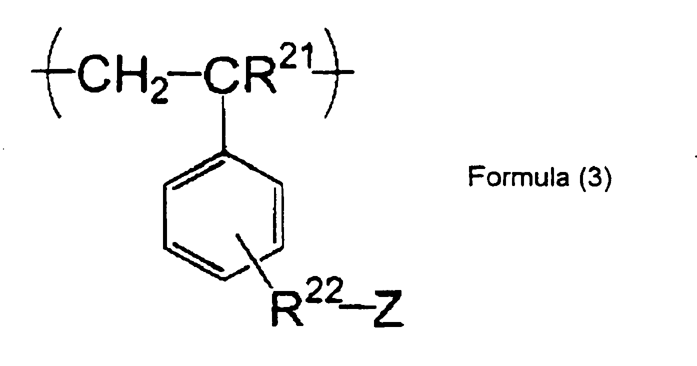

In Formula (3), R²¹ represents a hydrogen atom or a methyl group; R²² represents an alkylene group; and Z represents a nitrogen-containing heterocyclic group.

The alkylene group represented by R²² may have a substituent, and examples of the substituent include a methylene group, an ethylene group, a trimethylene group, a tetramethylene group, a hexamethylene group, a 2-hydroxypropylene group, a methyleneoxy group, an ethyleneoxy group, a methyleneoxycarbonyl group and a methylenethio group. Among these, a methylene group, a methyleneoxy group, a methyleneoxycarbonyl group and a methylenethio group are preferable.

In Formula (3), Z represents a nitrogen-containing heterocyclic group. Specific examples thereof include groups having a pyridine ring, a pyrazine ring, a pyrimidine ring, a pyrrole ring, an imidazole ring, a triazole ring, a tetrazole ring, an indole ring, a quinoline ring, an acridine ring, a phenothiazine ring, an phenoxazine ring, an acridone ring, an anthraquinone ring, a benzimidazole structure, a benzotriazole structure, a benzothiazole structure, a cyclic amide structure, a cyclic urea structure, or a cyclic imide structure.
Among these, a heterocyclic structure represented by Z is preferably a structure represented by the following Formula (4) or Formula (5).

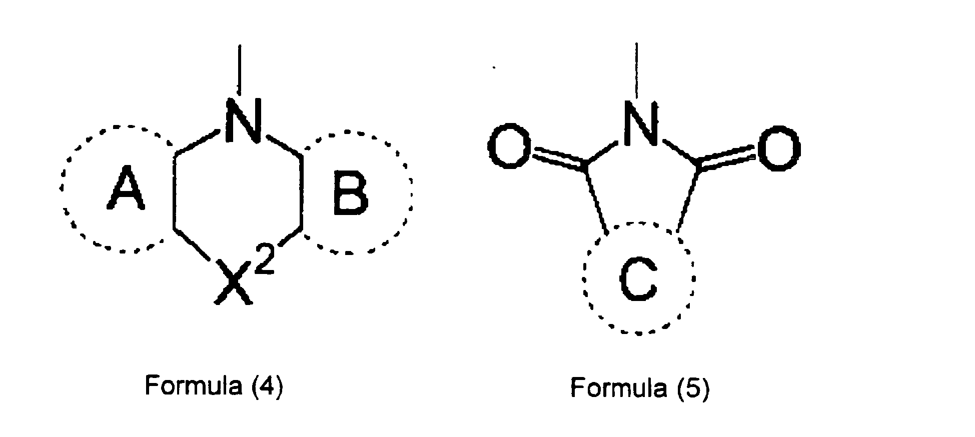

In Formula (4), X² represents a single bond, an alkylene group (for example, a methylene group, an ethylene group, a propylene group, a trimethylene group, a tetramethylene group), -O-, -S-, -NR- or -C(=O)-. Here, R represents a hydrogen atom or an alkyl group. Examples of the alkyl group represented by R include a methyl group, an ethyl group, an n-propyl group, an i-propyl group, an n-butyl group, a t-butyl group, an n-hexyl group, an n-octyl group, a 2-ethylhexyl group and an n-octadecyl group.

Among these, X² preferably represents a single bond, a methylene group, -O- or -C(=O)-, and more preferably represents -C(=O)-.

In Formulae (4) and (5), Ring A, Ring B and Ring C each independently represent an aromatic ring. Examples of the aromatic ring include a benzene ring, a naphthalene ring, an indene ring, an azulene ring, a fluorene ring, an anthracene ring, a pyridine ring, a pyrazine ring, a pyrimidine ring, a pyrrole ring, an imidazole ring, an indole ring, a quinoline ring, an acridine ring, a phenothiazine ring, a phenoxazine ring, an acridone ring and an anthraquinone ring. Among these, a benzene ring, a naphthalene ring, an anthracene ring, a pyridine ring, a phenoxazine ring, an acridine ring, a phenothiazine ring, a phenoxazine ring, an acridone ring and an anthraquinone ring are preferable, and a benzene ring, a naphthalene ring and a pyridine ring are more preferable.

Preferable examples of the repeating unit represented by Formula (3) include the following (M-21) to (M-27), but the invention is not intended to be limited to these examples.

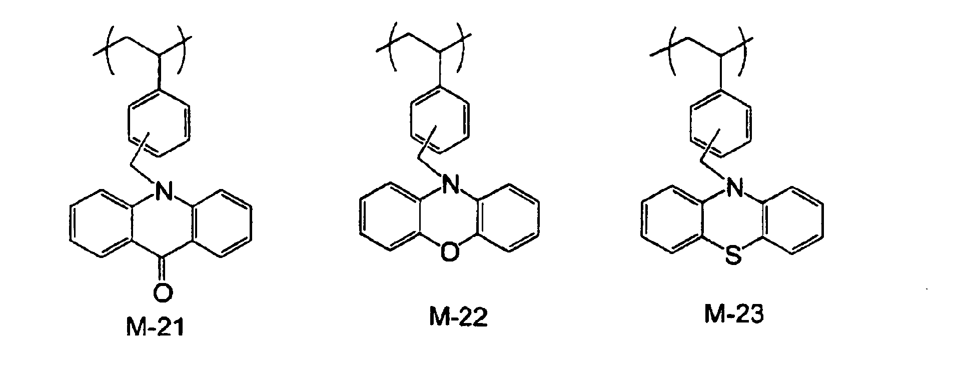

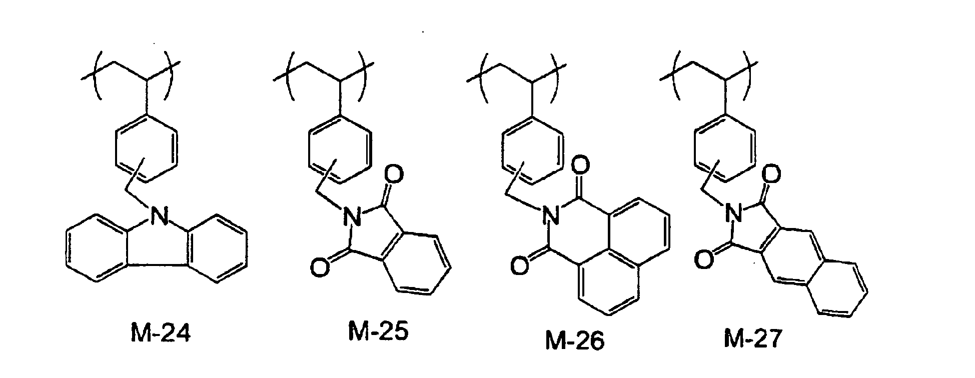

The repeating unit having a nitrogen-containing heterocyclic group according to the invention is preferably M-2, M-4, M-11, M-13, M-14, M-21, M-24, M-25 or M-26, and more preferably M-4, M-21 or M-26.
The content of the repeating unit having a nitrogen-containing heterocyclic group in the specific alkaline-soluble resin is preferably from 1% by mass to 50% by mass, more preferably from 5% by mass to 30% by mass, and still more preferably from 10% by mass to 20% by mass, with respect to the total mass of the specific alkaline-soluble resin.

(F) The specific alkali-soluble resin preferably further contains a repeating unit having an ethylenic unsaturated double bond at a side chain thereof. Examples of a method for introducing the repeating unit having an ethylenic unsaturated double bond into a side chain include (a) a method of reacting the specific alkali-soluble resin with a compound having an ethylenic unsaturated double bond, (b) a method of incorporating a monomer having an ethylenic unsaturated double bond through copolymerization, and (c) a method of incorporating a monomer having an elimination group with the specific alkali-soluble resin through copolymerization and introducing an ethylenic unsaturated double bond by an elimination reaction. Hereinafter, these methods will be described in detail.

### (a) Method of reacting a specific alkali-soluble resin with a compound having an ethylenic unsaturated double bond

The method (a) includes reacting a reaction site (site having a nucleophilic group such as a carboxyl group or a hydroxyl group) of the specific alkali-soluble resin with the compound having an ethylenic unsaturated double bond (for example, glycidyl (meth)acrylate, 2-isocyanatoethyl (meth)acrylate, 2-vinyloxirane, and (meth)acryloyl chloride) thereby performing introduction. Specifically, (a-1) a method of reacting a carboxyl group of the specific alkali-soluble resin with a compound having an epoxy group and an ethylenic unsaturated double bond in a molecule thereof; and (a-2) a method of reacting a hydroxyl group of the specific alkali-soluble resin with a compound having an isocyanate group and an ethylenic unsaturated double bond in a molecule thereof, are preferable from the viewpoint of productivity.

In method (a-1), known compounds having an epoxy group and an ethylenic unsaturated double bond in a molecule thereof can be used without limitation. Among such compounds, glycidyl methacrylate and 2-vinyloxirane are preferable, and glycidyl methacrylate is more preferable. The reaction is preferably performed in the presence of a catalyst. As the catalyst, any catalyst can be used without limitation as long as the catalyst can promote the reaction of a carboxyl group and an epoxy group. The catalyst is preferably a catalyst not containing a halogen atom. The catalyst is preferably a tertiary amine having a boiling point of 90°C or more, and more preferably a tertiary amine represented by NR³¹(CH₃)₂ (where R³¹ represents an alkyl group or a cycloalkyl group having 10 to 30 carbon atoms). The catalyst is preferably used in an amount of from 0.1% by mol to 10% by mol, and more preferably from 2% by mol to 7% by mol, with respect to the molar amount of the compound having an epoxy group and an ethylenic unsaturated double bond in a molecule thereof. The reaction temperature is preferably from 50°C to 150°C, more preferably from 60°C to 130°C, and still more preferably from 70°C to 110°C.

In method (a-2), known compounds having an isocyanate group and an ethylenic unsaturated double bond in the a molecule thereof can be used without limitation. Among such compounds, 2-isocyanatoethyl methacrylate and 2-isocyanatoethyl acrylate are preferable, and 2-isocyanatoethyl methacrylate is more preferable. The reaction is preferably performed in the presence of a catalyst. As the catalyst, any catalyst can be used without limitation as long as the catalyst can promote a reaction of a carboxyl group and an epoxy group. In particular, a Lewis acid catalyst is preferable, and Bi (for example, NEOSTAN (trade name, manufactured by NITTO KASEI CO., LTD.)) and Sn (for example, dibutyltin oxide) are more preferable. The catalyst is preferably used in an amount of from 0.1 % by mol to 10% by mol, and more preferably from 2% by mol to 7% by mol, with respect to the molar amount of the compound having an epoxy group and an ethylenic unsaturated double bond in a molecule thereof. The reaction temperature is preferably from 50°C to 150°C, more preferably from 60°C to 130°C, and still more preferably from 70°C to 110°C. The reaction is preferably performed under dehydration conditions.

### (b) Method of incorporating a monomer having an ethylenic unsaturated double bond through copolymerization

The monomer having an ethylenic unsaturated double bond is preferably a (meth)acrylic monomer having an allyl group having low copolymerization activities, and more preferably allyl methacrylate. The polymerization is preferably performed such that the total concentration of monomer is from 0.5% by mass to 20% by mass, and more preferably from 1% by mass to 10% by mass, with respect to the mass of solvent. When the concentration of the monomer is lower than the above range, polymerization rate may decrease and productivity may deteriorate. When the concentration is higher than the above range, a gelling is likely to occur.

### (c) Method of incorporating a monomer having an elimination group with a compound having an ethylenic unsaturated double bond through copolymerization and introducing an ethylenic unsaturated double bond by an elimination reaction

Here, the monomer having an elimination group refers to a monomer that can generate an ethylenic unsaturated double bond as a result of an elimination reaction caused by a base. In particular, monomers represented by the following Formula (6-1) and Formula (6-2) are preferable.

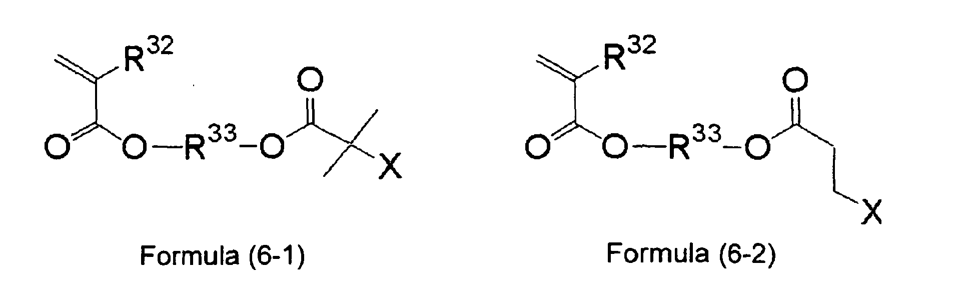

In Formula (6-1) and Formula (6-2), R³² represents a hydrogen atom, a methyl group, a hydroxymethyl group, or a trifluoromethyl group; R³³ represents an alkylene group having 1 to 10 carbon atoms, a cycloalkylene group having 4 to 10 carbon atoms, or an arylene group having 6 to 15 carbon atoms; and X represents a halogen atom.

The elimination reaction is preferably performed in the presence of a base. The base is preferably used in an amount of from 1 to 2 molar equivalents with respect to one molar equivalent of the monomer having an elimination group. As the base, any known base can be used without limitation. The base is preferably a tertiary amine such as a triethylamine or diisopropylmethylamine, or 1,8-diazabicyclo[5.4.0]-7-undecene (DBU).

Among the above methods (a) to (c), (a) the method of reacting the specific alkali-soluble resin with the compound having an ethylenic unsaturated double bond is preferable since the production cost can be reduced.

The monomers to be copolymerized to form the (F) the specific alkali-soluble resin of the invention may further include other monomers. Preferable examples of the other monomers include the following monomers (1) to (11):
(1) alkyl acrylates such as methyl acrylate, ethyl acrylate, propyl acrylate, butyl acrylate, isobutyl acrylate, amyl acrylate, hexyl acrylate, 2-ethylhexyl acrylate, octyl acrylate, benzyl acrylate, 2-chloroethyl acrylate, glycidyl acrylate, 3,4-epoxycyclohexylmethyl acrylate, vinyl acrylate, 2-phenylvinyl acrylate, 1-propenyl acrylate, allyl acrylate, 2-allyloxyethyl acrylate and propargyl acrylate;
(2) alkyl methacrylates such as methyl methacrylate, ethyl methacrylate, propyl methacrylate, butyl methacrylate, isobutyl methacrylate, amyl methacrylate, hexyl methacrylate, 2-ethylhexyl methacrylate, cyclohexyl methacrylate, benzyl methacrylate, 2-chloroethyl methacrylate, glycidyl methacrylate, 3,4-epoxycyclohexylmethyl methacrylate, vinyl methacrylate, 2-phenylvinyl methacrylate, 1-propenyl methacrylate, allyl methacrylate, 2-allyloxyethyl methacrylate and propargyl methacrylate;
(3) acrylamides or methacrylamides, such as acrylamide, methacrylamide, N-methylolacrylamide, N-ethylacrylamide, N-hexylmethacrylamide, N-cyclohexylacrylamide, N-hydroxyethylacrylamide, N-phenylacrylamide, N-nitrophenylacrylamide, N-ethyl-N-phenylacrylamide, vinylacrylamide, vinylmethacrylamide, N,N-diallylacrylamide, N,N-diallylmethacrylamide, allylacrylamide and allylmethacrylamide;

(4) vinyl ethers such as ethyl vinyl ether, 2-chloroethyl vinyl ether, hydroxyethyl vinyl ether, propyl vinyl ether, butyl vinyl ether, octyl vinyl ether and phenyl vinyl ether;
(5) vinyl esters such as vinyl acetate, vinyl chloroacetate, vinyl butyrate and vinyl benzoate;
(6) styrenes such as styrene, α-methylstyrene, methylstyrene, chloromethylstyrene and p-acetoxystyrene;
(7) vinyl ketones such as methyl vinyl ketone, ethyl vinyl ketone, propyl vinyl ketone and phenyl vinyl ketone;
(8) olefins such as ethylene, propylene, isobutylene, butadiene and isoprene; [0178] (9) N-vinylpyrrolidone, acrylonitrile and methacrylonitrile;
(10) unsaturated imides such as maleimide, N-acryloylacrylamide, N-acetylmethacrylamide, N-propionylmethacrylamide and N-(p-chlorobenzoyl)methacrylamide; and
(11) methacrylic acid monomers having a heteroatom bound to the α-position such as the compounds described in JP-A Nos. 2002-309057 and 2002-311569.

In addition, examples of other monomers include monomers having a carboxy group and monomers having a hydroxyl group. Specific examples of the monomers having a carboxy group include acrylic acid, methacrylic acid, itaconic acid, crotonic acid, maleic acid, fumaric acid and 4-carboxylstyrene. Acidic cellulose derivatives having a carboxyl group at a side chain thereof may also be used. Examples of other monomers further include products formed by adding a cyclic acid anhydride to a polymer having a hydroxyl group.
Examples of the monomers having a hydroxyl group include acrylic acid esters having an aliphatic hydroxyl group and methacrylic acid esters having an aliphatic hydroxyl group, such as 2-hydroxyethyl acrylate, 2-hydroxypropyl acrylate, 3-hydroxypropyl acrylate, 4-hydroxybutyl acrylate, 2-hydroxyethyl methacrylate, 2-hydroxypropyl methacrylate, 3-hydroxypropyl methacrylate and 4-hydroxybutyl methacrylate; ethyleneoxy-modified products thereof; and hydroxystyrene.

From the viewpoints of sensitivity, developability and storage stability, the weight average molecular weight of (F) the specific alkali-soluble resin is preferably from 3,000 to 300,000, more preferably from 4,000 to 100,000, even more preferably from 5,000 to 50,000, and still more preferably from 6,000 to 25,000.

The quantity of ethylenic unsaturated bond per 1 g of (F) the specific alkali-soluble resin (unit: mol/g) is preferably 0.00001 mol/g or more, more preferably from 0.0001 mol/g to 0.01 mol/g, and still more preferably from 0.001 mol/g to 0.008 mol/g, from the viewpoints of sensitivity and storage stability.

The acid value of (F) the specific alkali-soluble resin is preferably from 40 mg KOH/g to 250 mg KOH/g, more preferably from 50 mg KOH/g to 200 mg KOH/g, and still more preferably from 70 mg KOH/g to 120 mg KOH/g. Preferable examples of monomers having an acid group include (meth)acrylic acid, p-vinylbenzoic acid, maleic acid, fumaric acid, itaconic acid, succinic anhydride adducts of 2-hydroxyethyl (meth)acrylate and phthalic anhydride adducts of 2-hydroxyethyl (meth)acrylate.

(F) the specific alkali-soluble resin may further contain a graft structure having branches. In order to form the graft structure, it is preferable to use polymerizable oligomers (macromonomers). Preferable examples of the polymerizable oligomers include polymethyl (meth)acrylate, poly-n-butyl (meth)acrylate, poly-i-butyl (meth)acrylate, and a polymer produced by attaching a (meth)acryloyl group at one end of a polystyrene molecule. Examples of commercially available polymerizable oligomers include a polystyrene oligomer having a methacryloyl group at one end (Mn = 6000, trade name: AS-6, manufactured by Toagosei Co., Ltd.), a polymethyl methacrylate oligomer having a methacryloyl group at one end (Mn = 6000, trade name: AA-6, manufactured by Toagosei Co., Ltd.) poly-n-butyl acrylate oligomer having a methacryloyl group at one end (Mn = 6000, trade name: AB-6, manufactured by Toagosei Co., Ltd.), and products manufactured by Toagosei Co., Ltd. such as UM-9001, XM-9053, WM-9054, UC-3000, UC-3900, UC-3910, UC-3920, UF-5022 (all containing a COOH group), AA-714, AX-714, AY-707, AY-714, UH-2000, UH-2032, UH-2041, UH-2170, and UHE-2012 (all containing a OH group).

The content of (F) the alkali-soluble resin in the colored curable composition in the invention is preferably from 10% by mass to 100% by mass, more preferably from 20% by mass to 80% by mass, and still more preferably from 20% by mass to 50% by mass, with respect to the mass of the pigment. (F) The specific alkali-soluble resin may be added during a process of pulverizing (salt milling) the pigment, or added at the time of preparing the pigment dispersion liquid, or added to the pigment dispersion liquid after a dispersion process. (F) The specific alkali-soluble resin may be added during a process of preparing the colored curable composition or may be separately added in each process.

The colored curable composition of the invention may further contain at least one of the following components if necessary.

### Sensitizer

The colored curable composition of the invention may include a sensitizer for the purposes of improving the radical generation efficiency of (C) the photopolymerization initiator and shifting the wavelength at which (C) the photopolymerization initiator has sensitivity to a longer wavelength side. The sensitizer used in the invention is preferably a sensitizer that sensitizes the (C) the photopolymerization initiator by an electron transfer mechanism or an energy transfer mechanism. Examples of the sensitizer for use in the colored curable composition of the invention include compounds which belong to any of the groups of compounds described below and which have an absorption wavelength in the wavelength range of 300 nm to 450 nm.

Preferable examples of the sensitizer include compounds which belong to any of the groups of compounds described below and have an absorption wavelength in the wavelength range of 330 nm to 450 nm.
Specific examples of the sensitizer include polynuclear aromatic compounds (such as phenanthrene, anthracene, pyrene, perylene, triphenylene, and 9,10-dialkoxyanthracene), xanthenes (such as fluorescein, eosin, erythrosine, rhodamine B, and rose bengal), thioxanthones (such as isopropylthioxanthone, diethylthioxanthone and chlorothioxanthone), cyanines (such as thiacarbocyanine and oxacarbocyanine), merocyanines (such as merocyanine and carbomerocyanine), phthalocyanines, thiazines (such as thionine, methylene blue and toluidine blue), acridines (such as acridine orange, chloroflavin and acriflavin), anthraquinones (such as anthraquinone), squaryliums (such as squarylium), acridine orange, coumarins (such as 7-diethylamino-4-methylcoumarin), ketocoumarin, phenothiazines, phenazines, styrylbenzenes, azo compounds, diphenylmethane, triphenylmethane, distyrylbenzenes, carbazoles, porphyrin, spiro compounds, quinacridone, indigo, styryl compounds, pyrylium compounds, pyrromethene compounds, pyrazolotriazole compounds, benzothiazole compounds, barbituric acid derivatives, thiobarbituric acid derivatives, aromatic ketone compounds such as acetophenone, benzophenone, thioxanthone, and Michler's ketone, heterocyclic compounds such as N-aryloxazolidinone, and compounds such as those described in EP No. 568,993, USP Nos. 4,508,811 and 5,227,227, and JP-A Nos. 2001-125255 and 11-271969.

### Polymerization Inhibitor

In the invention, a thermal polymerization inhibitor may preferably be added in order to inhibit unnecessary polymerization of the compound having a polymerizable ethylenic unsaturated double bond during the production or storage of the colored curable composition.

Examples of the thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol), and N-nitrosophenylhydroxylamine cerous salt.

The addition amount of polymerization inhibitor is preferably from 0.10 parts by mass to 5 parts by mass, with respect to the total mass of the colored curable composition. If necessary, behenic acid or a higher fatty acid derivative such as behenic acid amide may be added to prevent oxygen-induced inhibition of polymerization and may be localized to the surface of a photosensitive layer during a drying process after coating. The content of the higher fatty acid derivative is preferably from about 0.5% by mass to about 10% by mass with respect to the total mass of the colored curable composition.

### Polymer material

From the viewpoints of improving dispersion stability, regulating developability, and the like, the colored curable composition of the invention may further contain a dispersant, examples of which include other polymer materials (e.g., polyamidoamine and salts thereof, polycarboxylic acid and salts thereof, high-molecular-weight unsaturated acid esters, modified polyurethanes, modified polyesters, modified poly(meth)acrylates, (meth)acrylic copolymers, naphthalene sulfonic acid formalin condensates), polyoxyethylene alkyl phosphate, polyoxyethylene alkylamine, and alkanolamine. The polymer materials can be further classified into straight-chain polymers, terminal-modified polymers, graft polymers, and block polymers according to their structures.

The above polymer materials are supposed to be adsorbed on the surface of the pigment, and work to prevent the pigment from aggregation. Accordingly, preferable structures of the polymer materials include terminal modified polymers, graft polymers, and block polymers, each of which has an anchoring site to the pigment surface.
Examples of polymer materials usable in the invention include DISPERBYK 101 (polyamidoamine phosphate), 107 (carboxylic acid ester), 110 (acid group-containing copolymer), 130 (polyamide), 161, 162, 163, 164, 165, 166, and 170 (high-molecular-weight copolymer), and BYK-P104 and P105 (high-molecular-weight unsaturated polycarboxylic acid) (trade name, all manufactured by BYK Chemie); EFKA 4047, 4050, 4010, and 4165 (polyurethane dispersants), EFKA 4330, 4340 (block copolymer), 4400, 4402 (modified polyacrylate), 5010 (polyester amide), 5765 (high-molecular-weight polycarboxylic acid salt), 6220 (fatty acid polyester), 6745 (phthalocyanine derivative), and 6750 (azo pigment derivative) (trade name, all manufactured by EFKA); AJISPER PB821 and PB822 (trade name, manufactured by Ajinomoto Fine-Techno Co., Inc.); FLOWLEN TG-710 (urethane oligomer) and POLYFLOW Nos. 50E and 300 (acrylic copolymer) (trade name, all manufactured by Kyoeisha Chemical Co., Ltd.); DISPARLON KS-860, 873SN, 874, #2150 (aliphatic polycarboxylic acid), #7004 (polyether ester), DA-703-50, DA-705, and DA-725 (trade name, all manufactured by Kusumoto Chemicals, Ltd.); DEMOL RN, N (naphthalenesulfonic acid formalin polycondensate), MS, C, SN-B (aromatic sulfonic acid formalin polycondensate), HOMOGENOL L- 18 (high-molecular-weight polycarboxylic acid), EMULGEN 920, 930, 935, and 985 (polyoxyethylene nonyl phenyl ether), and ACETAMIN 86 (stearylamine acetate) (trade name, all manufactured by Kao Corporation); SOLSPERSE 5000 (phthalocyanine derivative), 22000 (azo pigment derivative), 13240 (polyester amine), 3000, 17000, 27000 (polymer having a functional part at a terminal), 24000, 28000, 32000, and 38500 (graft polymers) (trade name, all available from The Lubrizol Corporation); and NIKKOL T106 (polyoxyethylene sorbitan monooleate) and MYS-IEX (polyoxyethylene monostearate) (trade name, all manufactured by Nikko Chemicals Co., Ltd).

These polymer materials may be used singly, or in combination two or more kinds thereof. When two or more kinds of polymer materials are used in combination, the total content of the polymer material is preferably from 1% by mass to 100% by mass, more preferably from 3% by mass to 80% by mass, and still more preferably from 5% by mass to 50% by mass, with respect to the mass of (F) the specific alkali-soluble resin. These polymer materials may be added at the time of the dispersion, or may be added after the dispersion.

### Other additives

Furthermore, in the invention, known additives such as an inorganic filler or a plasticizer, and/or a substrate-adhesion agent that can improve adhesiveness to a substrate, may be added, so as to improve the physical properties of the cured film.

Examples of the plasticizer include dioctyl phthalate, didodecyl phthalate, triethyleneglycol dicaprylate, dimethylglycol phthalate, tricresyl phosphate, dioctyl adipate, dibutyl sebacate, and triacetyl glycerol.

When the colored curable composition of the invention is applied to a hard surface such as a surface of a substrate, an additive that improves adhesiveness to the hard surface (hereinafter, referred to as a "substrate-adhesion agent") may be added to the colored curable composition.

Examples of the substrate-adhesion agent include a silane coupling agent, a titanium coupling agent and an aluminum coupling agent.

Examples of the silane coupling agent include γ-(2-aminoethyl)aminopropyltrimethoxysilane, γ-(2-aminoethyl)aminopropyldimethoxysilane, β-(3,4-epoxycyclohexyl)ethyltrimethoxysilane, γ-aminopropyltrimethoxysilane, γ-aminopropyltriethoxysilane, γ-methacryloxypropyltrimethoxysilane, γ-methacryloxypropyltriethoxysilane, γ-acryloxypropyltrimethoxysilane, γ-acryloxypropyltriethoxysilane, γ-isocyanatepropyltrimethoxysilane, γ-isocyanatepropyltriethoxysilane, N-β-(N-vinylbenzylaminoethyl)- γ-aminopropyltrimethoxysilane hydrochloride, γ-glycidoxypropyltrimetoxysilane, γ-glycidoxypropyltriethoxysilane, aminosilane, γ-mercaptopropyltrimethoxysilane, γ-mercaptopropyltriethoxysilane, methyltrimethoxysilane, methyltriethoxysilane, vinyltriacetoxysilane, γ-chloropropyltrimethoxysilane, hexamethyldisilazane, γ-anilinopropyltrimethoxysilane, vinyltrimethoxysilane, vinyltriethoxysilane, vinyltris(β-methoxyethoxy)silane, octadecyldimethyl[3-(trimethoxysilyl)propyl]ammonium chloride, γ-chloropropylmethyldimethoxysilane, γ-mercaptopropylmethyl dimethoxysilane, methyltrichlorosilane, dimethyldichlorosilane, trimethylchlorosilane, 2-(3,4-epoxycyclohexyl)ethyltrimethoxysilane, bisallyltrimethoxysilane, tetraethoxysilane, bis(trimethoxysilyl)hexane, phenyltrimethoxysilane, N-(3-acryloxy-2-hydroxypropyl)-3-aminopropyltriethoxysilane, N-(3-methacryloxy-2-hydroxypropyl)-3-aminopropyltriethoxysilane, (methacryloxymethyl)methyldiethoxysilane, and (acryloxymethyl)methyldimethoxysilane.
Among the above, γ-methacryloxypropyltrimethoxysilane, γ-methacryloxypropyltriethoxysilane, γ-acryloxypropyltrimethoxysilane, γ-acryloxypropyltriethoxysilane, γ-mercaptopropyltrimethoxysilane, γ-aminopropyltriethoxysilane, and phenyltrimethoxysilane are preferable, and γ-methacryloxypropyltrimethoxysilane is more preferable.

Examples of the titanate coupling agent include isopropyl triisostearoyl titanate, isopropyl tridecylbenzenesulfonyl titanate, isopropyl tris(dioctylpyrophosphate) titanate, tetraisopropyl bis(dioctylphosphite) titanate, tetraoctyl bis(ditridecylphosphite) titanate, tetra(2,2-diallyloxymethyl) bis(di-tridecyl)phosphite titanate, bis(dioctylpyrophosphate) oxyacetate titanate, bis(dioctylpyrophosphate) ethylene titanate, isopropyl trioctanoyl titanate, isopropyl dimethacryl isostearoyl titanate, isopropyl isostearoyl diacryl titanate, triisopropyl tri(dioctylphosphate) titanate, isopropyl tricumylphenyl titanate, isopropyl tri(N-amidoethyl, aminoethyl) titanate, dicumylphenyl oxyacetate titanate, and diisostearoyl ethylene titanate.

The aluminum coupling agent is, for example, acetoalkoxyaluminum diisopropylate.

The addition amount of the substrate-adhesion agent is preferably from 0.1 % by mass to 30% by mass, more preferably from 0.5% by mass to 20% by mass, and still more preferably from 1% by mass to 10% by mass, with respect to the total solid content of the colored curable composition, from the viewpoint of preventing a residue of an uncured colored curable composition from remaining in an unexposed area.

The colored curable composition of the invention can be cured with high sensitivity and has favorable storage stability. In addition, the colored curable composition of the invention has excellent adhesiveness to a surface of a hard material, such as a substrate, to which the curable composition is applied. Therefore, the colored curable composition of the invention can be preferably used in the fields of image forming materials such as three-dimensional optical molding, holography, or color filters; inks, coating materials, adhesives, and coating agents.
Even when the colored curable composition of the invention contains a pigment having a small size at a high concentration, pigment dispersion stability and developability of the colored curable composition are excellent and a colored region having high definition and favorable color characteristics can be formed therefrom, and these effects are particularly significant when the colored curable composition of the invention is used for forming color filters for solid-state image sensors, particularly for forming pixels having a film thickness of 0.8 µm or less, and preferably in the range of from 0.1 to 0.5 µm.

### Color filter and method for producing the color filter

Hereinafter, the color filter of the invention and a method for producing the color filter will be described.

The color filter of the invention has a colored pattern formed, on a substrate, by using the colored curable composition of the invention.

In the following, the color filter of the invention will be described in detail by way of its production method (method for producing the color filter of the invention).

The method of producing the color filter of the invention includes a colored layer forming process of applying the colored curable composition of the invention to a surface of a substrate to form a colored layer, an exposure process of pattern-wise exposing the colored layer through a mask, and a development process of developing the colored layer after exposure to form a colored pattern.
Hereinafter, the respective processes in the production method of the invention will be discussed.

### Colored layer forming process

In the colored layer forming process, the colored curable composition of the invention is applied to a surface of a substrate to form a colored layer.

Examples of the substrate that can be used in the colored layer forming process include non-alkali glass, soda glass, PYREX (registered trademark) glass, and substrates each obtained by attaching a transparent conductive film to any of these materials, which are used in a liquid crystal display and the like; photoelectric conversion element substrates that are used in solid-state image sensors, such as a silicon substrate; and a complementary metal-oxide semiconductor (CMOS). These substrates may have black stripes that separate respective pixels.
Furthermore, on these substrates, an undercoat layer may be provided, if necessary, for the purpose of improving the adhesion with upper layers, preventing material diffusion, or flattening the substrate surface.

Examples of the method for applying the curable composition of the invention to the substrate include various methods such as slit coating method, ink-jetting method, spin coating method, flow casting method, roll coating method and screen printing method.
The thickness of the colored layer immediately after the application of the curable composition is preferably from 0.1 µm to 10 µm, more preferably from 0.2 µm to 5 µm and still more preferably from 0.2 µm to 3 µm, in terms of the uniformity of film thickness and facilitating drying of the applied solvent.

Drying (prebaking) of a colored layer (a colored curable composition layer) formed on the substrate may be conducted by heating at a temperature of from 50°C to 140°C for 10 sec to 300 sec using a hot plate, an oven or the like.

When a film is used as a color filter for a LCD, the film thickness of the coated colored curable composition after drying (hereinafter, sometimes referred to as "dry film thickness") is preferably 0.1 µm or more but less than 2.0 µm, more preferably 0.2 µm or more but 1.8 µm or less, and still more preferably 0.3 µm or more but 1.75 µm or less, in order to apply the film to LCDs having reduced thickness and secure favorable color density.
When a film is used as a color filter for a solid-state image sensor, the dry film thickness is preferably 0.05 µm or more but less than 1.0 µm, more preferably 0.1 µm or more but 0.8 µm or less, and still more preferably 0.2 µm or more but 0.7 µm or less, in view of securing favorable color density, and in view of reducing defects such as inability of light traveling in an oblique direction to reach a light-receiving portion and significant difference in light collecting efficiency between periheral and central regions of a device.

### Exposure process

In the exposure process, the colored layer (the colored curable composition layer) formed in the colored layer forming process is exposed to light through a mask having a predetermined mask pattern, thereby curing only an area of the coating film that is irradiated with the light.

As a radiation used in the exposure, UV-rays such as g-line, h-line or i-line are preferable. The irradiation intensity is preferably in the range of from 5 mJ/cm² to 1500 mJ/cm², more preferably in the range of from 10 mJ/cm² to 1000 mJ/cm², and still more preferably in the range of from 10 mJ/cm² to 500 mJ/cm².

Within the above ranges, more specifically, the following ranges are preferable. When the color filter of the invention is used for liquid crystal displays, the irradiation intensity is preferably in the range of from 5 mJ/cm² to 200 mJ/cm², more preferably in the range of from 10 mJ/cm² to 150 mJ/cm², and still more preferably in the range of from 10 mJ/cm² to 100 mJ/cm². When the color filter of the invention is used for solid-state image sensors, the irradiation intensity is preferably in the range of from 30 mJ/cm² to 1500 mJ/cm², more preferably in the range of from 50 mJ/cm² to 1000 mJ/cm², and still more preferably in the range of from 80 mJ/cm² to 500 mJ/cm².

### Development process

After the exposure process, alkali development (development process) is performed to elute an area, which has not been exposed to light in the exposure process, into an alkali aqueous solution. Thereby, only an area that has been cured by light is left. As a result of the development using a developer, a patterned film having a desired color can be formed.

The developer is preferably an organic alkali developer that does not damage an underlying circuit. The development temperature is usually in the range of from 20°C to 30°C, and the development time may be in the range of 20 sec to 90 sec.

Examples of an alkali compound used for the developer include organic alkali compounds such as aqueous ammonia, ethylamine, diethylamine, dimethylethanolamine, tetramethylammonium hydroxide, tetraethylammonium hydroxide, choline, pyrrole, piperidine, and 1,8-diazacyclo-[5.4.0]-7-undecene; and inorganic compounds such sodium hydroxide, potassium hydroxide, sodium carbonate, and sodium hydrogen carbonate. The developer is preferably an alkaline aqueous solution in which the alkali compound is diluted with pure water to a concentration of from 0.001 % by mass to 10% by mass, preferably from 0.01% by mass to 1% by mass. When such an alkaline aqueous solution is used as a developer, washing (rinsing) treatment with pure water is usually performed after the development.
Subsequently, excess developer solution is removed by washing treatment and then dried.

The production method of the invention may further include, after conducting the above-described colored layer forming process, exposure process and development process, a curing process for curing the formed colored pattern by post-heating (post-baking) and/or post-exposing, if necessary.

The post-baking treatment is a heat treatment to complete the curing after development, and the thermal curing treatment is usually conducted at 100°C to 240°C. Within the above temperature range, when a glass substrate or a silicon substrate is used as the substrate, the temperature for thermal curing treatment is preferably from 200°C to 240°C.
This post-baking treatment of the developed film may be performed continuously or batch-wise, using a heating apparatus such as a hot plate, a convection oven (hot air circulating drier) or a high frequency heater, under conditions as described above.

A color filter with desired number of color hues (for example, three or four colors) can be produced by repeating the above-described colored layer forming process, exposure process and developing process (and the curing process, if necessary) in accordance with the number of colors as desired.

In the above, the application of the colored curable composition of the invention to the color pixels of a color filter is mainly described. However, the colored curable composition of the invention may also be applied to the black matrix between the color pixels of the color filter. The black matrix may be formed by performing pattern-wise exposure, alkali development and then post-baking to accelerate the curing of a film, in the same manner as the method of producing color pixels as descrived above, and except that a black pigment such as carbon black or titanium black is added as the colorant to the colored curable composition of the invention.

Since the color filter of the invention is obtained from the colored curable composition having excellent exposure sensitivity, the cured colored composition in the exposure areas has excellent adhesiveness to a substrate and resistance to development. As a result, a high-resolution pattern having excellent adhesiveness to a substrate in an exposed region and having a desired sectional shape may be formed.
Accordingly, the color filter of the invention is preferably applied to liquid crystal display devices and solid-state image sensors such as CCDs, and particularly preferably applied to high resolution CCDs and CMOSs having more than 1,000,000 pixels. The color filter of the invention may be used as, for example, a color filter disposed between a light receiving portion of each of plural pixels that form a CCD element and a condenser microlens.

### EXAMPLES

Hereinafter, the present invention is described in more detail by reference to examples. However, the invention is not restricted to the examples described below as long as the invention as defined by the appended claims is maintained. In the examples, a condensed aqueous solution of polyallylamine is used as polyallylamine. Unless otherwise specified, "parts" and "%" are based on weight.

### Synthesis Example 1

### Synthesis of Polyester (i-1)

6.4 g of n-octanoic acid, 200 g of ε-caprolactone, and 5 g of monobutyl tin oxide were mixed. The mixture was heated at 160°C for 8 hours, and cooled to room temperature, thereby obtaining polyester (i-1).

The scheme is shown below.

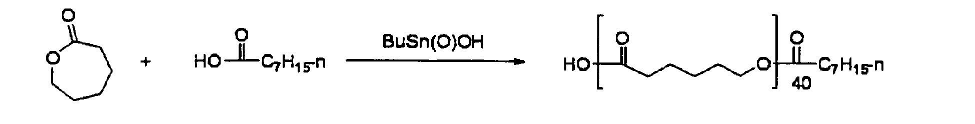

### Synthesis Examples 2 to 10

Polyesters (i-2) to (i-10) were obtained in a manner substantially similar to Synthesis Example 1, except that the type of lactone, the type of carboxylic acid, and the charge amount of carboxylic acid is changed as shown in Table 1. The weight average molecular weight and the number average molecular weight of the polyesters obtained by these Synthesis Examples were measured by the GPC method described above. The results are shown in Table 1. The number of units of lactone repeating units calculated from a charging ratio of the raw material is also shown in Table 1.

Table 1

| | Polyester | Carboxylic acid (Charge amount: g) | Lactone | Mw | Mn | Number of lactone repeating unit |
|---|---|---|---|---|---|---|
| Synthesis Ex. 1 | i-1 | n-octanoic acid (6.4) | ε-caprolactone | 15,000 | 10,000 | 40 |
| Synthesis Ex. 2 | i-2 | n-octanoic acid (12.6) | ε-caprolactone | 8,000 | 6,000 | 20 |
| Synthesis Ex. 3 | i-3 | n-octanoic acid (5.1) | ε-caprolactone | 18,000 | 14,000 | 50 |
| Synthesis Ex. 4 | i-4 | palmitic acid (5.6) | ε-caprolactone | 25,000 | 16,500 | 80 |
| Synthesis Ex. 5 | i-5 | palmitic acid (7.5) | ε-caprolactone | 23,000 | 19,000 | 60 |
| Synthesis Ex.6 | i-6 | decanoic acid (15.1) | ε-caprolactone | 8,000 | 5,500 | 20 |
| Synthesis Ex. 7 | i-7 | 12-hydroxy stearic acid (17.5) | ε-caprolactone | 10,000 | 8,000 | 30 |
| Synthesis Ex. 8 | i-8 | 12-hydroxy stearic acid (5.25) | ε-decanolactone | 30,000 | 21,000 | 100 |
| Synthesis Ex. 9 | i-9 | recinoleic acid (10.4) | ε-caprolactone | 19,000 | 14,000 | 50 |
| Synthesis Ex. 10 | i-10 | 2,2-bis(hydroxymethyl) butyric acid (6.5) | ε-caprolactone | 15,000 | 1,200 | 20 |

| | | | | | | |
|---|---|---|---|---|---|---|
| Synthesis Ex. Synthesis Example; Mw: the weight average molecular weight; Mn: the number average molecular weight | | | | | | |

### Synthesis Example 11

### Synthesis of resin (A-1)

100 g of polyester (i-1) and 10 g of polyethyleneimine (trade name: SP-006, manufactured by NIPPON SHOKUBAI CO., LTD.) were mixed and heated at 110°C for 3 hours, thereby obtaining a resin (A-1). The weight average molecular weight of the resin (A-1) was 10,000, the number average molecular weight thereof was 7,000, and the amine value thereof was 80 mgKOH/g. To the obtained resin (A-1), propylene glycol-1-monomethylether-2-acetate (hereinafter referred to as PGMEA) was added, thereby obtaining a 10% by mass solution of the resin (A-1).

### Synthesis Examples 12 to 20

### Synthesis of resins (A-2) to (A-10)

Resins (A-2) to (A-10) were synthesized in a manner substantially similar to Synthesis Example 11, except that polyester (100 g), amino group-containing resin, a reaction temperature, and a reaction time were changed as shown in Table 2. The amino group-containing resins shown in Table 2 are as follows. Water was removed from PAA-01 by concentration before use.
- SP-003 (polyethyleneimine, manufactured by NIPPON SHOKUBAI CO., LTD., Number average molecular weight: 300)
- SP-006 (polyethyleneimine, manufactured by NIPPON SHOKUBAI CO., LTD., Number average molecular weight: 600)
- SP-012 (polyethyleneimine, manufactured by NIPPON SHOKUBAI CO., LTD., Number average molecular weight: 1,200)
- SP-018 (polyethyleneimine, manufactured by NIPPON SHOKUBAI CO., LTD., Number average molecular weight: 1,800)
- PAA-01 (polyallylamine, manufactured by Nittobo, Weight average molecular weight: 1,000)

Table 2

| | Resin | Polyester | Amino group-containing resin (Content: g) | Reaction temperature | Reaction Time | Mw | Mn | Amine value (mgKOH/g) |
|---|---|---|---|---|---|---|---|---|
| Synthesis Ex. 11 | A-1 | i-1 | SP-006 (10g) | 110°C | 3 h | 10,000 | 7,000 | 80 |
| Synthesis Ex. 12 | A-2 | i-2 | SP-012 (10 g) | 110°C | 2 h | 11,000 | 7,000 | 90 |
| Synthesis Ex. 13 | A-3 | i-3 | SP-018 (10 g) | 120°C | 3 h | 34,000 | 20,000 | 75 |
| Synthesis Ex. 14 | A-4 | i-4 | SP-003 (10 g) | 100°C | 8 h | 15,000 | 10,000 | 70 |
| Synthesis Ex. 15 | A-5 | i-5 | SP-006 (10 g) | 130°C | 3 h | 19,000 | 12,000 | 55 |
| Synthesis Ex. 16 | A-6 | i-6 | SP-006 (10 g) | 110°C | 3 h | 6,000 | 4,000 | 80 |
| Synthesis Ex. 17 | A-7 | i-7 | SP-006 (14 g) | 110°C | 3 h | 7,000 | 5,000 | 100 |
| Synthesis Ex. 18 | A-8 | i-8 | SP-006 (7 g) | 120°C | 3 h | 25,000 | 18,000 | 40 |
| Synthesis Ex. 19 | A-9 | i-9 | PAA-01 (10 g) | 110°C | 3 h | 20,000 | 15,000 | 70 |
| Synthesis Ex. 20 | A-10 | i-10 | SP-006 (10 g) | 120°C | 4 h | 10,000 | 7,500 | 60 |

| | | | | | | | | |
|---|---|---|---|---|---|---|---|---|
| Synthesis Ex. Synthesis Example; Mw: the weight average molecular weight; Mn: the number average molecular weight | | | | | | | | |

### Synthesis Example 21

### Synthesis of resin (A-11)

100 g of polyester (i-1) and 10 g of polyethyleneimine (trade name: SP-006, manufactured by NIPPON SHOKUBAI CO., LTD.) were mixed and heated at 110°C for 3 hours, thereby obtaining a resin. The weight average molecular weight of the resin was 10,000, the number average molecular weight thereof was 7,000, and the amine value thereof was 80 mgKOH/g. Thereafter, the resin was allowed to cool to 65°C, and then 200 g of PGMEA containing 7.6 g of succinic anhydride was slowly added. The resultant was then stirred for 2 hours. Thereafter, PGMEA was added, thereby obtaining a 10% PGMEA solution of a resin (A-11). The weight average molecular weight of the resin (A-11) was 11,000, the number average molecular weight thereof was 7,500, the acid value thereof was 40 mgKOH/g, and the amine value thereof was 40 mgKOH/g.

### Synthesis Example 22

### Synthesis of resin (F-1)

15 g of a compound A having the following structure (corresponding to the repeating unit (M-2) described above), 31 g of benzyl methacrylate, 29 g of methacrylic acid, and 150 g of propyleneglycol monomethyl ether were mixed and heated at 75°C for 1 hour under a nitrogen gas stream. Subsequently, 2.5 g of dodecyl mercaptan and 0.5 g of dimethyl 2,2'-bisisobutyrate (trade name: V-601, manufactured by Wako Pure Chemical Ind., Ltd.) were added thereto, and the mixture was heated for 2 hours. Then, another 0.5 g of dimethyl 2,2'-bisisobutyrate was added, and the mixture was heated at 90°C for 2 hours. To the resultant solution, 25 g of glycidyl methacrylate, 2 g of N,N-dimethyldodecylamine, and 0.2 g of *p-*methoxyphenol were added, and the mixture was heated at 90°C for 10 hours. To the obtained solution, propyleneglycol monomethyl ether was added, thereby obtaining a 30% by mass solution of a resin (F-1). The weight average molecular weight of the obtained resin (F-1) was 15,000, the number average molecular weight thereof was 8,000, and the acid value thereof was 90 mgKOH/g. The structure and molecular weight of the resin (F-1) are shown below. Here, the composition ratio is represented by a mass ratio.

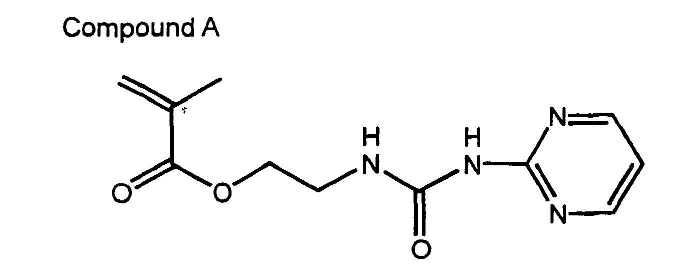

### Synthesis Examples 23 to 26

### Synthesis of resins (F-2) to (F-6)

Resins (F-2) to (F-6) were synthesized in a manner substantially similar to Synthesis Example 22, except that the type and amount of the compound corresponding to the repeating unit represented by Formula (1), and the type and amount of the monomers to be copolymerized are changed. The structure and molecular weight of resins (F-2) to (F-6) are shown below. Here, the composition ratio is represented by a mass ratio.

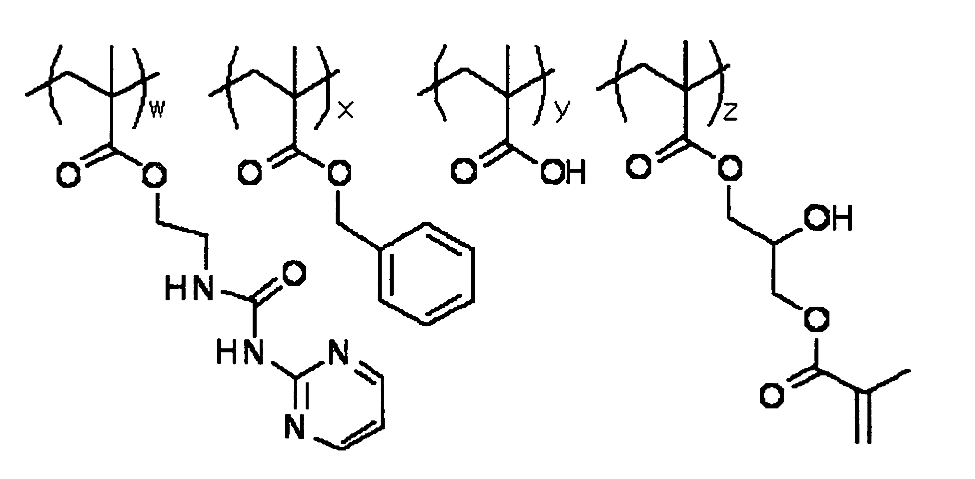

(F-1) w/x/y/z=15/31/14/40 Mw 15,000 Mn 8,000 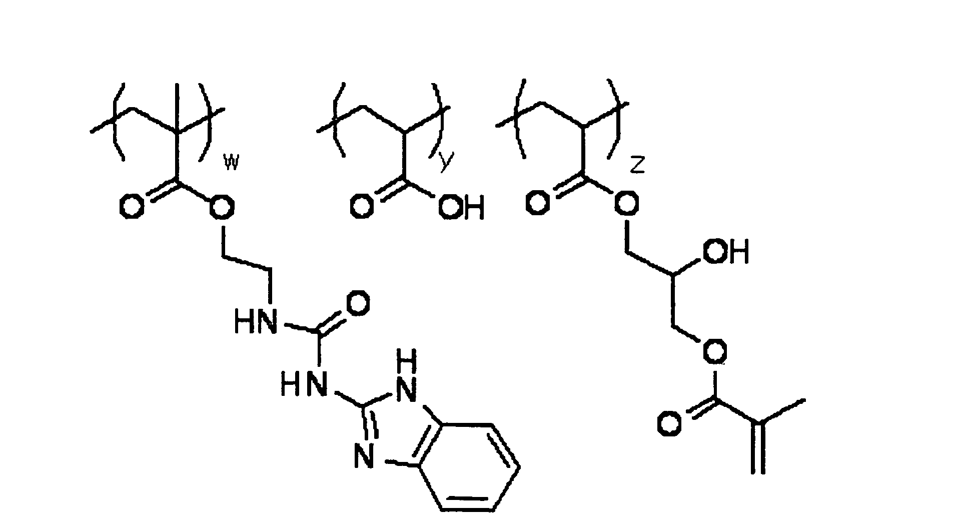 (F-2) w/y/z=15/10/75 Mw 20,000 Mn 12,000 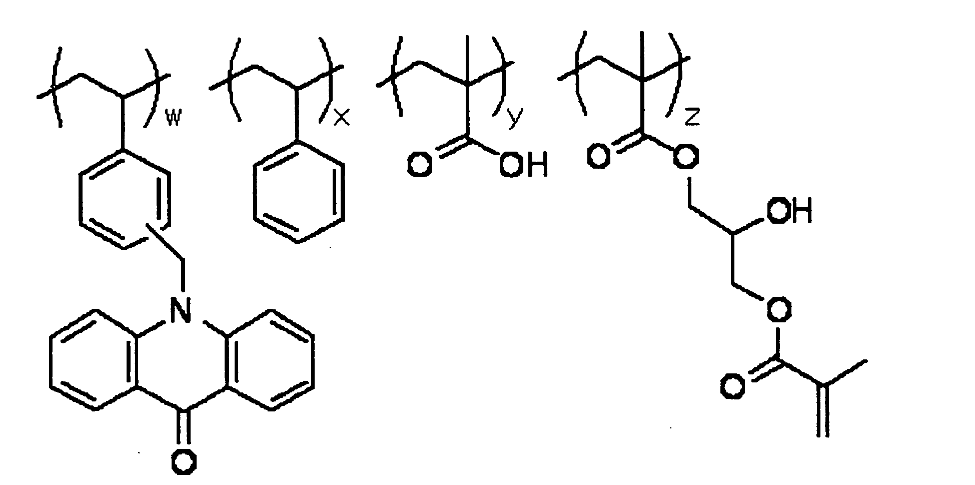 (F-3) w/x/y/z=20/29/18/33 Mw 7,000 Mn 4,500 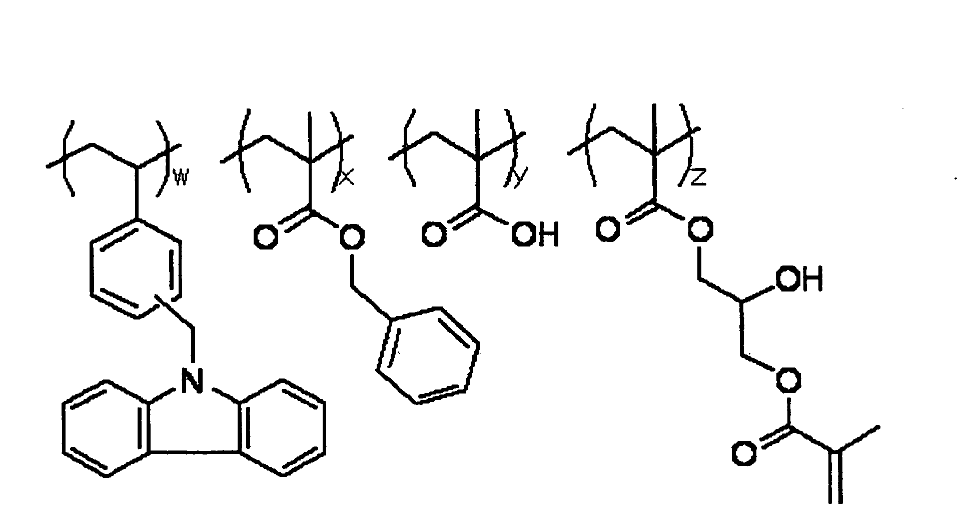 (F-4) w/x/y/z=15/47/18/20 Mw 11,000 Mn 7,000 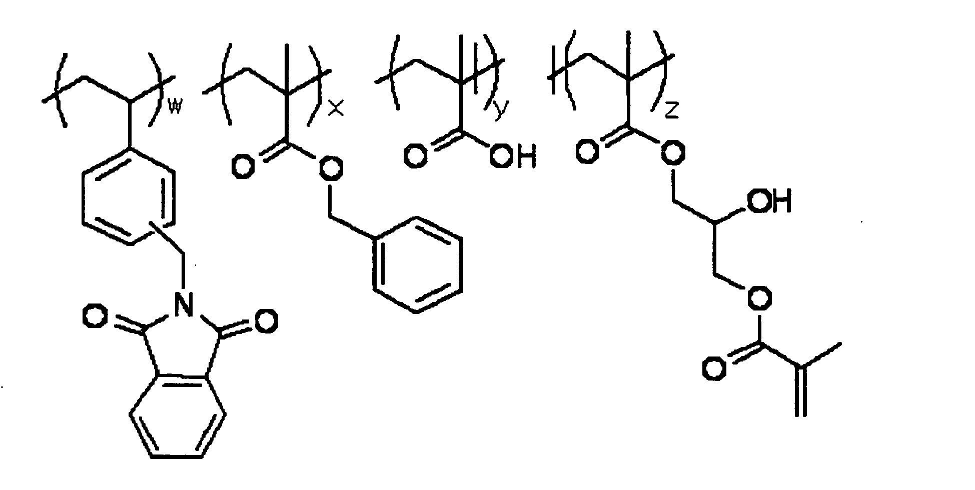 (F-5) w/x/y/z=15/31/14/40 Mw 18,000 Mn 10,000 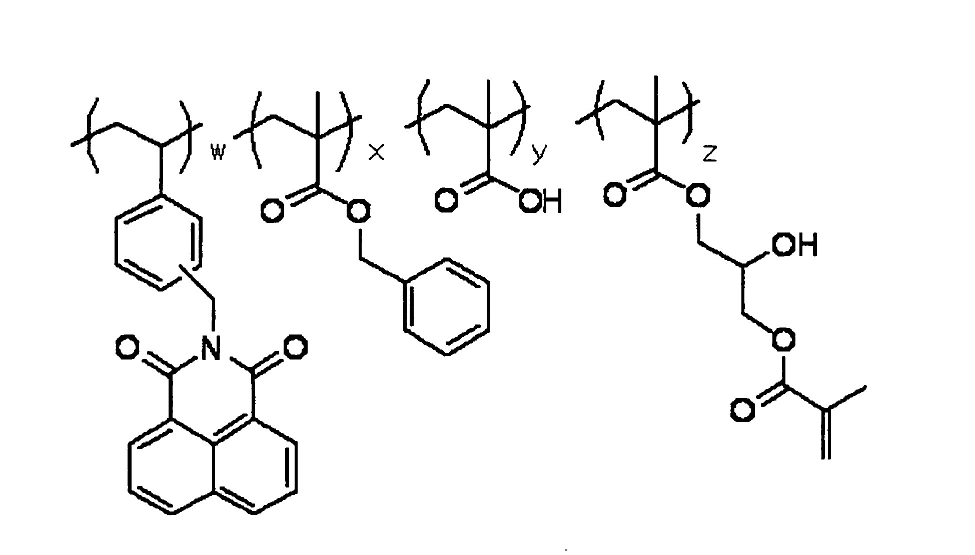 (F-6) w/x/y/z=15/26/14/45 Mw 12,000 Mn 7,000

### Synthesis Example 27

### Synthesis of resin (F-7)

15 g of a compound A having the following structure (corresponding to the repeating unit (M-2) described above), 71 g of benzyl methacrylate, 14 g of methacrylic acid, and 150 g of propyleneglycol monomethyl ether were mixed and heated at 75°C for 1 hour under a nitrogen gas stream. Subsequently, 2.5 g of dodecyl mercaptan and 0.5 g of dimethyl 2,2'-bisisobutyrate (trade name: V-601, manufactured by Wako Pure Chemical Ind., Ltd.) were added thereto, and the mixture was heated for 2 hours. Then, another 0.5 g of dimethyl 2,2'-bisisobutyrate was added, and the mixture was heated at 90°C for 2 hours. To the obtained solution, propyleneglycol monomethyl ether was added, thereby obtaining a 30% by mass solution of a resin (F-7). The weight average molecular weight of the obtained resin (F-7) was 15,000, the number average molecular weight thereof was 8,000 and the acid value thereof was 90 mgKOH/g.

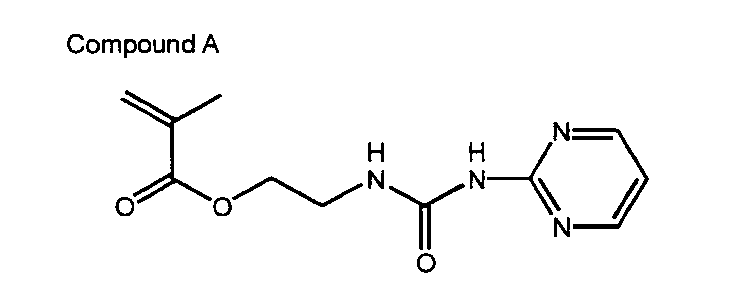

### Comparative Synthesis Example 1

### Synthesis of resin (F-8)

86 g of benzyl methacrylate, 14 g of methacrylic acid, and 150 g of propyleneglycol monomethyl ether were mixed and heated at 75°C for 1 hour under a nitrogen gas stream. Subsequently, 2.5 g of dodecyl mercaptan and 0.5 g of dimethyl 2,2'-bisisobutyrate (trade name: V-601, manufactured by Wako Pure Chemical Ind., Ltd.) were added thereto, and the mixture was heated for 2 hours. Then, another 0.5 g of dimethyl 2,2'-bisisobutyrate was added, and the mixture was heated at 90°C for 2 hours. To the obtained solution, propyleneglycol monomethyl ether was added, thereby obtaining a 30% by mass solution of a resin (F-8). The weight average molecular weight of the obtained resin (F-8) was 15,000, the number average molecular weight thereof was 8,000, and the acid value thereof was 90 mgKOH/g.

### Comparative Synthesis Example 2

### Synthesis of resin (F-9)

15 g of styrene, 31 g of benzyl methacrylate, 29 g of methacrylic acid, and 150 g of propyleneglycol monomethyl ether were mixed and heated at 75°C for 1 hour under a nitrogen gas stream. Subsequently, 2.5 g of dodecyl mercaptan and 0.5 g of dimethyl 2,2'-bisisobutyrate (trade name: V-601, manufactured by Wako Pure Chemical Ind., Ltd.) were added thereto, and the mixture was heated for 2 hours. Then, another 0.5 g of dimethyl 2,2'-bisisobutyrate was added, and the mixture was heated at 90°C for 2 hours. To the solution, 25 g of glycidyl methacrylate, 2 g of N,N-dimethyldodecylamine, and 0.2 g of p-methoxyphenol were added, and the mixture was heated at 90°C for 10 hours. To the obtained solution, propyleneglycol monomethyl ether was added, thereby obtaining a 30% by mass solution of a resin (F-9). The weight average molecular weight of the obtained resin (F-9) was 16,000, the number average molecular weight thereof was 8,000, and the acid value thereof was 90 mgKOH/g.

### Examples 1 to 32, Comparative Examples 1 to 4

Here, examples in which a colored curable composition containing a pigment was prepared for forming a color filter for liquid crystal displays will be described.

### 1-1. Preparation ofpigment dispersion liquid (Preparation Examples 1 to 20)

According to the formulation shown in Table 3, a mixed liquid containing 40 parts of the pigment shown in Table 3, resins 1 and 2 (types and amounts thereof are shown in Table 3), and 300 parts of propyleneglycol monomethyl ether acetate was mixed and dispersed for 3 hours with a bead mill (using zirconia beads having a diameter of 0.3 mm), thereby preparing a pigment dispersion liquid (each of X-1 to X-20).

**Table 3**

| | Pigment dispersion liquid | Pigment | Resin 1 | Resin 2 |
|---|---|---|---|---|
| Preparation Ex. 1 | X-1 | PG36 | (A-1) 150 parts (15) | - |
| Preparation Ex. 2 | X-2 | PG36 | (A-2) 150 parts (15) | - |
| Preparation Ex. 3 | X-3 | PG36 | (A-3) 150 parts (15) | - |
| Preparation Ex. 4 | X-4 | PG36 | (A-4) 150 parts (15) | - |
| Preparation Ex. 5 | X-5 | PG36 | (A-5) 150 parts (15) | - |
| Preparation Ex. 6 | X-6 | PG36 | (A-6) 150 parts (15) | - |
| Preparation Ex. 7 | X-7 | PG36 | (A-7) 150 parts (15) | - |
| Preparation Ex. 8 | X-8 | PG36 | (A-8) 150 parts (15) | - |
| Preparation Ex. 9 | X-9 | PG36 | (A-9) 150 parts (15) | - |
| Preparation Ex. 10 | X-10 | PG36 | (A-10) 150 parts (15) | - |
| Preparation Ex. 11 | X-11 | PG36 | (A-11) 150 parts (15) | - |
| Preparation Ex. 12 | X-12 | PG36 | (A-11) 100 parts (10) | (F-6) 16.7 (5) |
| Preparation Ex. 13 | X-13 | PR254 | (A-11) 100 parts (10) | - |
| Preparation Ex. 14 | X-14 | PR177 | (A-11) 100 parts (10) | - |
| Preparation Ex. 15 | X-15 | PG58 | (A-11) 100 parts (10) | - |
| Preparation Ex. 16 | X-16 | PY138 | (A-11) 100 parts (10) | - |
| Preparation Ex. 17 | X-17 | PY139 | (A-11) 100 parts (10) | - |
| Preparation Ex. 18 | X-18 | PY150 | (A-11) 100 parts (10) | - |
| Preparation Ex. 19 | X-19 | PB15:6 | (A-11) 100 parts (10) | - |
| Preparation Ex. 20 | X-20 | PG36 | (Disper BYK174) 28 parts (15) | - |

| | | | | |
|---|---|---|---|---|
| Preparation Ex.: Preparation Example | | | | |

In Table 3, "parts" of the resin 1 and the resin 2 indicate the amount of the solution used, and the numerals in the brackets each indicate the solid content of the resin 1 or the resin 2 by "part."

The DISPER BYK-174 (trade name, manufactured by BYK Chemie) is a block copolymer having an affinity for pigments and has an acid value of 22 mgKOH/g and a solid content of 53% by mass.

The pigments mentioned in Table 3 are as shown below.
PG36: C. I. Pigment Green 36
PR254: C. I. Pigment Red 254
PR177: C. I. Pigment Red 177
PG58: C. I. Pigment Green 58
PY138: C.I. Pigment Yellow 138
PY139: C. I. Pigment Yellow 139
PY150: C. I. Pigment Yellow 150
PB15:6: C. I. Pigment Blue 15:6

### 1-2. Preparation of colored curable composition (coating liquid)

Using the above pigment dispersion liquid, the components of the following composition were mixed at the following amounts by stirring, thereby preparing colored curable compositions.
- Pigment dispersion liquid described above 600 parts
- Photopolymerization initiator (shown in Table 4) 20 parts
- Pentaerythritol tetraacrylate 20 parts
- Resin (shown in Table 4) 20 parts
   (equivalent to 6 parts in terms of solid content)
- Solvent: PGMEA 900 parts
- Substrate adhesion agent (3-methacryloxypropyltrimethoxysilane) 1 part

### 1-3. Formation ofcolored curable composition layer

The colored curable composition was applied as a resist solution to a glass substrate (550 mm x 650 mm) by slit coating under the following conditions. Then, the resultant was subjected to vacuum drying and prebaking (at 100°C for 80 seconds), thereby forming a coating film (a curable composition layer) of the colored curable composition.

### Slit coating conditions

| | |
|---|---|
| Width of an opening at a coating head end: | 50 µm |
| Coating rate: | 100 mm/second |
| Clearance between a substrate and a coating head: | 150 µm |
| Dry film thickness | 1.75 µm |
| Coating temperature: | 23°C |

### 1-4. Exposure and Development

Thereafter, the coating film of the colored curable composition was exposed to form a pattern at 100 mJ/cm² by LE4000A (trade name, manufactured by Hitachi High-Technologies Corporation) using a 2.5 kW ultrahigh pressure mercury lamp and a photomask with a line width of 20 µm. After the exposure, the surface of the coating film was thoroughly coated with a 1% aqueous inorganic developer solution (trade name: CDK-1, manufactured by Fujifilm Electronic Materials. Co.), and shower development was carried out.

### 1-5. Heat treatment

Pure water was sprayed in a shower to wash off the developer solution. Then, the coating film subjected to the exposure (photocuring) treatment and development treatment was heated in an oven at 220°C for 1 hour (post-baking), whereby a color filter having a pattern (colored layer) of the colored curable composition formed on the glass substrate was obtained.

### 1-6. Evaluation ofperformance

The storage stability, developability, and exposure sensitivity of each of the colored curable compositions prepared above, and the contrast of each of the curable composition coating films (colored layers) each of which was formed on the glass substrate using the colored curable composition were evaluated as follows. The results are shown in Table 4.

### 1-6-1. Storage stability

The viscosity of each of the colored curable compositions obtained in section 1-2 above was evaluated as follows: the viscosity of the colored curable composition was measured with a cone-plate type viscometer (trade name: TV-22, manufactured by Toki Sangyo Co., Ltd.) one day after the preparation and one month after the preparation.

A smaller viscosity value indicates better pigment dispersibility. A smaller viscosity value and a smaller increase in viscosity over time indicate better pigment dispersion stability.

### 1-6-2. Developability

After developing in section 1-4 above, 20 developed areas (unexposed areas) were observed by SEM (visual field: 10 µm × 10 µm), and the number of residues was counted.

Fewer residues indicate better developability.

### 1-6-3. Exposure sensitivity

In section 1-4 above, exposure was performed at an exposure amount varied in the range of from 10 mJ/cm² to 500 mJ/cm². Regarding the exposure sensitivity, the exposure amount at which the pattern line width after post-baking was 20 µm was evaluated as the exposure requirement amount. A smaller value of exposure requirement amount indicates higher sensitivity.

### 1-6-4. Contrast of color filter

The color filter obtained in section 1-5 above was disposed between two polarizing plates, and the luminance of transmitted light when the polarization axes of the polarizing plates were respectively parallel and vertical was measured using a color luminance meter (trade name: COLOR LUMINANCE METER BM-7, manufactured by TOPCON CORP.). Then, the contrast was calculated by dividing the value of the luminance when the polarization axes were parallel by the value of the luminance when the polarization axes were vertical. A larger value of contrast indicates a better performance as a color filter for a liquid crystal display.

Table 4

| | Pigment dispersion liquid | Photo-polymerization initiator | Resin | Viscosity (after one day) (mPa·s) | Viscosity (after one month) (mPa·s) | Developability | Exposure requirement amount (mJ/cm²) | Contrast |
|---|---|---|---|---|---|---|---|---|
| Ex.1* | X-1 | Z-1 | F-1 | 12 | 16 | 7 | 60 | 20,000 |
| Ex.2* | X-1 | Z-1 | F-2 | 10 | 12 | 5 | 60 | 20,000 |
| Ex. 3* | X-1 | Z-1 | F-3 | 10 | 12 | 5 | 60 | 20,000 |
| Ex. 4* | X-1 | Z-1 | F-4 | 12 | 16 | 5 | 60 | 20,000 |
| Ex.5* | X-1 | Z-1 | F-5 | 12 | 16 | 8 | 60 | 20,000 |
| Ex. 6* | X-1 | Z-1 | F-6 | 10 | 12 | 5 | 60 | 20,000 |
| Ex. 7* | X-1 | Z-1 | F-7 | 12 | 16 | 7 | 90 | 20,000 |
| Ex. 8* | X-2 | Z-1 | F-6 | 12 | 16 | 7 | 60 | 14,000 |
| Ex. 9* | X-3 | Z-1 | F-6 | 15 | 20 | 7 | 60 | 14,000 |
| Ex. 10* | X-4 | Z-1 | F-6 | 12 | 16 | 8 | 60 | 14,000 |
| Ex. 11* | X-5 | Z-1 | F-6 | 10 | 12 | 5 | 60 | 20,000 |
| Ex. 12* | X-6 | Z-1 | F-6 | 10 | 12 | 4 | 60 | 18,000 |
| Ex. 13* | X-7 | Z-1 | F-6 | 10 | 12 | 3 | 60 | 18,000 |
| Ex. 14* | X-8 | Z-1 | F-6 | 10 | 12 | 4 | 60 | 17,000 |
| Ex. 15* | X-9 | Z-1 | F-6 | 15 | 20 | 8 | 60 | 14,000 |
| Ex. 16* | X-10 | Z-1 | F-6 | 10 | 12 | 4 | 60 | 20,000 |
| Ex. 17* | X-11 | Z-1 | F-6 | 8 | 8 | 2 | 60 | 24,000 |
| Ex. 18* | X-11 | Z-1 | F-6 | 8 | 8 | 1 | 60 | 24,000 |
| Ex. 19 | X-11 | Z-2 | F-6 | 8 | 8 | 0 | 50 | 24,000 |
| Ex. 20 | X-11 | Z-3 | F-6 | 8 | 8 | 0 | 60 | 24,000 |
| Ex. 21 | X-11 | Z-4 | F-6 | 8 | 8 | 2 | 90 | 24,000 |
| Ex. 22* | X-11 | Z-5 | F-6 | 8 | 8 | 2 | 90 | 24,000 |
| Ex. 23* | X-11 | Z-6 | F-6 | 8 | 8 | 2 | 90 | 24,000 |
| Ex. 24* | X-11 | Z-7 | F-6 | 8 | 8 | 2 | 60 | 24,000 |
| Ex. 25* | X-12 | Z-1 | F-6 | 8 | 8 | 1 | 60 | 24,000 |
| Ex. 26* | X-13 | Z-1 | F-2 | 8 | 8 | 1 | 60 | 21,000 |
| Ex. 27* | X-14 | Z-1 | F-2 | 8 | 8 | 0 | 60 | 16,000 |
| Ex. 28 | X-15 | Z-2 | F-2 | 8 | 8 | 0 | 50 | 18,000 |
| Ex. 29 | X-16 | Z-2 | F-3 | 8 | 8 | 0 | 50 | 22,000 |
| Ex.30 | X-17 | Z-2 | F-3 | 8 | 8 | 0 | 50 | 19,000 |
| Ex.31 | X-18 | Z-2 | F-3 | 8 | 8 | 0 | 50 | 22,000 |
| Ex. 32 | X-19 | Z-2 | F-3 | 8 | 8 | 0 | 50 | 24,000 |
| Comp. Ex. 1 | X-20 | Z-4 | E-1 | 20 | 50 | 50 | 120 | 8,000 |
| Comp. Ex. 2 | X-3 | Z-4 | F-8 | 20 | 90 | 70 | 150 | 7,000 |
| Comp. Ex. 3 | X-20 | Z-4 | F-8 | 30 | gelated | 100 | 160 | 5,000 |
| Comp. Ex. 4 | X-20 | Z-4 | F-9 | 30 | gelated | 100 | 80 | 5,000 |

| | | | | | | | | |
|---|---|---|---|---|---|---|---|---|
| Ex.: Example; Comp. Ex.: Comparative Example *Reference Example | | | | | | | | |

The photopolymerization initiators (Z-1) to (Z-7) mentioned in Table 4 are as shown below. The photopolymerization initiator (Z-1) shown below is a mixture of (Z-1-a) and (Z-1-b) at a mixing ratio of 20:10 (parts by mass).

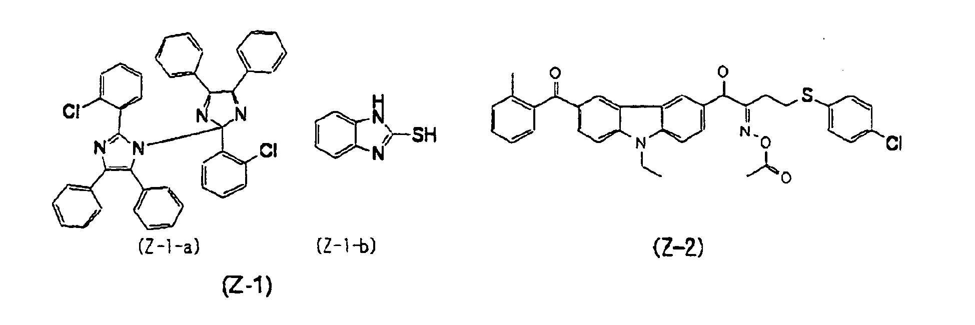

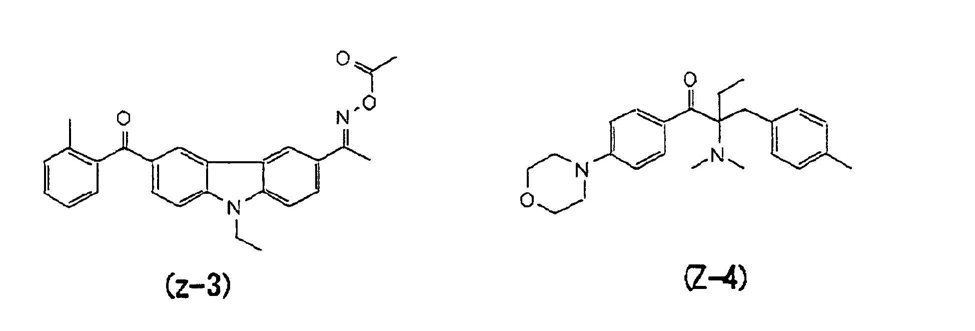

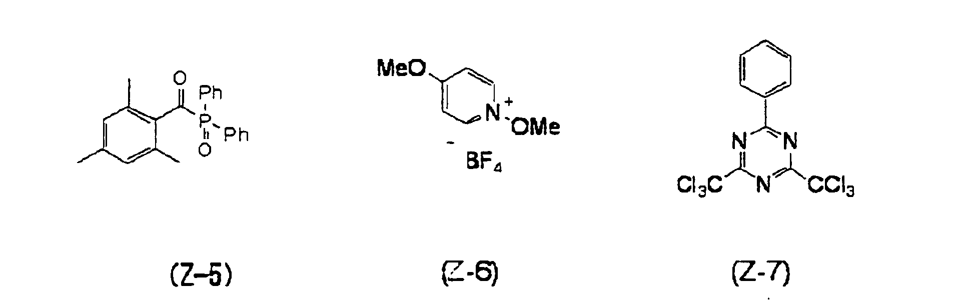

As shown in Table 4, it was found that the colored curable compositions of the Examples of the present invention each of which contained a dispersion resin having an amino group in the main chain thereof and a specific alkali-soluble resin of the invention, had excellent storage stability and developability. Furthermore, it was found that the colored pattern formed on the support using the colored curable composition exhibited high sensitivity and high contrast in Examples 1 to 32. On the other hand, in each of Comparative Examples 1 to 4, in which the colored curable composition of the invention was not used, the viscosity increased during storage, the storage stability over time was poor, residues were generated by development, and the sensitivity and the contrast were low.

### Examples 33 to 64 and Comparative Examples 5 to 8

Hereinafter, examples in which a colored curable composition was prepared for forming a color filter for solid-state image sensors will be described.

### 2-1. Preparation of resist solution

The components of the following composition were mixed at the following amounts and dissolved to prepare a resist solution.

### Composition of resist solution

- Solvent: Propyleneglycol monomethyl ether acetate 19.20 parts
- Solvent: Ethyl lactate 36.67 parts
- Alkali-soluble resin: 40% solution of benzyl methacrylate/methacrylic acid/2-hydroxyethyl methacrylate (molar ratio = 60/22/18) copolymer in propyleneglycol monomethyl ether acetate (PGMEA) 30.51 parts
- Compound having an ethylenic unsaturated double bond: Dipentaerythritol hexaacrylate 12.20 parts
- Polymerization inhibitor: p-methoxyphenol 0.0061 parts
- Fluorine surfactant: F-475 (trade name, manufactured by DIC Corporation) 0.83 parts
- Photopolymerization initiator: TAZ-107 (trade name, manufactured by Midori Kagaku Co., Ltd.; trihalomethyl triazine compound) 0.586 parts

### 2-2. Production of silicon wafer having undercoat layer

A 6-inch silicon wafer was heat-treated in an oven at 200°C for 30 minutes. Subsequently, the above resist solution was applied to the silicon wafer such that dry film thickness of the film was 1.5 µm. Then, the silicon wafer was further heated to dry in an oven at 220°C for 1 hour to form an undercoat layer, whereby a silicon wafer substrate having an undercoat layer was obtained.

### 2-3. Preparation of colored curable composition (coating liquid)

Using each of the pigment dispersion liquids (X-1) to (X-20) above, the components of the following composition were mixed at the following amounts by stirring, thereby preparing a colored curable composition.
- Pigment dispersion liquid described above 600 parts
- Resin (shown in Table 5) 20 parts (equivalent to 6 parts in terms of solid content)
- Photopolymerization initiator (shown in Table 5) 20 parts
- Polymerizable compound: TO-1382 (trade name, manufactured by Toagosei Co., Ltd.; a mixture of dipentaerythritol hexaacrylate, dipentaerythritol pentaacrylate, and a succinic acid derivative of dipentaerythritol pentaacrylate) 20 parts
- Polymerizable compound: Dipentaerythritol hexaacrylate 30 parts
- Solvent: PGMEA 900 parts

### 2-4. Production and evaluation of color filter formed using colored curable composition

### Pattern formation

Respective colored curable compositions prepared as described above was applied to the undercoat layer of the silicon wafer having the undercoat layer obtained in section 2-1 above, to form a colored layer (coating film). Subsequently, the silicon wafer was heat-treated (prebaking) for 120 sec using a hot plate at 100°C, such that the dry film thickness of the coating film was 0.5 µm.

Subsequently, an i-line stepper FPA-3000i5⁺ (trade name, manufactured by Canon Inc.) was used to expose the coating film to light through a patterned mask having a 1.2 µm-square island pattern at various exposure amounts from 50 mJ/cm² to 1200 mJ/cm² at a wavelength of 365 nm.
After irradiation, the silicon wafer substrate on which the irradiated coating film was formed was placed on a horizontal rotary table of a spin-shower developing apparatus (DW-30 type; manufactured by Chemitronics Co., Ltd.), and subjected to paddle development at 23°C for 60 sec using a CD-2000 (manufactured by Fujifilm Electronic Materials Co., Ltd.), whereby a colored pattern was formed on the silicon wafer.

The silicon wafer on which a colored pattern had been formed was fixed to the horizontal rotary table by a vacuum chuck method. While the silicon wafer was rotated by a rotating apparatus at a rotation speed of 50 rpm, a rinsing treatment was conducted by supplying purified water in a shower from an ejection nozzle placed upper side of the rotational center of the silicon wafer, and then the silicon wafer was spray-dried.
Thereafter, the size of the colored pattern was measured using a length measuring SEM (trade name: S-9260A, manufactured by Hitachi High-Technologies Corporation). Regarding the exposure sensitivity, the exposure amount at which the pattern size 1.2 µm was evaluated as the exposure requirement amount.

### 2-5. Evaluation of performance

The dispersibility, dispersion stability, exposure sensitivity, coating property and developability of each of the colored curable compositions prepared were evaluated as follows. The results are shown in Table 5.

The color unevenness of each of the color filters obtained above was evaluated as follows. The results are shown in Table 5.

### 2-5-1. Dispersibility and dispersion stability

The viscosity of each of the colored curable compositions obtained in section 2-3 above was evaluated as follows: the viscosity of the colored curable composition was measured with a cone-plate type viscometer (trade name: TV-22, manufactured by Toki Sangyo Co., Ltd.) one day after the preparation and one month after the preparation.

A smaller viscosity value indicates better pigment dispersibility. A smaller viscosity value and a smaller increase in viscosity over time indicate better pigment dispersion stability.

### 2-5-2. Developability

After developing in section 2-4 above, 20 developed areas (unexposed areas) were observed by SEM (visual field: 10 µm × 10 µm), and the number of residues was counted.

### 2-5-3. Exposure sensitivity

The exposure was performed at various exposure amounts from 10 mJ/cm² to 500 mJ/cm². Regarding the exposure sensitivity, the exposure amount at which the pattern line width after post-baking was 1.2 µm was evaluated as the exposure requirement amount. A smaller value of exposure requirement amount indicates higher sensitivity.

### 2-5-4. Evaluation of color unevenness

The color unevenness of the color filter obtained in section 2.4 above was evaluated according to the following method: the brightness distribution was analyzed by the method described below, and the proportion of pixels deviating from the average of the entire number of pixels by ± 5% was determined. The evaluation criteria are as described below.

Hereinafter, a method for analyzing the brightness distribution is explained. First, the colored curable composition obtained in section 2-3 above was coated on the glass substrate having an undercoat layer, which was obtained in a manner similar to that described in section 2-2 above, whereby a colored layer (coating film) was obtained.

Subsequently, the coating film was heat-treated (prebaked) for 120 sec using a hot plate at 100°C, such that the dry film thickness of the coating film was 0.7 µm.

The brightness distribution of the coated glass substrate was analyzed based on images taken with a microscope MX-50 (trade name, manufactured by Olympus Corporation), and then the ratio (percentage) of pixels deviating from the average by ± 5% was calculated. A higher value of this ratio indicates better properties as a color filter, with less color unevenness.

Table 5

| | Pigment dispersion | Photo-polymerization liquid initiator | Resin | Viscosity (after one day) (mPa·s) | Viscosity (after one month) (mPa·s) | Developability | Exposure requirement amount (mJ/cm²) | Color unevenness (%) |
|---|---|---|---|---|---|---|---|---|
| Ex. 33* | X-1 | Z-1 | F-1 | 12 | 16 | 10 | 130 | 97 |
| Ex. 34* | X-1 | Z-1 | F-2 | 10 | 12 | 5 | 120 | 97 |
| Ex. 35* | X-1 | Z-1 | F-3 | 10 | 12 | 5 | 120 | 97 |
| Ex. 36* | X-1 | Z-1 | F-4 | 12 | 16 | 6 | 130 | 97 |
| Ex. 37* | X-1 | Z-1 | F-5 | 12 | 16 | 11 | 120 | 97 |
| Ex. 38* | X-1 | Z-1 | F-6 | 10 | 12 | 5 | 120 | 97 |
| Ex. 39* | X-1 | Z-1 | F-7 | 12 | 16 | 10 | 190 | 97 |
| Ex. 40* | X-2 | Z-1 | F-6 | 12 | 16 | 10 | 120 | 96 |
| Ex. 41* | X-3 | Z-1 | F-6 | 15 | 20 | 12 | 120 | 96 |
| Ex. 42* | X-4 | Z-1 | F-6 | 12 | 16 | 11 | 120 | 96 |
| Ex. 43* | X-5 | Z-1 | F-6 | 10 | 12 | 5 | 110 | 98 |
| Ex. 44* | X-6 | Z-1 | F-6 | 10 | 12 | 3 | 110 | 97 |
| Ex. 45* | X-7 | Z-1 | F-6 | 10 | 12 | 3 | 120 | 97 |
| Ex. 46* | X-8 | Z-1 | F-6 | 10 | 12 | 3 | 120 | 97 |
| Ex. 47* | X-9 | Z-1 | F-6 | 15 | 20 | 11 | 130 | 96 |
| Ex. 48* | X-10 | Z-1 | F-6 | 10 | 12 | 6 | 120 | 97 |
| Ex. 49* | X-11 | Z-1 | F-6 | 8 | 8 | 1. | 120 | 99 |
| Ex. 50* | X-11 | Z-1 | F-6 | 8 | 8 | 1 | 120 | 99 |
| Ex. 51 | X-11 | Z-2 | F-6 | 8 | 8 | 0 | 90 | 99 |
| Ex. 52 | X-11 | Z-3 | F-6 | 8 | 8 | 0 | 100 | 99 |
| Ex. 53 | X-11 | Z-4 | F-6 | 8 | 8 | 2 | 180 | 99 |
| Ex. 54* | X-11 | Z-5 | F-6 | 8 | 8 | 2 | 180 | 99 |
| Ex. 55* | X-11 | Z-6 | F-6 | 8 | 8 | 2 | 180 | 99 |
| Ex. 56* | X-11 | Z-1 | F-6 | 8 | 8 | 1 | 120 | 99 |
| Ex. 57* | X-12 | Z-1 | F-6 | 8 | 8 | 1 | 120 | 99 |
| Ex. 58* | X-13 | Z-1 | F-2 | 8 | 8 | 1 | 120 | 99 |
| Ex. 59* | X-14 | Z-1 | F-2 | 8 | 8 | 1 | 120 | 99 |
| Ex. 60 | X-15 | Z-2 | F-2 | 8 | 8 | 0 | 90 | 99 |
| Ex.61 | X-16 | Z-2 | F-3 | 8 | 8 | 0 | 100 | 99 |
| Ex.62 | X-17 | Z-2 | F-3 | 8 | 8 | 0 | 90 | 99 |
| Ex. 63 | X-18 | Z-2 | F-3 | 8 | 8 | 0 | 90 | 99 |
| Ex. 64 | X-19 | Z-2 | F-3 | 8 | 8 | 0 | 100 | 99 |
| Comp. Ex. 5 | X-20 | Z-4 | F-1 | 20 | 50 | 60 | 250 | 90 |
| Comp. Ex. 6 | X-3 | Z-4 | F-8 | 20 | 90 | 90 | 310 | 90 |
| Com. Ex. 7 | X-20 | Z-4 | F-8 | 30 | gelated | 120 | 330 | 85 |
| Comp. Ex. 8 | X-20 | Z-4 | F-9 | 30 | gelated | 120 | 250 | 85 |

| | | | | | | | | |
|---|---|---|---|---|---|---|---|---|
| Ex.: Example; Comp. Ex.: Comparative Example *Reference Example | | | | | | | | |

As shown in Table 5, it was found that each of the colored curable compositions of Examples of the invention used for forming color filters for solid-state image sensors had excellent storage stability. In addition, it was found that when a colored pattern is formed on a support using the colored curable composition of the invention, color filters having fewer residues, superior developability and reduced color unevenness as compared with the Comparative Examples were obtained.

## Claims

1. A colored curable composition, comprising:
(A) a dispersion resin being a condensate of polyethyleneimine and a polyester or a condensate of polyallylamine and a polyester;
(B) a pigment;
(C) a photopolymerization initiator which is an oxime compound;
(D) a polymerizable compound;
(E) a solvent; and
(F) an alkali-soluble resin containing a repeating unit represented by the following Formula (2) or (3): 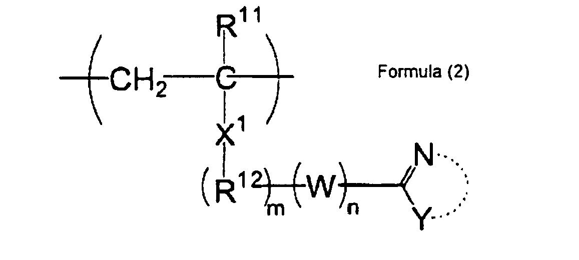
wherein in Formula (2), R¹¹ represents a hydrogen atom or an alkyl group; R¹² represents an alkylene group; X¹ represents -CO-, -COO-, -OCO-, -CONH-, or a phenylene group; W represents -O-, -S-, -COO-, -CONH-, -COS-, -NHCONH-, -NHCOO-, -NHCOS-, -OCO-, -OCONH-, or -NHCO-; Y represents -NR¹³-, -O-, -S-, or -N=, and is linked to the N atom via an atomic group adjacent to Y to form a cyclic structure; R¹³ represents a hydrogen atom, an alkyl group, or an aryl group; and m and n each independently represent 0 or 1 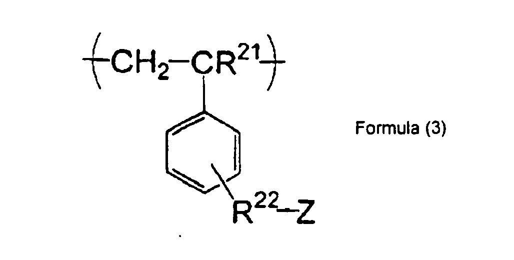 wherein in Formula (3), R²¹ represents a hydrogen atom or a methyl group; R²² represents an alkylene group; and Z represents a nitrogen-containing heterocyclic group.

2. The colored curable composition of claim 1, wherein (F) the alkali-soluble resin further comprises a repeating unit having an ethylenic unsaturated double bond at a side chain thereof.

3. The colored curable composition of claim 1 or 2,
wherein the content of (F) the alkali-soluble resin is from 10% by mass to 100% by mass with respect to the mass of (B) the pigment.

4. The colored curable composition according to any one of claims 1 to 3, wherein the weight average molecular weight of (A) the dispersion resin is from 3,000 to 100,000.

5. The colored curable composition according to any one of claims 1 to 4, wherein the amine value of (A) the dispersion resin is from 10 mgKOH/g to 150 mgKOH/g.

6. The colored curable composition according to any one of claims 1 to 5, wherein the content of (A) the dispersion resin is from 20% by mass to 50% by mass with respect to the content of (B) the pigment.

7. The colored curable composition according to claim 1, wherein W in Formula (2) is -O-, -S-, -CONH-, -NHCONH- or -NHCOS-.

8. A color filter, which has a colored pattern on a support obtainable by using the colored curable composition according to any one of claims 1 to 7.

9. A method for producing a color filter, comprising forming a colored layer by applying the colored curable composition according to any one of claims 1 to 7 to a support, pattern-wise exposing the colored layer through a mask, and developing the exposed colored layer to form a colored pattern.

## Patentansprüche

1. Gefärbte, härtbare Zusammensetzung, umfassend
(A) ein Dispersionsharz, das ein Kondensat von Polyethylenimin und einem Polyester oder ein Kondensat von Polyallylamin und einem Polyester ist;
(B) ein Pigment;
(C) einen Fotopolymerisationsinitiator, der eine Oximverbindung ist;
(D) eine polymerisierbare Verbindung;
(E) ein Lösungsmittel; und
(F) ein alkalilösliches Harz, umfassend eine Wiederholungseinheit, dargestellt durch die folgende Formel (2) oder (3) : 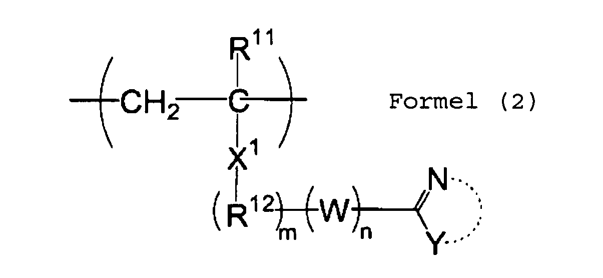 worin in der Formel (2) R¹¹ ein Wasserstoffatom oder eine Alkylgruppe ist, R¹² eine Alkylengruppe ist, X¹ -CO-, -COO-, -OCO-, -CONH- oder eine Phenylengruppe ist, W -O-, -S-, -COO-, -CONH-, -COS-, -NHCONH-, -NHCOO-, -NHCOS-, -OCO-, -OCONH- oder -NHCO- ist, Y -NR¹³-, -O-, -S- oder -N= ist und an das N-Atom über eine Atomgruppe neben Y gebunden ist, unter Bildung einer cyclischen Struktur; R¹³ ein Wasserstoffatom, eine Alkylgruppe oder Arylgruppe ist und m und n jeweils unabhängig 0 oder 1
sind, 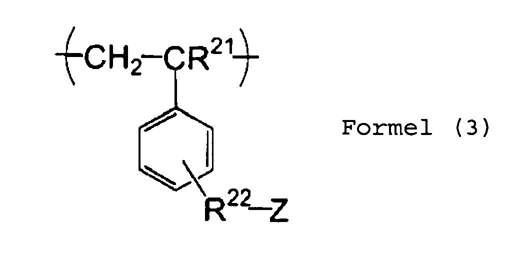 worin in der Formel (3) R²¹ ein Wasserstoffatom oder eine Methylgruppe ist, R²² eine Alkylengruppe ist und Z eine Stickstoff-haltige heterocyclische Gruppe ist.

2. Gefärbte, härtbare Zusammensetzung nach Anspruch 1, worin (F) das alkalilösliche Harz weiterhin eine Wiederholungseinheit mit einer ethylenisch ungesättigten Doppelbindung an einer Seitenkette davon umfasst.

3. Gefärbte, härtbare Zusammensetzung nach Anspruch 1 oder 2, worin der Gehalt von (F) dem alkalilöslichen Harz von 10 bis 100 Massen-% in Bezug auf die Masse von (B) dem Pigment ist.

4. Gefärbte, härtbare Zusammensetzung nach einem der Ansprüche 1 bis 3, worin das Molekulargewicht im Gewichtsmittel von dem Dispersionsharz (A) von 3000 bis 100000 ist.

5. Gefärbte, härtbare Zusammensetzung nach einem der Ansprüche 1 bis 4, worin der Aminwert des Dispersionsharzes (A) von 10 bis 150 mg KOH/g ist.

6. Gefärbte, härtbare Zusammensetzung nach einem der Ansprüche 1 bis 5, worin der Gehalt des Dispersionsharzes (A) von 20 bis 50 Massen-% in Bezug auf den Gehalt des Pigmentes (B) ist.

7. Gefärbte, härtbare Zusammensetzung nach Anspruch 1, worin W in der Formel (2) -O-, -S-, -CONH-, -NHCONH-oder -NHCOS- ist.

8. Farbfilter, der ein gefärbtes Muster auf einem Träger hat, erhältlich durch Verwendung der gefärbten, härtbaren Zusammensetzung nach einem der Ansprüche 1 bis 7.

9. Verfahren zur Erzeugung eines Farbfilters, umfassend die Bildung einer gefärbten Schicht durch Auftragen der gefärbten, härtbaren Zusammensetzung nach einem der Ansprüche 1 bis 7 auf einen Träger, musterweises Belichten der gefärbten Schicht durch eine Maske und Entwickeln der belichteten, gefärbten Schicht zur Bildung eines gefärbten Musters.

## Revendications

1. Composition durcissable colorée, comprenant :
(A) une résine de dispersion étant un condensat de polyéthylèneimine et d'un polyester ou un condensat de polyallylamine et d'un polyester ;
(B) un pigment ;
(C) un initiateur de photopolymérisation qui est un composé d'oxime ;
(D) un composé polymérisable ;
(E) un solvant ; et
(F) une résine soluble dans un alcali contenant une unité répétitive représentée par la formule (2) ou (3) ; 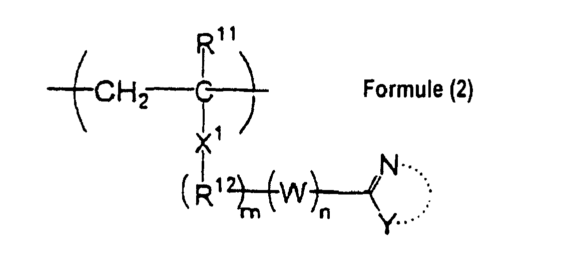
dans laquelle dans la formule (2), R¹¹ représente un atome d'hydrogène ou un groupe alkyle ; R¹² représente un groupe alkylène ; X¹ représente -CO-, -COO-, -OCO-, -CONH-, ou un groupe phénylène ; W représente -O-, -S-, -COO-, -CONH-, -COS-, -NHCONH, -NHCOO, -NHCOS-, -OCO-, -OCONH-, ou -NHCO- ; Y représente -NR¹³-, -O-, -S-, ou -N=, et est lié à l'atome N via un groupe atomique adjacent à Y pour former une structure cyclique ; R¹³ représente un atome d'hydrogène, un groupe alkyle, ou un groupe aryle ; et m et n représentent chacun indépendamment 0 ou 1 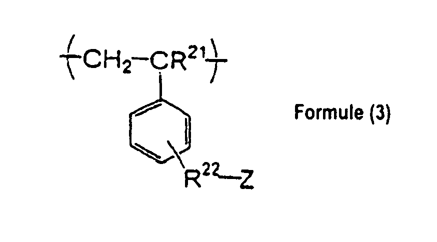 dans laquelle dans la formule (3), R²¹ représente un atome d'hydrogène ou un groupe méthyle ; R²² représente un groupe alkylène ; et Z représente un groupe hétérocyclique contenant de l'azote.

2. Composition durcissable colorée selon la revendication 1, dans laquelle (F) la résine soluble dans un alcali comprend de plus une unité répétitive ayant une double liaison éthylénique insaturée sur sa chaîne latérale.

3. Composition durcissable colorée selon la revendication 1 ou 2, dans laquelle la teneur de (F) la résine soluble dans un alcali est de 10 % en masse à 100 % en masse par rapport à la masse de (B) le pigment.

4. Composition durcissable colorée selon l'une quelconque des revendications 1 à 3, dans laquelle la masse moléculaire moyenne en masse de (A) la résine de dispersion est de 3 000 à 100 000.

5. Composition durcissable colorée selon l'une quelconque des revendications 1 à 4, dans laquelle la valeur d'amine de (A) la résine de dispersion est de 10 mg de KOH/g à 150 mg de KOH/g.

6. Composition durcissable colorée selon l'une quelconque des revendications 1 à 5, dans laquelle la teneur en (A) la résine de dispersion est de 20 % en masse à 50 % en masse par rapport à la teneur en (B) le pigment.

7. Composition durcissable colorée selon la revendication 1, dans laquelle W dans la formule (2) est -O-, -S-, -CONH-, -NHCONH-ou -NHCOS-.

8. Filtre de couleur, lequel présente un motif coloré sur un support pouvant être obtenu en utilisant la composition durcissable colorée selon l'une quelconque des revendications 1 à 7.

9. Procédé de production d'un filtre de couleur comprenant la formation d'une couche colorée par application de la composition durcissable colorée selon l'une quelconque des revendications 1 à 7 sur un support, l'exposition à la manière d'un motif de la couche colorée à travers un masque, et le développement de la couche colorée exposée pour former un motif coloré.
